(19) Europäisches Patentamt
European Patent Office
Office européen des brevets

(11) EP 4 174 888 A1

(12) # EUROPEAN PATENT APPLICATION

(43) Date of publication:
**03.05.2023 Bulletin 2023/18**

(21) Application number: **22203512.3**

(22) Date of filing: **25.10.2022**

(51) International Patent Classification (IPC):
***H01G 9/20*** *(2006.01)*

(52) Cooperative Patent Classification (CPC):
**H01G 9/2077;** H01G 9/2031; H01G 9/2059

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.10.2021 JP 2021177553**
**19.10.2022 JP 2022167661**

(71) Applicant: **Ricoh Company, Ltd.**
**Tokyo 143-8555 (JP)**

(72) Inventors:
- **TANAKA, Masato**
**Tokyo, 143-8555 (JP)**
- **TANAKA, Yuuji**
**Tokyo, 143-8555 (JP)**
- **TAMOTO, Nozomu**
**Tokyo, 143-8555 (JP)**
- **KANEI, Naomichi**
**Tokyo, 143-8555 (JP)**

(74) Representative: **J A Kemp LLP**
**80 Turnmill Street**
**London EC1M 5QU (GB)**

(54) **PHOTOELECTRIC CONVERSION ELEMENT AND PHOTOELECTRIC CONVERSION ELEMENT MODULE**

(57) [Summary] The present invention is to provide a photoelectric conversion element with excellent productivity, initial output performance and durability.

[Tasks] A photoelectric conversion element in which a first substrate, a first electrode, a photoelectric conversion layer, a second electrode, and a second substrate are sequentially laminated, includes an adhesive layer surrounding at least the photoelectric conversion layer, wherein a clearance surrounding an outer edge of the adhesive layer is formed between the outer edge of the adhesive layer and an outer edge of the first substrate in a plan view.

FIG.1

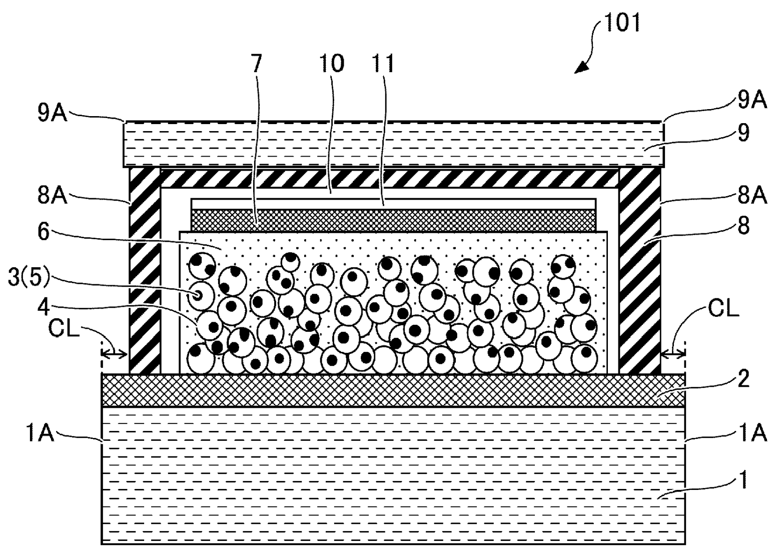


EP 4 174 888 A1

## Description

BACKGROUND OF THE INVENTION

1. Field of the Invention

The present invention relates to a photoelectric conversion element and a photoelectric conversion element module.

2. Description of the Related Art

In recent years, solar cells and photodiodes have become increasingly important as alternatives to fossil fuels and as countermeasures against global warming. Solar cells and photodiodes use photoelectric conversion elements that can convert light energy into electrical energy.

SUMMARY OF THE INVENTION

[Problem to be solved by the invention]

Recently, photoelectric conversion elements for indoor use, which have high power generation performance not only in sunlight (illuminance in direct light: about 100,000 lux) but also in low-illuminance light (illuminance: 20 lux or more and 1,000 lux or less) such as LED (light emitting diode) and fluorescent lamps, have attracted attention.

For example, an electronic device including a gas barrier film having a substrate and a gas barrier layer, a sealing substrate, an electronic device body positioned between the gas barrier film and the sealing substrate, and a welding accelerator is proposed. In the electronic device, the gas barrier film and the sealing substrate are bonded together through a welding accelerator, thereby sealing the electronic device body (see Japanese Patent Application Laid-Open No. 2013-232320).

In a conventional photoelectric conversion element having a sealing member, the sealing member (adhesive layer) protrudes out of the substrate, and when a user touches the device, the sealing member (adhesive layer) disadvantageously touches the adhesive portion, which may reduce productivity and initial output performance. Further, when the user touches the protruding adhesive layer or the substrate, the sealing portion may be broken, and the durability of the device may be reduced.

Disclosed is a photoelectric conversion element having excellent productivity, initial output performance, and durability.

[Means for Solving the Problem]

In order to solve the above-described problem, an aspect of the present invention provides
a photoelectric conversion element in which a first substrate, a first electrode, a photoelectric conversion layer, a second electrode, and a second substrate are sequentially laminated, including: an adhesive layer surrounding at least the photoelectric conversion layer, wherein a clearance surrounding an outer edge of the adhesive layer is formed between the outer edge of the adhesive layer and an outer edge of the first substrate in a plan view.

[Effect of the Invention]

The present invention can provide a photoelectric conversion element having good productivity, initial output performance, and durability.

BRIEF DESCRIPTION OF THE DRAWINGS

FIG. 1 is a schematic diagram illustrating an example of a photoelectric conversion element;
FIG. 2 is a plan view illustrating an example of a photoelectric conversion element;
FIG. 3 is a cross-sectional view taken along line A-A of FIG. 2;
FIG. 4 is a plan view illustrating a conventional example of a photoelectric conversion element; and
FIG. 5 is a cross-sectional view taken along line B-B of FIG. 4.

DESCRIPTION OF THE PREFERRED EMBODIMENTS

An example of the photoelectric conversion element of the present embodiment will be described below with reference to the drawings. However, the present invention is not limited thereto, and for example, the number, position, and shape of the following constituent members which are not described in the present embodiment are also included in the scope of the present invention. The embodiments of the present invention will be described below.

(Photoelectric Conversion Elements)

As illustrated in FIG. 1, the photoelectric conversion element 101 of the present embodiment includes a first substrate 1, a first electrode 2, a hole blocking layer 3, an electron transporting layer 4 having a photosensitizing compound 5, a hole transporting layer 6, a second electrode 7, and a second substrate 9. The photoelectric conversion element 101 further includes a sealing member 8 that at least surrounds the photoelectric conversion layer (electron transporting layer 4 and hole transporting layer 6).
In the present specification, the term "at least surrounds" indicates that either the sealing member surrounds only the lateral surface of the photoelectric conversion layer or the sealing member surrounds (covers) the entire lateral surface and top surface of the photoelectric conversion layer.
In the photoelectric conversion element 101, a first substrate 1, a hole blocking layer 3, and a second substrate 9 are optionally provided. The electron transporting layer 4 and the hole transporting layer 6 constitute a photoelectric conversion layer. The sealing member 8 is configured by sealing members for shielding the electron transporting layer 4, the hole transporting layer 6, and the second electrode 7 from the external environment of the photoelectric conversion element. In the present embodiment, part of the sealing member 8 is configured by the second substrate 9.
In the present specification, a photoelectric conversion element is an element capable of converting light energy into electric energy, and is applied, for example, to a solar cell, a photodiode, or the like.

«First Substrate»

The first substrate 1 is disposed on the outermost side of the first electrode 2 side of the photoelectric conversion element 101. The shape, structure, and size of the first substrate 1 are not particularly limited, and can be appropriately selected according to the purpose.
The material of the first substrate 1 is not particularly limited as long as the material has a translucent property and an insulating property, and can be appropriately selected according to a purpose. For example, a substrate such as glass, plastic film, ceramic, or the like can be used. Among these, in the case where the step of firing is performed in forming the electron transporting layer 4 as described later, a substrate having heat resistance to the firing temperature is preferably used. The first substrate 1 having flexible property is more preferably used.

<First Electrode>

The first electrode 2 is formed on the first substrate 1. The shape and size of the first electrode 2 are not particularly limited, and can be appropriately selected according to the purpose.
The structure of the first electrode 2 is not particularly limited, and can be appropriately selected according to the purpose, and may be a single layer structure or a structure in which a plurality of materials is laminated.
The material of the first electrode 2 is not particularly limited as long as the material has transparency and conductivity with respect to visible light, and can be appropriately selected according to the purpose, for example, a transparent conductive metal oxide, carbon, metal, or the like.
Examples of the transparent conductive metal oxide include indium tin oxide (Hereinafter referred to as "ITO"), fluorine-doped tin oxide (Hereinafter referred to as "FTO"), antimony-doped tin oxide (Hereinafter referred to as "ATO"), niobium-doped tin oxide (Hereinafter referred to as "NTO"), aluminum-doped zinc oxide, indium-zinc oxide, niobium-titanium oxide, and the like.
Examples of the carbon include carbon black, carbon nanotube, graphene, and fullerene.
Examples of the metal include gold, silver, aluminum, nickel, indium, tantalum, and titanium.
These may be used alone or two or more of these may be used in combination. Among these, a transparent conductive metal oxide having high transparency is preferable, and ITO, FTO, ATO, and NTO are more preferable.
An average thickness of the first electrode 2 is not particularly limited and may be appropriately selected according to the intended purpose. The average thickness of the first electrode 2 is preferably 5 nm or more but 100 μm or less, more preferably 50 nm or more but 10 μm or less. When a material of the first electrode 2 is carbon or a metal, the average thickness of the first electrode 2 is preferably an average thickness sufficient to obtain translucency.
The first electrode 2 can be formed by known methods such as the sputtering method, the vapor deposition

method, the spray method, and the like.

The first electrode 2 is preferably formed on the substrate. An integrated commercially available product where the first electrode 2 is formed on the first substrate 1 in advance can be used.

Examples of the integrated commercially available product include FTO coated glass, ITO coated glass, zinc oxide/aluminum-coated glass plate, FTO coated transparent plastic film, ITO coated transparent plastic film, and the like.

Examples of other integrated commercially available product include: a glass substrate provided with a transparent electrode where tin oxide or indium oxide is doped with a cation or an anion having a different atomic value; and a glass substrate provided with a metal electrode having such a structure that allows light in the form of a mesh or stripes to pass.

These may be used alone, or two or more products may be used in combination as a mixed product or a laminate. Moreover, a metal lead wire may be used in combination in order to decrease an electric resistance value.

Examples of the material of the metal lead wire include aluminum, copper, silver, gold, platinum, nickel, and the like.

The metal lead wire can be used in combination by forming the metal lead wire on the substrate by, for example, vapor deposition, sputtering, pressure bonding, and the like, and disposing a layer of ITO or FTO thereon.

Although Figures are not illustrated, the first electrode 2 has a path for conducting to an electrode extraction terminal.

«Hole blocking Layer»

The hole blocking layer 3 can prevent recombination of electrons and hole in the photoelectric conversion element 101. The hole blocking layer 3 contributes to the improvement of output and its durability. The hole blocking layer 3 is formed between the first electrode 2 and the electron transporting layer 4. In other words, the hole blocking layer 3 is provided between the first electrode 2 and the photoelectric conversion layer.

The hole blocking layer 3 can, for example, transport electrons generated by the photosensitizing compound 5 and transported to the electron transporting layer 4 to the first electrode 2 and prevent contact with the hole transporting layer 6. Thereby, the hole blocking layer 3 makes it difficult for holes to flow into the first electrode 2, and the output drop due to recombination of electrons and holes can be suppressed.

In the solid type photoelectric conversion element 101 provided with the hole transporting layer 6, the recombination speed of holes in the hole transporting material and electrons on the electrode surface is faster than that of the wet type using the electrolyte, and therefore, the effect of forming the hole blocking layer 3 is very large.

The materials of the hole blocking layer 3 are not particularly limited as long as the materials are transparent to visible light and has electron transport properties, and can be appropriately selected according to the purpose. Examples the materials of the hole blocking layer include a single semiconductor such as silicon, germanium, and the like; a compound semiconductor represented by a metal chalcogenide; and a compound having a perovskite structure.

Examples of the chalcogenide of metal include: oxides of, for example, magnesium, aluminum, titanium, tin, zinc, iron, tungsten, zirconium, hafnium, strontium, indium, cerium, yttrium, lanthanum, vanadium, niobium, tantalum, and the like; sulfides of, for example, cadmium, zinc, lead, silver, antimony, bismuth, and the like; selenides of, for example, cadmium, lead, and the like; and tellurium compounds of, for example, cadmium and the like.

Examples of the other compound semiconductor include phosphides of zinc, gallium, indium, cadmium, and the like; gallium arsenide; copper-indium-selenide, copper-indium-sulfide, and the like.

Examples of the compound having a perovskite structure include strontium titanate, calcium titanate, sodium titanate, barium titanate, potassium niobate, and the like.

Among these, oxide semiconductors are preferable, titanium oxide, niobium oxide, magnesium oxide, aluminum oxide, zinc oxide, tungsten oxide, tin oxide, and the like are more preferable, and titanium oxide is particularly preferable.

These materials may be used alone or two or more of these may be used in combination. The materials may also be laminated as a single layer. The crystal type of these semiconductors is not particularly limited, and can be suitably selected according to the purpose, and may be single crystal, polycrystal, or amorphous.

The method of fabricating the hole blocking layer 3 is not particularly limited, and can be appropriately selected according to a purpose. For example, a method of forming a thin film in a vacuum (vacuum film forming method), a wet film forming method, and the like can be used.

Examples of the vacuum film forming method include a sputtering method, a pulsed laser deposition method (PLD method), an ion beam sputtering method, an ion assist method, an ion plating method, a vacuum deposition method, an atomic layer deposition method (ALD method), a chemical vapor deposition method (CVD method), and the like.

Examples of the wet film forming method include a sol-gel method. The sol-gel method is a method in which a gel is prepared from a solution through a chemical reaction such as hydrolysis, polymerization, condensation, or the like, followed by heat treatment to promote densification.

When the sol-gel method is used, there are no particular limitations on the method of coating the sol solution, and the method can be appropriately selected according to the purpose. For example, a dip method, a spray method, a wire bar method, a spin coating method, a roller coating method, a blade coating method, a gravure coating method can be used. Furthermore, as wet printing methods, a relief printing method, an offset method, a gravure method, an intaglio printing method, a rubber plate method, a screen-printing method, and the like can be used.
The temperature at the time of heat treatment after coating the sol solution is preferably 80°C or higher, and more preferably 100°C or higher.
An average thickness of the hole blocking layer 3 is not particularly limited and can be appropriately selected according to the purpose. The average thickness of the hole blocking layer 3 is preferably in a range from 5 nm to 1 μm, more preferably in a range from 500 nm to 700 nm for wet film formation, and more preferably in a range from 5 nm to 30 nm for dry film formation.

<Photoelectric Conversion Layer>

The photoelectric conversion layer is a layer that converts light emitted to the photoelectric conversion element 101 into electricity. Specifically, the photoelectric conversion layer absorbs the light emitted and transports the generated electrons and holes to the first electrode 2 or the second electrode 7 for photoelectric conversion.
Therefore, the photoelectric conversion layer may include an electron transporting layer 4 for transporting electrons, a photosensitizing compound 5 for absorbing light and generating charges, a hole transporting layer 6 for transporting hole, and the like.
The photoelectric conversion layer of the present embodiment preferably has a hole transporting layer 6, which will be described later, and an electron transporting layer 4, which will be described later, and may include other layers as necessary.

<<Electron Transporting Layer>>

The electron transporting layer 4 is formed on the first electrode 2 via the hole blocking layer 3. The electron transporting layer 4 is, for example, a layer for transporting electrons generated by the photosensitizing compound 5 to the first electrode 2 or the hole blocking layer 3. Therefore, the electron transporting layer 4 is preferably disposed adjacent to the first electrode 2 or the hole blocking layer 3. Furthermore, according to the material used, the electron transporting layer 4 and the photosensitizing compound 5 may also be used.
Although the structure of the electron transporting layer 4 is not particularly limited and can be appropriately selected according to the purpose, the electron transporting layer 4 is preferably divided without extending from each other in at least two photoelectric conversion elements 101 adjacent to each other.
If the electron transporting layers 4 are divided, electron diffusion is suppressed and leakage current is reduced, which is advantageous in terms of improving optical durability. The structure of the electron transporting layer 4 may be a single layer or a multilayer in which a plurality of layers is laminated.
The electron transporting layer 4 includes an electron transport material and optionally other materials.
The electron transport material is not particularly limited and can be appropriately selected according to the purpose, but a semiconductor material is preferable.
The semiconductor materials have a fine particulate shape, and is preferably formed into a porous film by bonding the materials. In the semiconductor particles constituting the porous electron transporting layer 4, the photosensitizing compound 5 can be chemically or physically adsorbed on the surface thereof. By making the electron transporting layer 4 porous, the amount of the photosensitizing compound 5 adsorbed on the surface can be dramatically increased, and the output can be increased.
As described above, in the present embodiment, the photoelectric conversion layer has an electron transporting layer 4, and the electron transporting layer 4 includes a semiconductor material.
The semiconductor materials are not particularly limited, and known materials can be used. Examples of the material include a single semiconductor, a compound semiconductor, a compound having a perovskite structure, and the like.
Examples of the single semiconductor include silicon, germanium, and the like.
The compound semiconductor is, for example, a metal chalcogenide, specifically oxides such as titanium, tin, zinc, iron, tungsten, zirconium, hafnium, strontium, indium, cerium, yttrium, lanthanum, vanadium, niobium, tantalum, and the like; sulfides such as cadmium, zinc, lead, silver, antimony, bismuth, and the like; selenides such as cadmium, lead, and the like; and tellurides such as cadmium and the like. Other compound semiconductors include phosphides such as zinc, gallium, indium, cadmium, gallium arsenide, copper-indium-selenide, copper-indium-sulfide, and the like.
Examples of the compound having the perovskite structure include strontium titanate, calcium titanate, sodium titanate, barium titanate, potassium niobite, and the like.

Among these, oxide semiconductors are preferred, particularly titanium oxide, zinc oxide, tin oxide, and niobium oxide. When the electron transport material of the electron transporting layer 4 is titanium oxide, the conduction band is high and a high open voltage can be obtained. Further, the refractive index is high, and a high short-circuit current is obtained by the optical confinement effect. Furthermore, the high dielectric constant and the high mobility are advantageous in that a high curve factor can be obtained.

These may be used alone or two or more of these may be used in combination. The crystal type of the semiconductor material is not particularly limited, and can be appropriately selected according to the purpose, and may be single crystal, polycrystal, or amorphous.

The number average particle size of the primary particles of the semiconductor material is not particularly limited and can be appropriately selected according to the purpose, but is preferably in a range from 1 nm to 100 nm, and more preferably in a range from 5 nm to 50 nm. Further, a semiconductor material larger than the number average particle size may be mixed or laminated, and the conversion efficiency may be improved by the effect of scattering incident light. In this case, the number average particle size is preferably in a range from 50 nm to 500 nm.

The average thickness of the electron transporting layer 4 is not particularly limited and can be appropriately selected according to the purpose, but is preferably in a range from 50 nm to 100 μm, more preferably in a range from 100 nm to 50 μm, and particularly preferably in a range from 120 nm to 10 μm.

When the average thickness of the electron transporting layer 4 is within a preferable range, it is advantageous in that the amount of the photosensitizing compound 5 per unit projected area can be sufficiently secured, the trapping rate of light can be maintained high, the diffusion distance of injected electrons is hardly increased, and the loss due to charge recombination can be reduced.

A production method of the electron transporting layer is not particularly limited and may be appropriately selected according to the intended purpose. Examples of the production method include a method such as sputtering and the like where a thin film is formed in vacuum, and a wet film formation method. Among them, in terms of production cost, it is preferable to use a wet film formation method, and it is particularly preferable to use a method where paste obtained by dispersing particles or sol of a semiconductor is prepared, and then the paste is coated onto the first electrode 2 as electron collecting electrode formed on a substrate or onto the hole blocking layer 3.

The wet film forming method is not particularly limited, and can be appropriately selected according to the purpose, for example, a dip method, a spray method, a wire bar method, a spin coat method, a roller coat method, a blade coat method, a gravure coat method, and the like.

As the wet printing method, various methods such as a relief printing method, an offset method, a gravure method, an intaglio printing method, a rubber plate method, a screen-printing method, and the like can be used.

As a method of preparing a dispersion liquid of the semiconductor material, for example, a method of mechanically pulverizing the semiconductor material using a known milling device or the like can be used. By this method, a dispersion liquid of the semiconductor material can be prepared by dispersing the particulate semiconductor material alone or a mixture of the semiconductor material and a resin in water or a solvent.

Examples of the resin include polymers or copolymers of vinyl compounds such as styrene, vinyl acetate, acrylic acid ester, and methacrylic acid ester; silicone resins, phenoxy resins, polysulfone resins, polyvinyl butyral resins, polyvinyl formal resins, polyester resins, cellulose ester resins, cellulose ether resins, urethane resins, phenol resins, epoxy resins, polycarbonate resins, polyarylate resins, polyamide resins, and polyimide resins. These may be used alone or in combination of two or more of them.

Examples of the solvent include water, alcohol solvents, ketone solvents, ester solvents, ether solvents, amide solvents, halogenated hydrocarbon solvents, hydrocarbon solvents, and the like.

Examples of the alcohol solvent include methanol, ethanol, isopropyl alcohol, α-terpineol, and the like.

Examples of the ketone solvent include acetone, methyl ethyl ketone, methyl isobutyl ketone, and the like.

Examples of the ester solvent include ethyl formate, ethyl acetate, n-butyl acetate, and the like.

Examples of the ether solvent include diethyl ether, dimethoxyethane, tetrahydrofuran, dioxolane, dioxane, and the like.

Examples of the amide solvent include N,N-dimethylformamide, N,N-dimethylacetamide, N-methyl-2 pyrrolidone, and the like.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, 1-chloronaphthalene, and the like.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, cumene, and the like.

These solvents may be used alone or in combination of two or more of them.

To the dispersion liquid of the semiconductor material or the paste of the semiconductor material obtained by, for example, the sol-gel method, acid, a surfactant, or a chelating agent may be added in order to prevent re-aggregation

of the particles.

Examples of the acid include hydrochloric acid, nitric acid, acetic acid, and the like.

Examples of the surfactant include polyoxyethylene octylphenyl ether and the like.

Examples of the chelating agent include, for example, acetylacetone, 2-aminoethanol, ethylenediamine, and the like.

Moreover, a thickener may be added to the dispersion for the purpose of improving a film formation property.

Examples of the thickener include polyethylene glycol, polyvinyl alcohol, ethyl cellulose, and the like.

In order to electronically contact particles of the semiconductor material with each other after the coating the semiconductor material to improve strength of a film and adhesiveness to a substrate, the semiconductor particle is preferably subjected to firing, irradiation of microwave, irradiation of electron rays, and irradiation of laser light. These treatments may be performed alone or in combination of two or more of them.

When the firing the electronic transport layer 4 formed from the semiconductor material is performed, the firing temperature is not particularly limited and may be appropriately selected according to the intended purpose. When the firing temperature is increased too much, a resistance of the substrate may be increased or melting may occur. Therefore, the firing temperature is preferably in a range from 30°C to 700°C, more preferably in a range from 100°C to 600°C. The firing time is not particularly limited and may be appropriately selected according to the intended purpose, but is preferably in a range from 10 minutes to 10 hours.

When the electron transporting layer 4 formed of the semiconductor material is subjected to microwave irradiation, the irradiation time is not particularly limited, and can be appropriately selected according to the purpose. The irradiation time is preferably 1 hour or less. In this case, irradiation may be performed from the side where the electron transporting layer 4 is formed or from the side where the electron transporting layer 4 is not formed.

After the electron transporting layer 4 made of the semiconductor material is fired, chemical plating or electrochemical plating may be performed for the purpose of increasing the surface area of the electron transporting layer 4 or increasing the efficiency of injecting electrons from the photosensitizing compound 5 to the semiconductor material. For the chemical plating, for example, an aqueous solution of titanium tetrachloride or a mixed solution with an organic solvent is used. For example, an aqueous solution of titanium trichloride is used for the electrochemical plating treatment.

A film, which is obtained by, for example, firing the semiconductor material having a diameter of several tens of nanometers, can form a porous state. Such a porous structure has an extremely high surface area, and the surface area can be represented by using a roughness factor.

The roughness factor is a numerical value representing an actual area of the inner sides of pores relative to an area of the semiconductor particles coated onto the first substrate 1. Therefore, the roughness factor is preferably larger. However, in terms of a relationship with the average thickness of the electron transporting layer 4, the roughness factor is preferably 20 or more.

The particles of the electron transporting material may be doped with a lithium compound. For example, a solution of a lithium bis (trifluoromethanesulfonimide) compound is deposited on particles of an electron transporting material by using a spin coat or the like, and then fired.

The lithium compound is not particularly limited and can be appropriately selected according to the purpose. Examples of the lithium compound include lithium bis (trifluoromethanesulfonimide), lithium bis (fluoromethanesulfonimide), lithium bis (fluoromethanesulfonyl) (trifluoromethanesulfonyl) imide, lithium perchlorate, and lithium iodide, in addition to the lithium bis (trifluoromethanesulfonimide) described above.

«Photosensitizing Compounds»

In the present embodiment, the electron transporting layer 4 has a photosensitizing compound 5. Specifically, in order to improve the conversion efficiency of the photoelectric conversion element 101, the photosensitizing compound 5 is adsorbed on the surface of the electron transporting material (For example, a semiconductor material) of the electron transporting layer 4.

The photosensitizing compound 5 is not particularly limited and may be appropriately selected according to the intended purpose so long as the photosensitizing compound is a compound photoexcited by excitation light to be used. Examples of the photosensitizing compound include: metal complex compounds described in, for example, Japanese Translation of PCT International Application Publication No.H7-500630, Japanese Unexamined Patent Application Publication No. H10-233238, Japanese Unexamined Patent Application Publication No. 2000-26487, Japanese Unexamined Patent Application Publication No. 2000-323191, and Japanese Unexamined Patent Application Publication No. 2001-59062; coumarine compounds described in, for example, Japanese Unexamined Patent Application Publication No. H10-93118, Japanese Unexamined Patent Application Publication No. 2002-164089, Japanese Unexamined Patent Application Publication No. 2004-95450, and J. Phys. Chem. C, 7224, Vol. 111 (2007); polyene compounds described in, for example, Japanese Unexamined Patent Application Publication No. 2004-95450 and Chem. Commun., 4887 (2007); indoline compounds described in, for example, Japanese Unexamined Patent Application Publication No.

2003-264010, Japanese Unexamined Patent Application Publication No. 2004-63274, Japanese Unexamined Patent Application Publication No. 2004-115636, Japanese Unexamined Patent Application Publication No. 2004-200068, Japanese Unexamined Patent Application Publication No. 2004-235052, J. Am. Chem. Soc., 12218, Vol. 126 (2004), Chem. Commun., 3036 (2003), and Angew. Chem. Int. Ed., 1923, Vol. 47 (2008); thiophene compounds described in, for example, J. Am. Chem. Soc., 16701, Vol. 128 (2006) and J. Am. Chem. Soc., 14256, Vol. 128 (2006); cyanine dyes described in, for example, Japanese Unexamined Patent Application Publication No. H11-86916, Japanese Unexamined Patent Application Publication No. H11-214730, Japanese Unexamined Patent Application Publication No. 2000-106224, Japanese Unexamined Patent Application Publication No. 2001-76773, and Japanese Unexamined Patent Application Publication No. 2003-7359; merocyanine dyes described in, for example, Japanese Unexamined Patent Application Publication No. H11-214731, Japanese Unexamined Patent Application Publication No. H11-238905, Japanese Unexamined Patent Application Publication No. 2001-52766, Japanese Unexamined Patent Application Publication No. 2001-76775, and Japanese Unexamined Patent Application Publication No. 2003-7360; 9-arylxanthene compounds described in, for example, Japanese Unexamined Patent Application Publication No. H10-92477, Japanese Unexamined Patent Application Publication No. H11-273754, Japanese Unexamined Patent Application Publication No. H11-273755, and Japanese Unexamined Patent Application Publication No. 2003-31273; triarylmethane compounds described in, for example, Japanese Unexamined Patent Application Publication No. H10-93118 and Japanese Unexamined Patent Application Publication No. 2003-31273; and phthalocyanine compounds and porphyrin compounds described in, for example, Japanese Unexamined Patent Application Publication No. H9-199744, Japanese Unexamined Patent Application Publication No. H10-233238, Japanese Unexamined Patent Application Publication No. H11-204821, Japanese Unexamined Patent Application Publication No. H11-265738, J. Phys. Chem., 2342, Vol. 91 (1987), J. Phys. Chem. B, 6272, Vol. 97 (1993), Electroanal. Chem., 31, Vol. 537 (2002), Japanese Unexamined Patent Application Publication No. 2006-032260, J. Porphyrins Phthalocyanines, 230, Vol. 3 (1999), Angew. Chem. Int. Ed., 373, Vol. 46 (2007), and Langmuir, 5436, Vol. 24 (2008).

Among these compounds, a metal complex compound, a coumarin compound, a polyene compound, an indoline compound, and a thiophene compound are preferable. For example, compounds of the following structural formulas (1), (2), and (3), manufactured by Mitsubishi Paper Mills Limited, are preferably used.

[Chemical Formula 1]

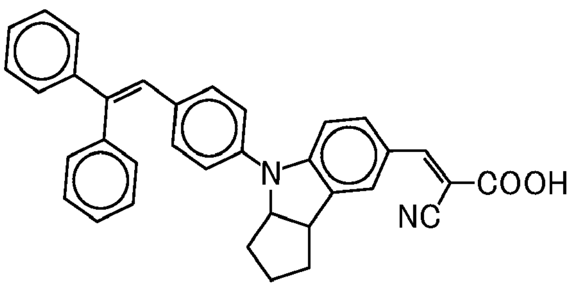

...Structural Formula (1)

[Chemical Formula 2]

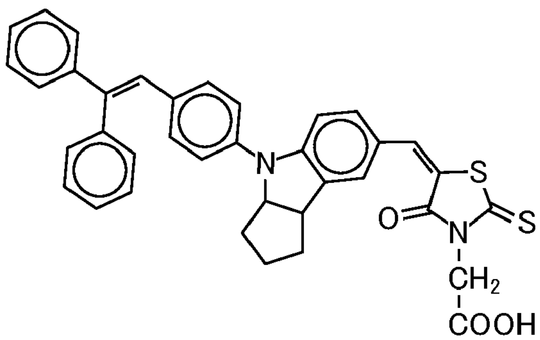

...Structural Formula (2)

[Chemical Formula 3]

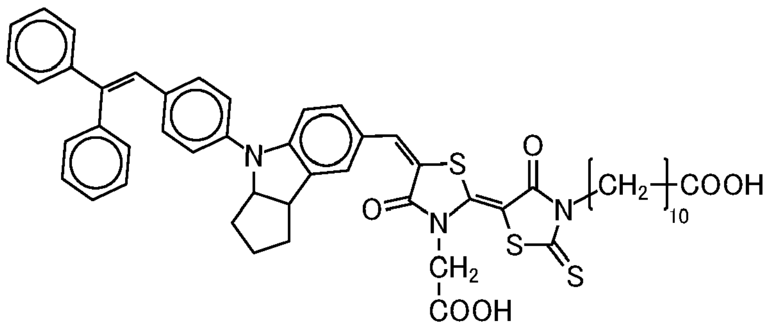

...Structural Formula (3)

More preferably used photosensitizing compounds include compounds containing the following general formula (1).

[Chemical Formula 4]

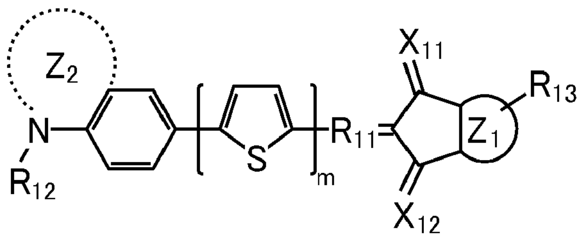

...General Formula (1)

In the general formula (1), $X_{11}$ and $X_{12}$ each independently represent an oxygen atom, a sulfur atom or a selenium atom.

$R_{11}$ represents a methine group which may have a substituent. Specific examples of the substituent include aryl groups such as phenyl groups, naphthyl groups, and the like, and heterocycles such as thienyl groups, furyl groups, and the like.

$R_{12}$ represents an alkyl group, aryl group, or heterocyclic group which may have a substituent. Examples of the alkyl group include a methyl group, an ethyl group, a 2-propyl group, a 2-ethylhexyl group, and the like, and examples of the aryl group and the heterocyclic group include those described above.

$R_{13}$ represents an acidic group such as a carboxylic acid, a sulfonic acid, a phosphonic acid, a boronic acid, or a phenol. $R_{13}$ may be one or more.

$Z_1$ and $Z_2$ each independently represent a substituent that forms a cyclic structure. Examples of $Z_1$ include condensed hydrocarbon-based compounds such as a benzene ring and a naphthalene ring, and heterocycles such as a thiophene ring and a furan ring, each of which may have a substituent. Specific examples of the substituent include the alkyl groups and the alkoxy groups such as a methoxy group, an ethoxy group, and a 2-isopropoxy group described above. Examples of $Z_2$ include the following (A-1) to (A-22).

Note that m represents an integer from 0 to 2.

[Chemical Formula 5]

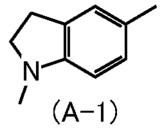
(A-1)

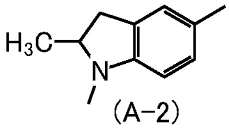
(A-2)

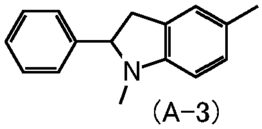
(A-3)

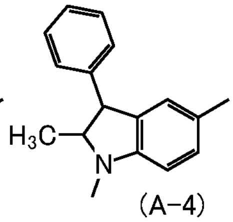
(A-4)

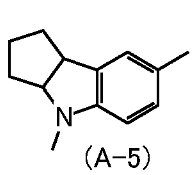
(A-5)

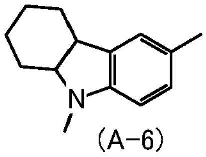
(A-6)

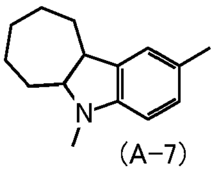
(A-7)

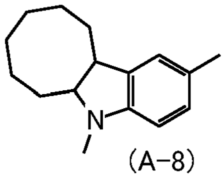
(A-8)

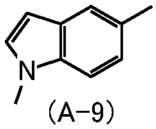
(A-9)

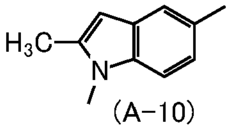
(A-10)

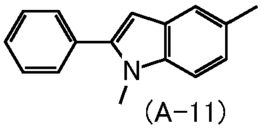
(A-11)

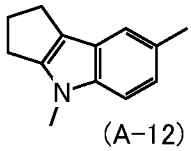
(A-12)

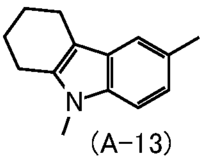
(A-13)

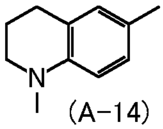
(A-14)

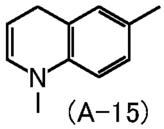
(A-15)

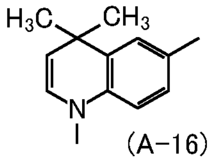
(A-16)

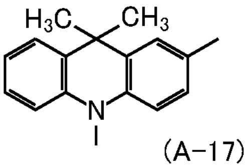
(A-17)

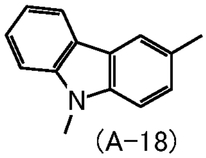
(A-18)

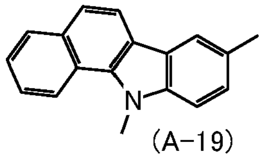
(A-19)

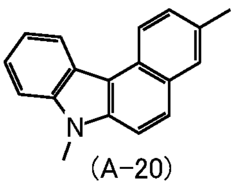
(A-20)

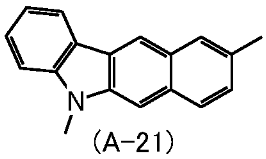
(A-21)

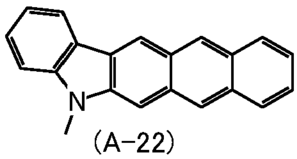
(A-22)

Among the above compounds, a compound represented by the following general formula (2) is more preferably used.

[Chemical Formula 6]

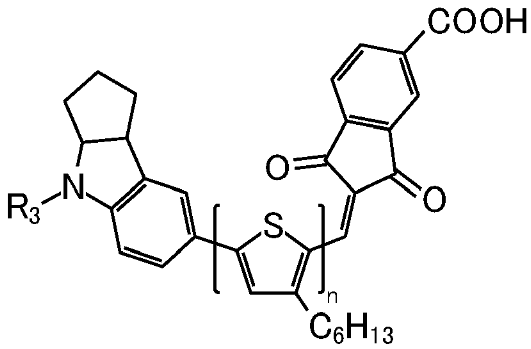

...General Formula (2)

In the general formula (2), n represents an integer of 0 or 1. $R_3$ represents an aryl group which may have a substituent or one of the following three structural formulas.

[Chemical Formula 7]

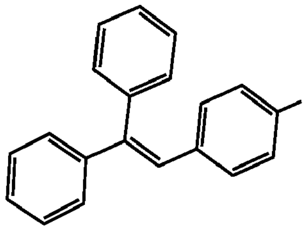

、

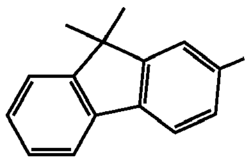

、

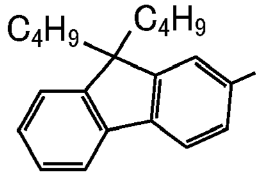

Specific examples of photosensitizing compound including the general formulas (1) and (2) include (B-1) to (B-41) described below. However, the compounds are not limited to the above.

[Chemical Formula 8]

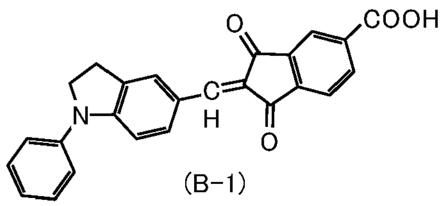
(B-1)

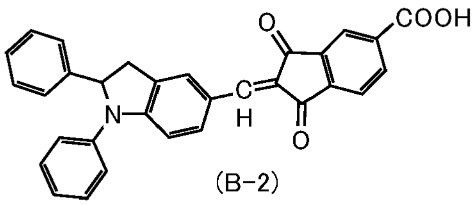
(B-2)

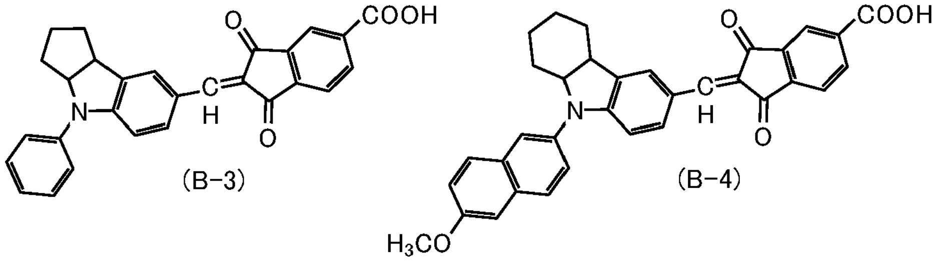
(B-3)

(B-4)

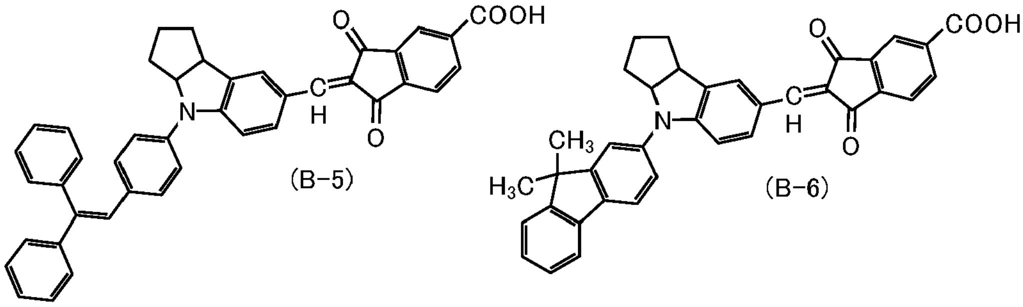
(B-5)

(B-6)

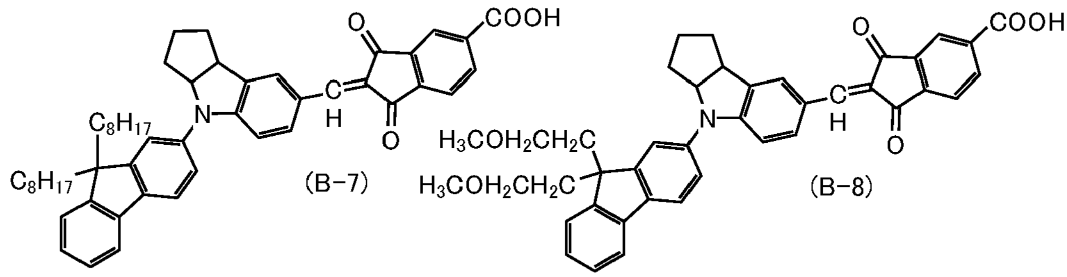
(B-7)

(B-8)

[Chemical Formula 9]

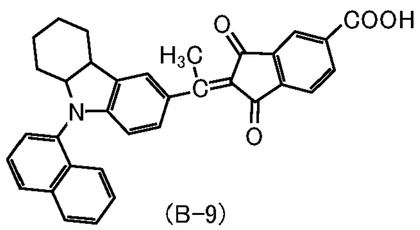

(B-9)

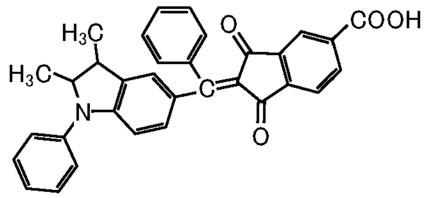

(B-10)

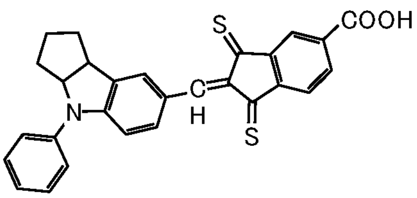

(B-11)

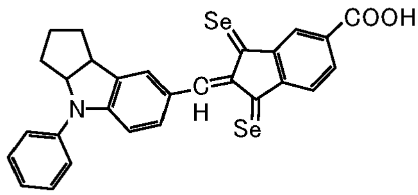

(B-12)

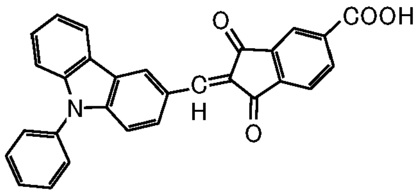

(B-13)

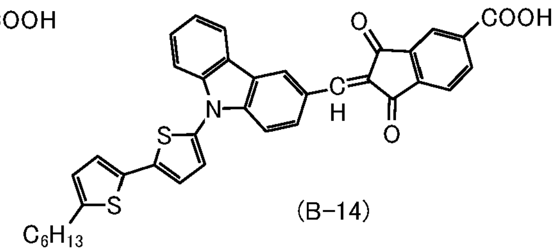

(B-14)

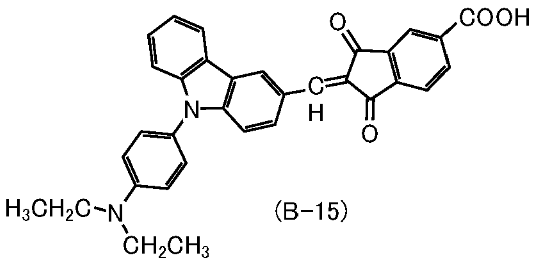

(B-15)

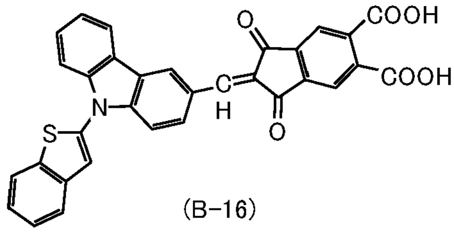

(B-16)

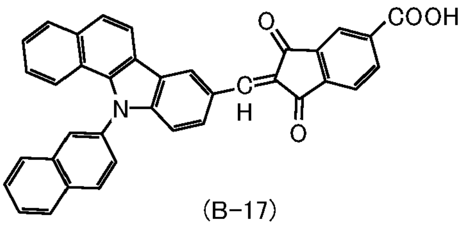

(B-17)

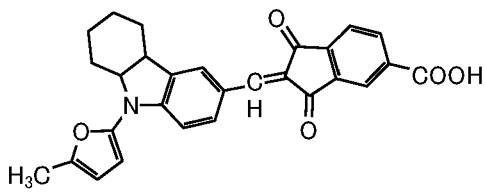

(B-18)

[Chemical Formula 10]

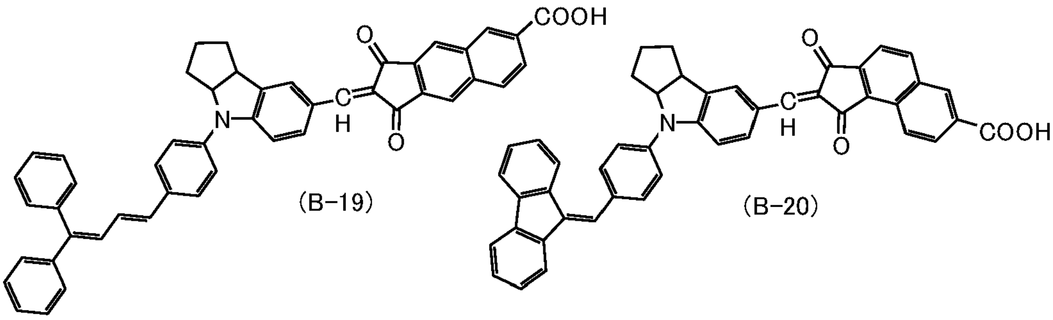

(B-19) (B-20)

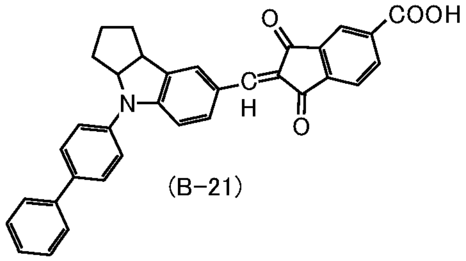

(B-21)

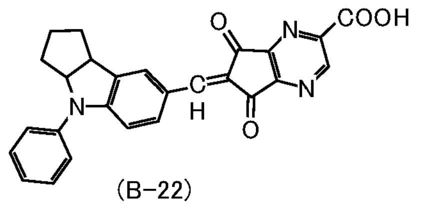

(B-22)

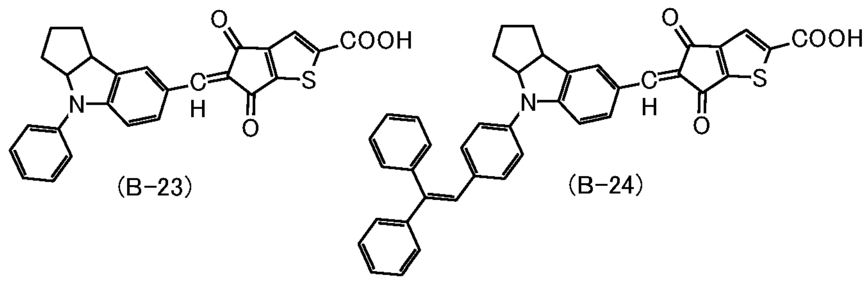

(B-23) (B-24)

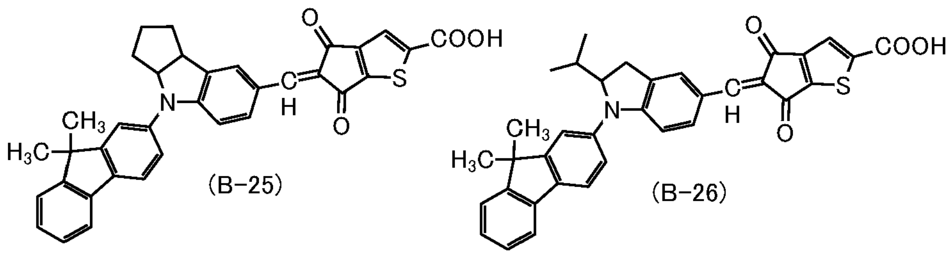

(B-25) (B-26)

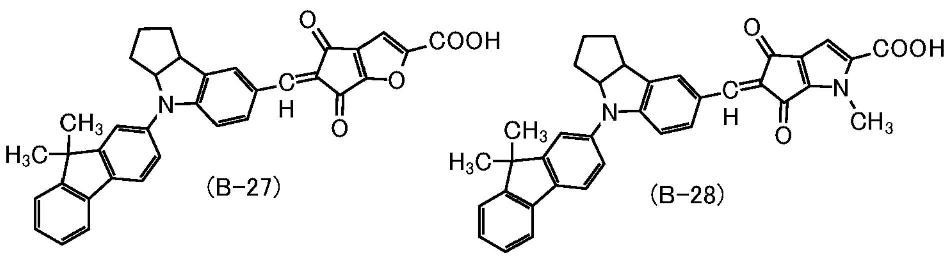

(B-27) (B-28)

[Chemical Formula 11]

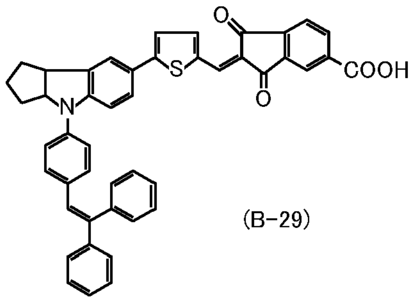

(B-29)

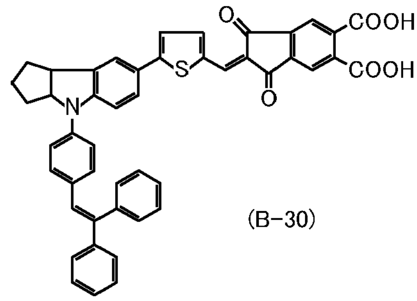

(B-30)

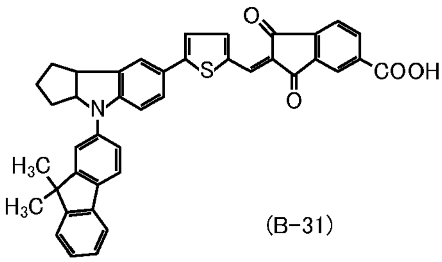

(B-31)

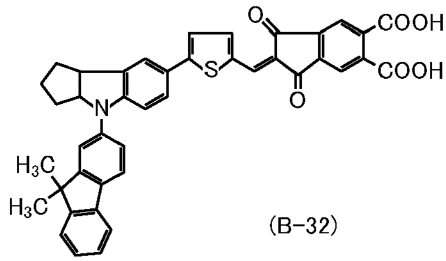

(B-32)

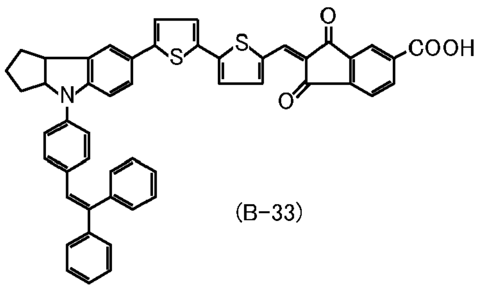

(B-33)

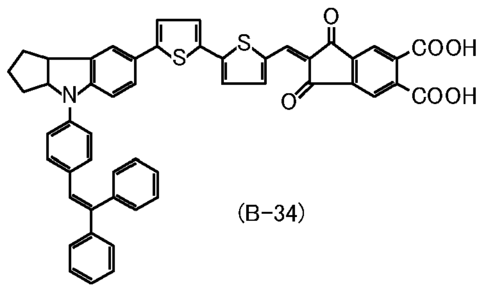

(B-34)

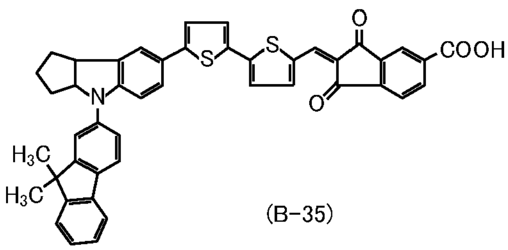

(B-35)

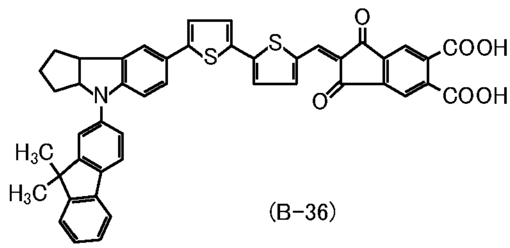

(B-36)

[Chemical Formula 12]

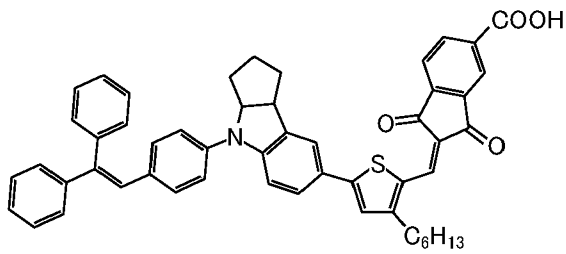

(B-37)

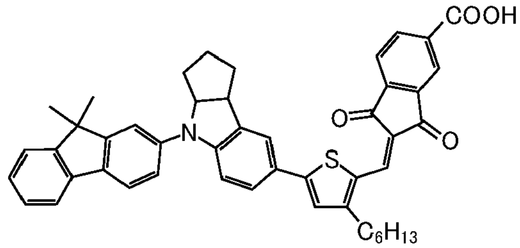

(B-38)

[Chemical Formula 13]

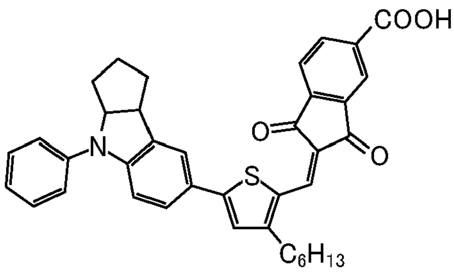

(B-39)

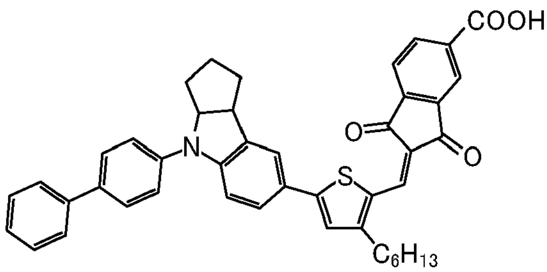

(B-40)

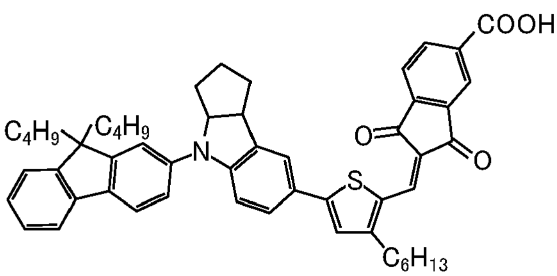

(B-41)

Further, a compound containing the following general formula (3) can be preferably used as a photosensitizing compound.

[Chemical Formula 14]

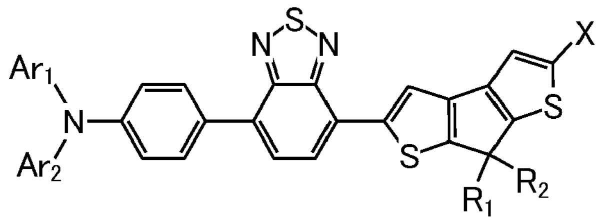

...General Formula (3)

In the general formula (3), $Ar_1$ and $Ar_2$ represent an aryl group which may have a substituent. $R_1$ and $R_2$ represent linear or branched alkyl group having carbon number of 4 to 10. X represents one of the substituents represented by the following four structural formulas.

[Chemical Formula 15]

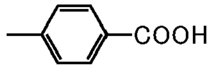 、 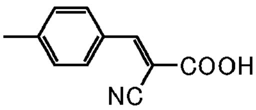 、 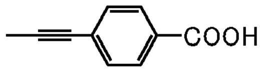 、 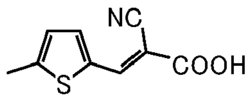

Among the photosensitizing compounds represented by general formula (3), the compound represented by general formula (4) is more preferably used.

[Chemical Formula 16]

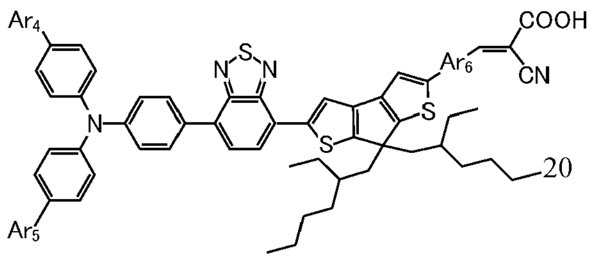

...General Formula (4)

In the general formula (4), $Ar_4$ and $Ar_5$ represent a phenyl group which may have a substituent or a naphthyl group which may have a substituent. $Ar_6$ represents a phenyl group which may have a substituent or a thiophene group which may have a substituent.

The following (B-42) to (B-58) are illustrated as specific examples of the photosensitizing compound represented by the above general formula (3) and the above general formula (4), but the photosensitizing compound 5 in the present embodiment is not limited thereto.

[Chemical Formula 17]

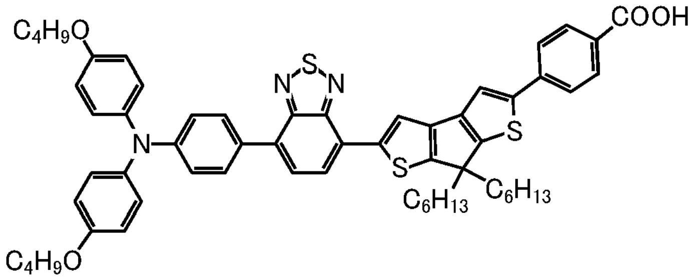

(B-42)

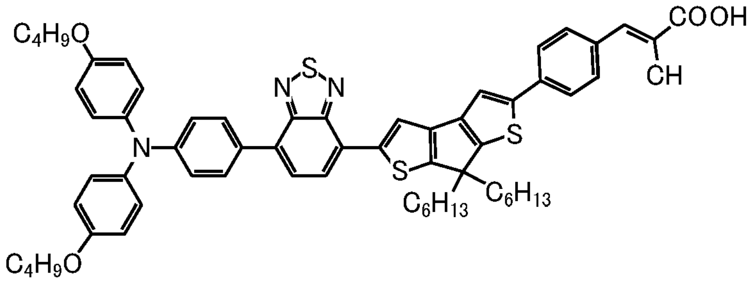

(B-43)

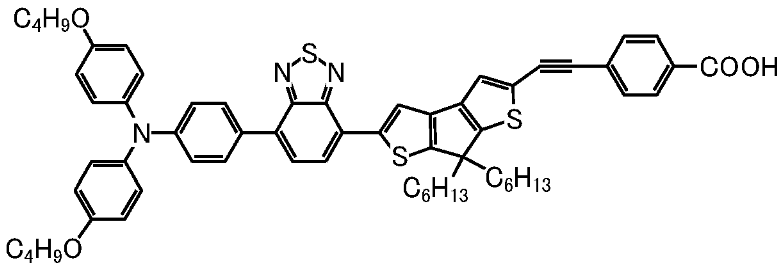

(B-44)

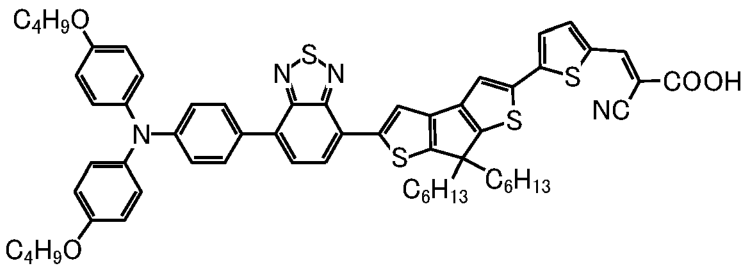

(B-45)

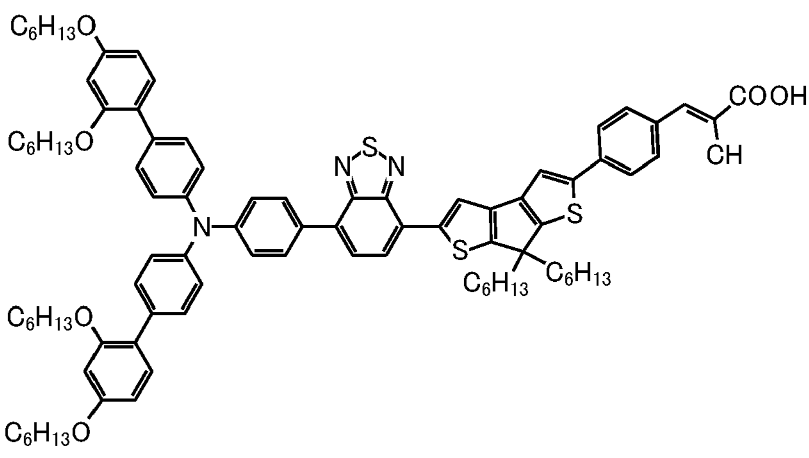

(B-46)

[Chemical Formula 18]

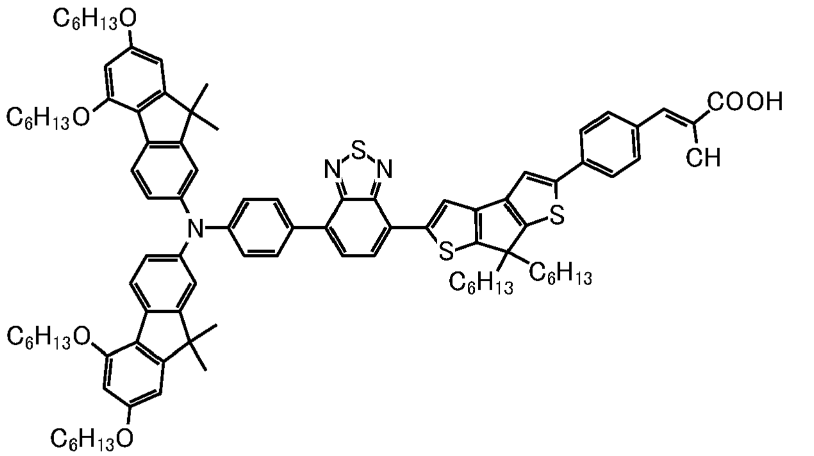

(B-47)

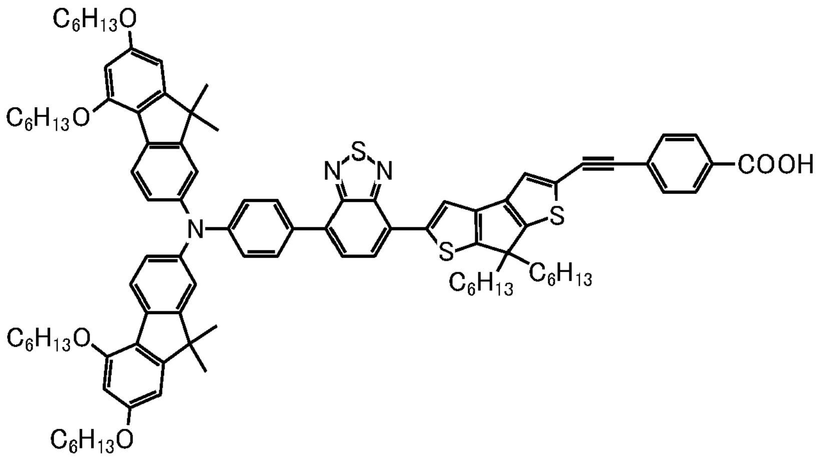

(B-48)

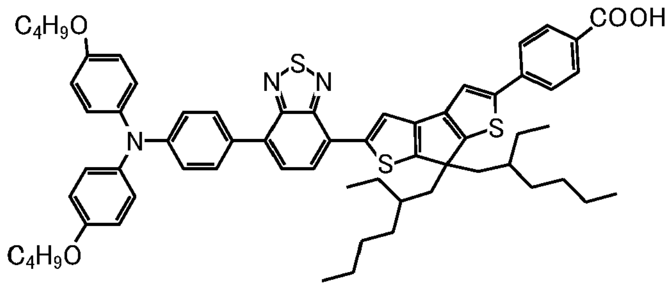

(B-49)

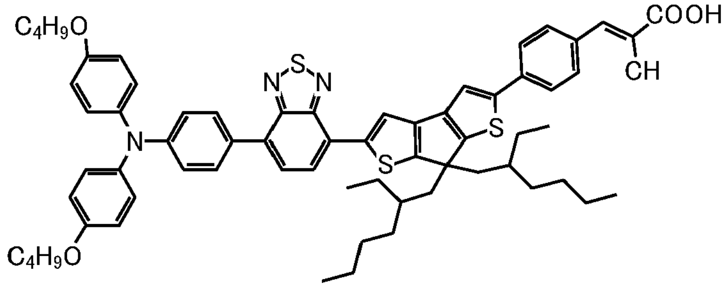

(B-50)

[Chemical Formula 19]

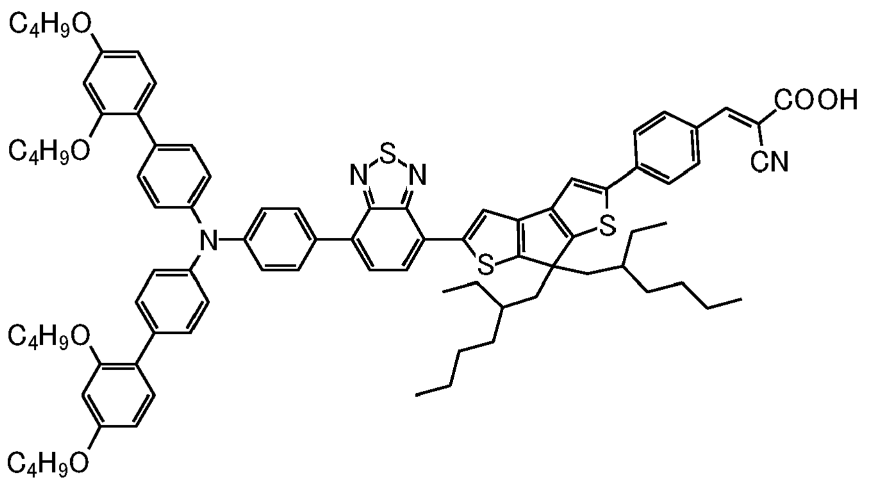

(B-51)

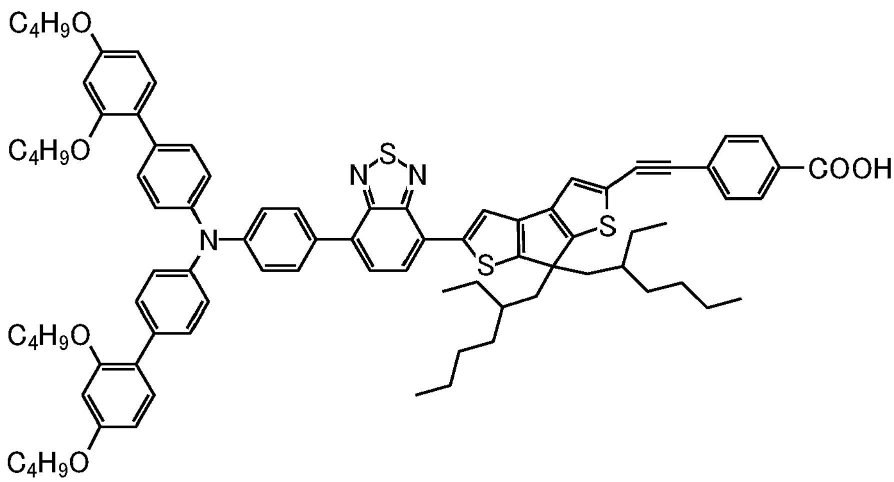

(B-52)

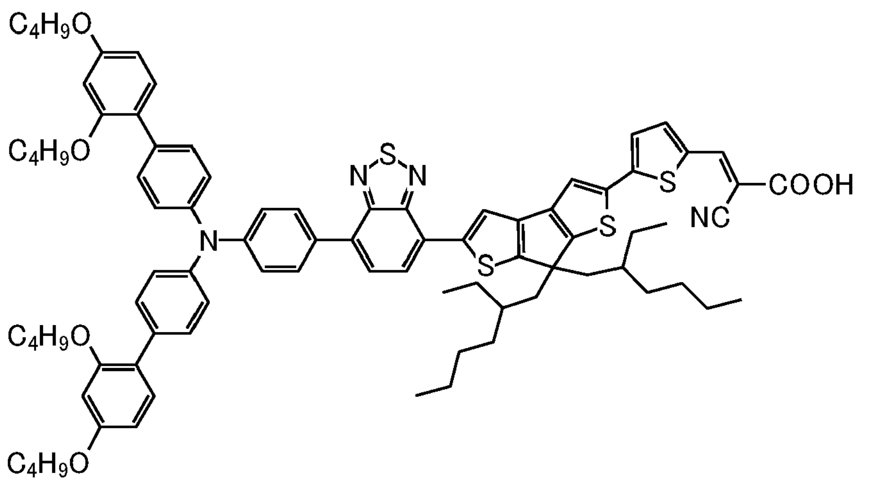

(B-53)

[Chemical Formula 20]

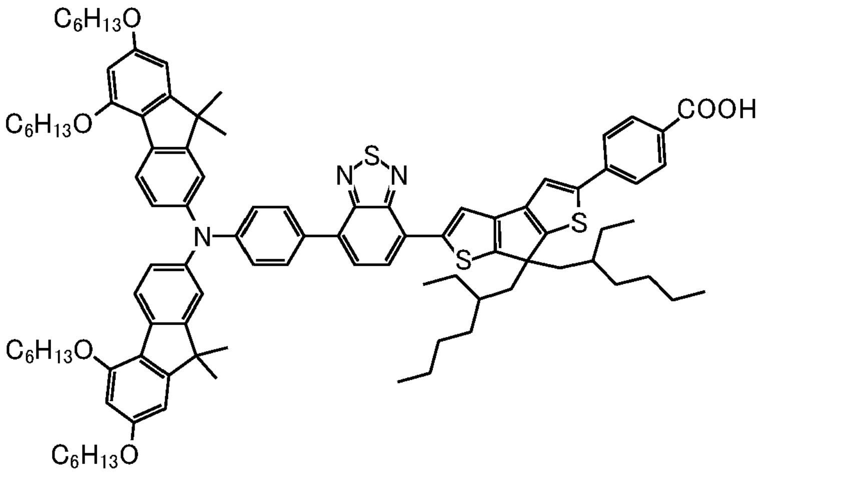

(B-54)

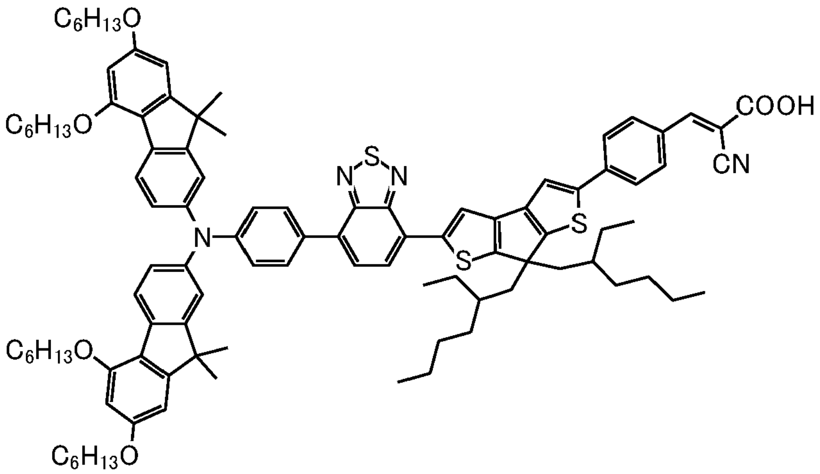

(B-55)

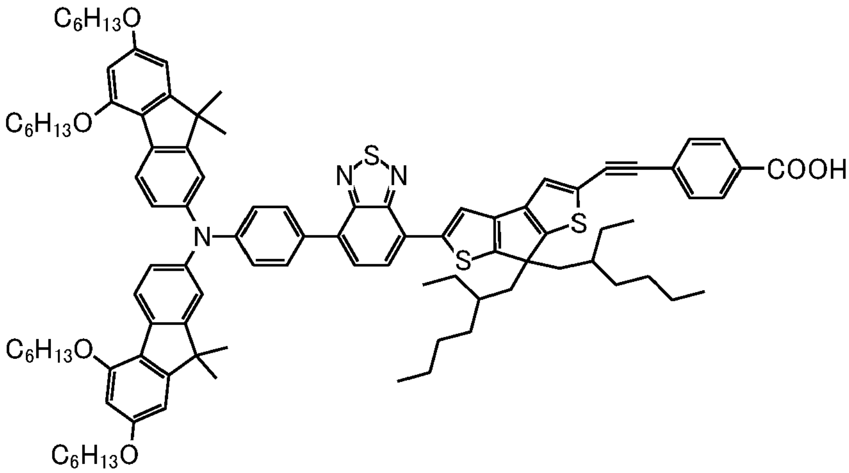

(B-56)

[Chemical Formula 21]

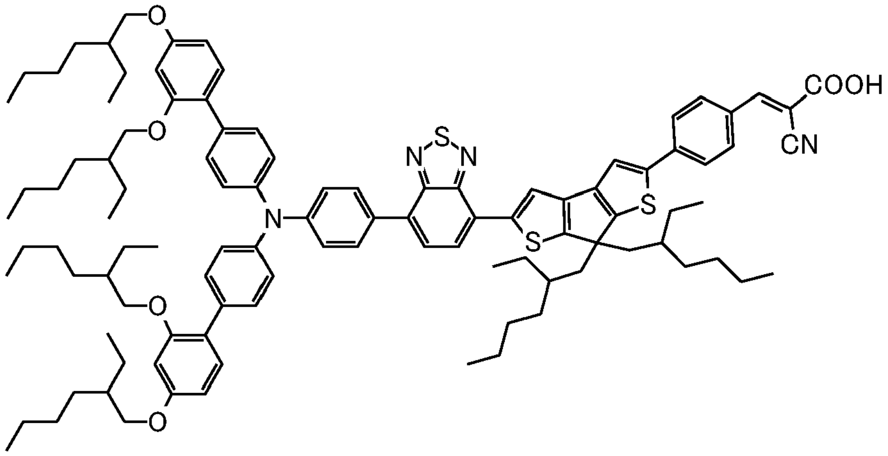

(B-57)

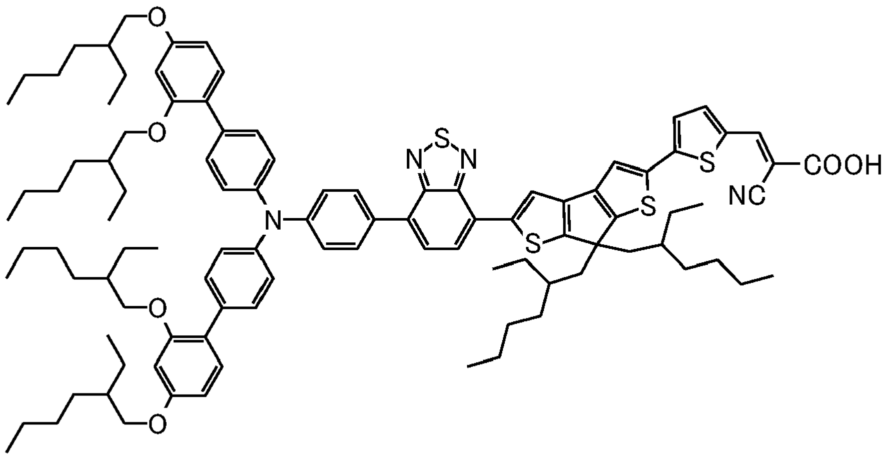

(B-58)

One kind or two or more kinds of these photosensitizing compounds may be used.

LED light sources having different colors such as warm, cool, and white are used, and the spectrum differs depending on the color. For example, when the color temperature is 3,000 K, the region of 600 nm becomes relatively strong, and the bulb color becomes reddish. A color temperature of 5,000 K produces a well-balanced neutral white color overall. Furthermore, when the color temperature exceeds 6,500 K, the 450 nm region becomes relatively strong and bluish daylight.

In the photoelectric conversion element, a high output can be preferably maintained even if the color temperature of the LED used in this manner is different. Therefore, from the viewpoint of reducing the output difference due to the color temperature, it is preferable to mix different photosensitizing compounds.

The method of adsorbing the photosensitizing compound 5 on the surface of the semiconductor material of the electron transporting layer 4 is not particularly limited, and can be appropriately selected according to the purpose. For example, a method of immersing the electron transporting layer 4 containing the semiconductor material in a solution or a dispersion of the photosensitizing compound 5, or a method of coating and adsorbing the solution or the dispersion of the photosensitizing compound 5 on the electron transporting layer 4 may be used.

In the case of the method of immersing the electron transporting layer 4 containing the semiconductor material in the solution or the dispersion of the photosensitizing compound 5, an immersion method, a dip method, a roller method, an air knife method, or the like can be used.

In the case of the method of coating and absorbing the solution or the dispersion of the photosensitizing compound 5 on the electron transporting layer 4, a wire bar method, a slide hopper method, an extrusion method, a curtain method, a spin method, a spray method, or the like can be used. Moreover, the photosensitizing compound may be adsorbed in a supercritical fluid using, for example, carbon dioxide.

When the photosensitizing compound is adsorbed on the semiconductor material, a condensing agent may be used in combination of two or more of them.

The condensing agent may be an agent exhibiting such a catalytic function that a photosensitizing compound is physically or chemically bound to a surface of the semiconductor material, or may be an agent that stoichiometrically acts and advantageously moves a chemical equilibrium. Moreover, thiol or a hydroxyl compound may be added thereto

as a condensation auxiliary.

Examples of the solvent that dissolves or disperses the photosensitizing compound include water, an alcohol solvent, a ketone solvent, an ester solvent, an ether solvent, an amide solvent, a halogenated hydrocarbon solvent, a hydrocarbon solvent, and the like.

Examples of the alcohol solvent include methanol, ethanol, isopropyl alcohol, and the like.

Examples of the ketone solvent include acetone, methyl ethyl ketone, methyl isobutyl ketone, and the like.

Examples of the ester solvent include ethyl formate, ethyl acetate, n-butyl acetate, and the like.

Examples of the ether solvent include diethyl ether, dimethoxyethane, tetrahydrofuran, dioxolane, dioxane, and the like.

Examples of the amide solvent include N,N-dimethylformamide, N,N-dimethylacetamide, N-methyl-2 pyrrolidone, and the like.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, 1-chloronaphthalene, and the like.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, cumene, and the like.

These solvents may be used alone or in combination of two or more of them.

Depending on kinds of photosensitizing compounds, there is a photosensitizing compound that functions more effectively when aggregation between compounds is prevented. Therefore, an aggregation dissociating agent may be used in combination. The aggregation dissociating agent is not particularly limited and may be appropriately selected depending on a dye to be used. Examples of the aggregation dissociating agent include steroid compounds such as cholic acid and chenodeoxycholic acid, long-chain alkyl carboxylic acid, and long-chain alkyl phosphonic acid.

An amount of the aggregation dissociating agent added is preferably in a range from 0.5 parts by mol to 100 parts by mol, and more preferably in a range from 10 parts by mol to 50 parts by mol with respect to 1 part by mol of the photosensitizing compound.

The temperature at which the photosensitizing compound 5 or the photosensitizing compound 5 and the aggregation dissociating agent are adsorbed on the surface of the semiconductor material constituting the electron transporting layer 4 is preferably in a range from -50°C to 200°C. The adsorption time is preferably from in a range from 5 seconds to 1,000 hours, more preferably in a range from 10 seconds to 500 hours, and particularly preferably in a range from 1 minute to 150 hours.

The adsorption step is preferably performed in a dark place. The adsorbing step may be performed in a static state or while stirring.

The stirring method is not particularly limited and can be appropriately selected according to the purpose. Examples include methods using a stirrer, a ball mill, a paint conditioner, a Sandoz mill, an attritor, a disperser, an ultrasonic dispersion, and the like.

In the present embodiment, a perovskite layer can also be provided. The perovskite layer means a layer containing a perovskite compound and sensitizing the electron transporting layer 4 by absorbing light. Therefore, the perovskite layer is preferably disposed adjacent to the electron transporting layer 4.

The perovskite compound is a composite material of an organic compound and an inorganic compound, and is represented by the following general formula (5):

$$X\alpha Y\beta M\gamma \quad \cdot\cdot\cdot \quad (5)$$

In the general formula (5), the ratio of $\alpha$:$\beta$:$\gamma$ is 3:1:1, and $\beta$ and $\gamma$ represent integers larger than 1. For example, X may be a halogen ion, Y may be an alkylamine compound ion, and M may be a metal ion.

X in the above general formula (5) is not particularly limited, and can be appropriately selected according to a purpose, for example, a halogen ion such as chlorine, bromine, iodine, or the like. These may be used alone or two or more of these may be used in combination.

Y in the above general formula (5) includes alkylamine compound ions such as methylamine, ethylamine, n-butylamine, formamidine, and the like; cesium, potassium, rubidium, and the like.

In the case of lead-methylammonium halide perovskite compounds, when the halogen ion is Cl, the peak optical absorption spectrum $\lambda$ max is about 350 nm for Cl, about 410 nm for Br, and about 540 nm for I, which shifts to the longer wavelength side. Therefore, the available spectral width (band width) is different.

The M in the above general formula (5) is not particularly limited and can be appropriately selected according to the purpose, for example, metals such as lead, indium, antimony, tin, copper, bismuth, and the like.

The perovskite layer preferably has a layered perovskite structure in which a layer composed of a metal halide

and a layer in which organic cation molecules are arranged are alternately laminated.

The method of forming the perovskite layer is not particularly limited, and can be appropriately selected according to the purpose, for example, a method of drying after applying a solution obtained by dissolving or dispersing a metal halide and an alkylamine halide.

Other methods of forming the perovskite layer include, for example, a two-step deposition method in which a solution obtained by dissolving or dispersing a metal halide is applied and dried, and then immersed in a solution obtained by dissolving an alkylamine halide to form the perovskite compound.

Still another method of forming the perovskite layer includes, for example, a method of depositing crystals by adding a poor solvent (solvent having low solubility) for the perovskite compound while applying a solution in which a metal halide and an alkylamine halide are dissolved or dispersed.

In addition, as a method of forming the perovskite layer, for example, a method of vapor depositing a metal halide in a gas filled with methylamine or the like can be used.

Among these, a method of depositing crystals by adding a poor solvent for a perovskite compound while applying a solution in which a metal halide and an alkylamine halide are dissolved or dispersed is preferably used.

The method of applying the solution is not particularly limited and can be appropriately selected according to the purpose, for example, an immersing method, a spin coating method, a spray method, a dip method, a roller method, an air knife method, and the like. The solution may be deposited in a supercritical fluid using, for example, carbon dioxide.

The perovskite layer may contain a photosensitizing compound. The sensitizing dye is not particularly limited as long as the compound is photoexcited by the excitation light to be used, and can be appropriately selected according to the purpose, for example, the photosensitizing compound mentioned above.

The method of forming the perovskite layer containing the sensitizing dye is not particularly limited, and can be appropriately selected according to the purpose. For example, a method of mixing the perovskite compound with the photosensitizing compound 5, a method of adsorbing the photosensitizing compound 5 after forming the perovskite layer, and the like can be used.

«Hole transporting Layer»

The hole transporting layer 6 is a layer having a function of a transporting hole. If the hole transporting layer 6 contains a hole transporting material, a pyridine compound represented by at least one of the following general formulas (6) and (7), and a lithium salt represented by the following general formula (8), known materials can be used for other materials.

Known materials include, for example, an electrolyte in which a redox couple is dissolved in an organic solvent, a gel electrolyte in which a polymer matrix is impregnated with a liquid in which a redox couple is dissolved in an organic solvent, a molten salt containing a redox couple, a solid electrolyte, an inorganic hole transporting material, an organic hole transporting material, and the like. Among these, a solid electrolyte is preferable, and an organic hole transporting material is more preferable.

Further, the lithium cation in the lithium salt represented by the following general formula (8) may be migrated to the electron transporting layer 4, and, for example, half or more than half of the lithium cation may be contained in the electron transporting layer 4.

The hole transporting layer 6 is formed on and inside the electron transporting layer 4. In the present embodiment, since the hole transporting layer 6 is filled in the electron transporting layer 4, the output of the photoelectric conversion element 101 can be further improved. In this case, the hole transporting layer 6 filled in the electron transporting layer 4 is also treated as a hole transporting layer.

The pyridine compound in the photoelectric conversion layer includes a pyridine compound represented by at least one of the following general formulas (6) and (7).

[Chemical Formula 22]

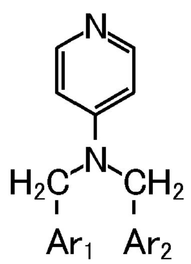

...General Formula (6)

[Chemical Formula 23]

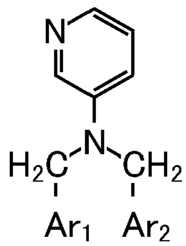

...General Formula (7)

In the general formulas (6) and (7), An and $Ar_2$ represent an aryl group which may have a substituent.

Specific examples of the aryl group include, for example, a phenyl group, a naphthyl group, a biphenyl group, and the like. Examples of the substituent include an alkyl group, an alkoxy group, and the like.

The following (H-1) to (H-8) are indicated as specific examples of the pyridine compound represented by the above general formula (6), but the pyridine compound in the present embodiment is not limited to these examples.

[Chemical Formula 24]

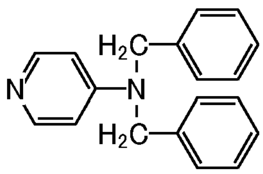

(H-1)

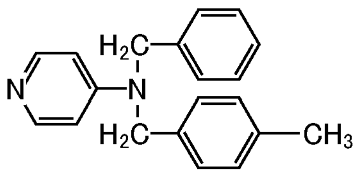

(H-2)

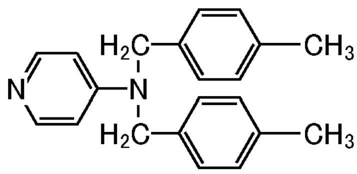

(H-3)

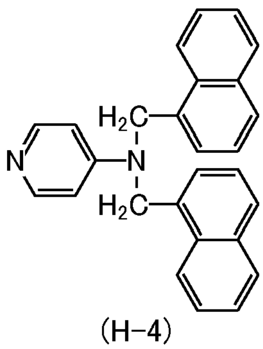

(H-4)

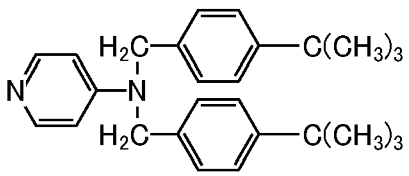

(H-5)

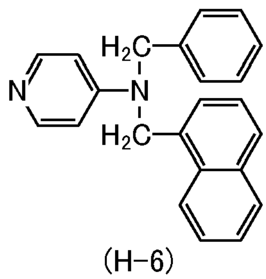

(H-6)

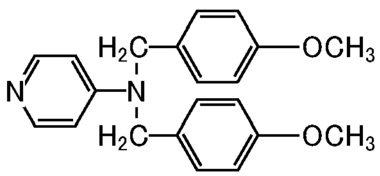

(H-7)

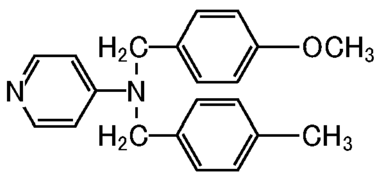

(H-8)

The content of the pyridine compound in the hole transporting layer 6 is preferably in a range from 20 mol% to 65 mol%, more preferably in a range from 35 mol% to 50 mol%, with respect to the hole transporting material. The content of the pyridine compound in the preferred range allows a high open-circuit voltage to be maintained, a high output to be obtained, and high stability and durability to be obtained even in a variety of environments (particularly low temperature environments) over a long period of time.

In the present embodiment, the hole transporting layer 6 in the photoelectric conversion layer contains a lithium salt represented by the following general formula (8).

[Chemical Formula 25]

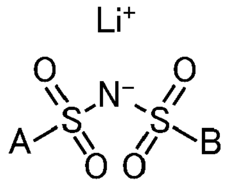

...General Formula (8)

In the formula (8), A and B represent any one of F, $CF_3$, $C_2F_5$, $C_3F_7$, and $C_4F_9$, and the substituents of A and B are different from each other.

These lithium salts include, for example, lithium (fluorosulfonyl) (trifluoromethanesulfonyl) imide (Li-FTFSI), lithium (fluorosulfonyl) (pentafluoroethanesulfonyl) imide (Li-FPFSI), lithium (fluorosulfonyl) (nonafluorobutanesulfonyl) imide (Li-FNFSI), lithium (nonafluorobutanesulfonyl) (trifluoromethanesulfonyl) imide (Li-NFTFSI), lithium (pentafluoroethanesulfonyl) (trifluoromethanesulfonyl) imide (Li-PFTFSI), and the like. Among these, lithium (fluorosulfonyl) (trifluoromethanesulfonyl) imide (Li-FTFSI) is particularly preferred.

The structural formula of the lithium salt is as follows.

[Chemical Formula 26]

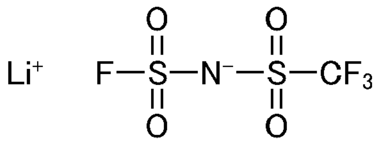

(Li-FTFSI)

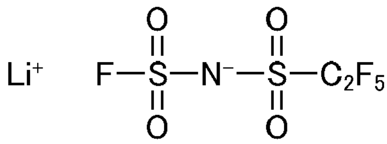

(Li-FPFSI)

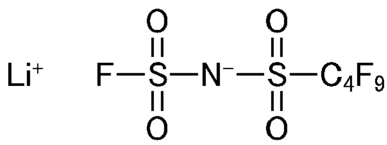

(Li-FNFSI)

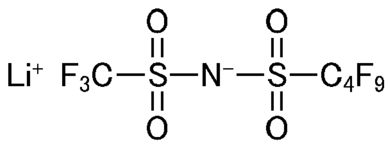

(Li-NFTFSI)

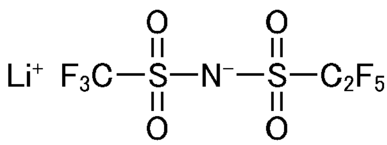

(Li-PFTFSI)

Here, for example, when the coating solution for forming a hole transporting layer containing a lithium salt is used, the lithium salt need not be contained in the form of a salt in which anions and cations are bonded in the formed film, and may be separated into lithium cations and anions.

Specifically, the inventors have found that, for example, when the hole transporting layer 6 is formed while the lithium salt is contained in the coating solution for forming the hole transporting layer, the lithium cations migrate to the electron transporting layer 4 and is contained more in the electron transporting layer 4 than in the hole transporting layer

6. On the other hand, the inventors of the present invention have found that anions are contained more in the hole transporting layer 6 than in the electron transporting layer 4, although the anions partially migrate to the electron transporting layer 4, for example.

In the present embodiment, the cations and anions of the lithium salt are preferably separated to form different distribution states. Since the lithium salt is separated into cations and anions and contained in the photoelectric conversion layer. As a result, even in low-temperature environments, the effect of high output to low illuminance light and excellent sustained output can be further improved.

The hole transporting layer 6 in the photoelectric conversion layer may contain a lithium salt having another structure in addition to the lithium salt represented by the above general formula (8).

These lithium salts may have symmetrical anion species other than the above-mentioned lithium salts.

Examples of the lithium salt having symmetrical anion species include lithium bis (fluorosulfonyl) imide (Li-FSI), lithium bis (trifluoromethanesulfonyl) imide (Li-TFSI), lithium bis (pentafluoroethanesulfonyl) imide (Li-BETI), lithium bis (nonafluorobutanesulfonyl) imide, and the like. Cyclic imides such as lithium (cyclohexafluoropropane) (disulfone) imide are also used.

However, since these lithium salts have symmetrical anions, their compatibility is low, making it difficult to increase the amount added. Therefore, if the lithium salts are added, the amount of lithium salts is preferably small.

The content of the lithium salt represented by the above general formula (8) is preferably in a range from 5 mol% to 50 mol%, more preferably in a range from 20 mol% to 35 mol%, with respect to the hole transporting material. When the content is within the above range, the output to the low illuminance light is high, the sustained output is improved, and compatibility with high durability is achieved.

In particular, in the photoelectric conversion layer, where the molar amount of the pyridine compound is a and the molar amount of the lithium salt is b, the molar ratio a/b of the pyridine compound to the lithium salt is preferably less than 2.0, more preferably 1.8 or less, and particularly preferably 1.7 or less.

If the molar ratio a/b is less than 2.0, it is possible to maintain a high output for a longer period of time when low illuminance light is irradiated in a low temperature environment, and the durability of the photoelectric conversion element can be further improved.

The hole transporting layer 6 contains, for example, a hole transporting material or a p-type semiconductor material in order to obtain a function of transporting hole. As the hole transporting material or the p-type semiconductor material, a known organic hole transporting compound can be used.

Specific examples include an oxadiazole compound, a triphenylmethane compound, a pyrazoline compound, a hydrazone compound, an oxadiazole compound, a tetraarylbenzidine compound, a stilbene compound, a spiro-type compound, and the like.

Among these, the spiro-type compound is more preferable.

As the spiro-type compound, a compound containing the following general formula (9) is preferable.

[Chemical Formula 27]

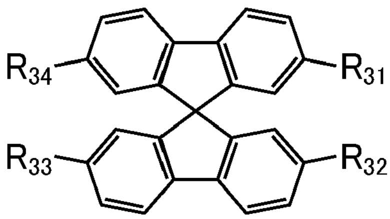

...General Formula (9)

In the general formula (4), $R_{31}$ to $R_{34}$ each independently represent a substituted amino group such as a dimethylamino group, a diphenylamino group, a naphthyl-4-tolylamino group, or the like.

Examples of the spiro-type compound include, but are not limited to, the following exemplified compounds (D-1) to (D-20).

[Chemical Formula 28]

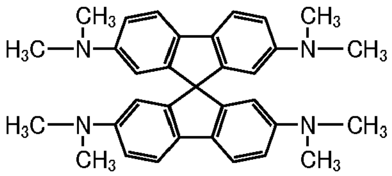

(D-1)

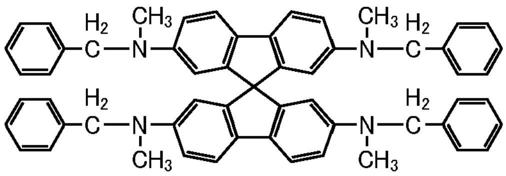

(D-2)

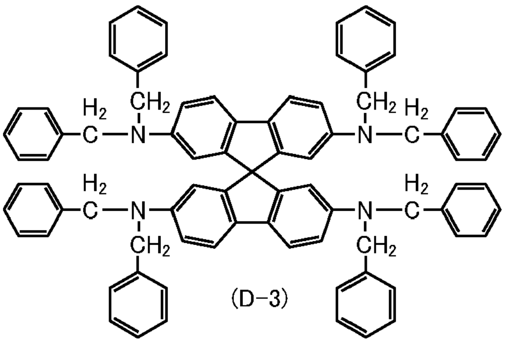

(D-3)

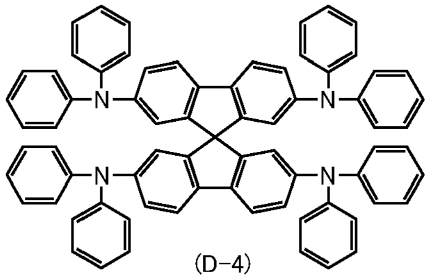

(D-4)

[Chemical Formula 29]

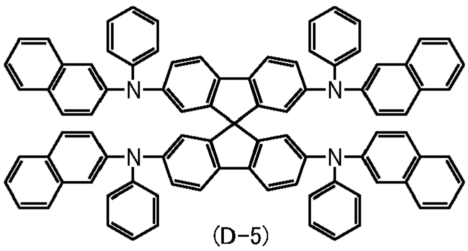

(D-5)

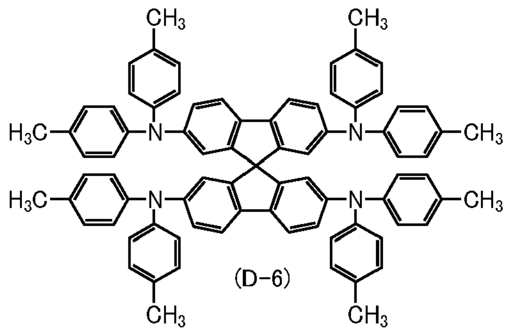

(D-6)

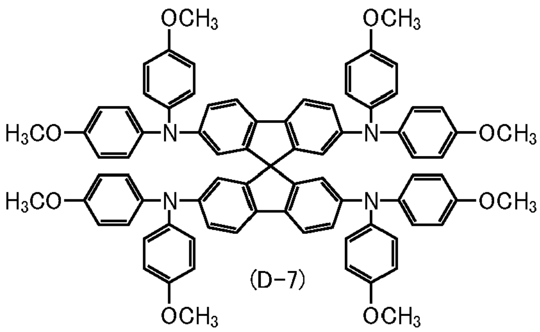

(D-7)

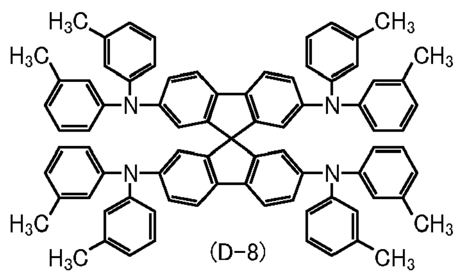

(D-8)

[Chemical Formula 30]

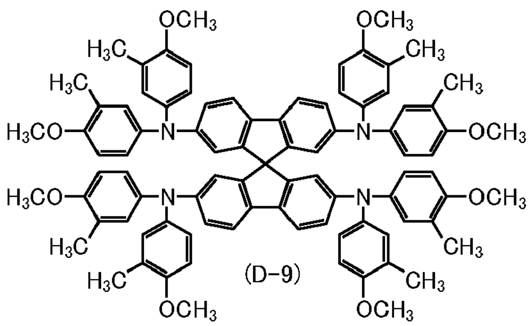

(D-9)

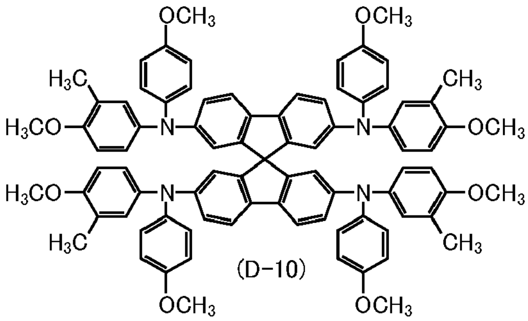

(D-10)

[Chemical Formula 31]

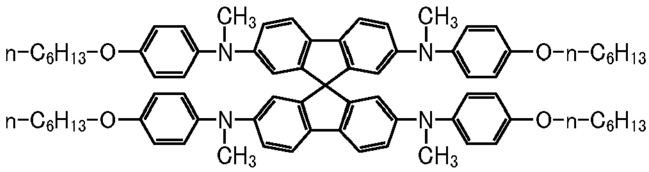

(D-11)

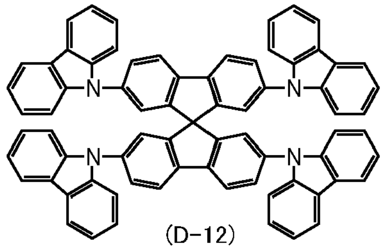

(D-12)

[Chemical Formula 32]

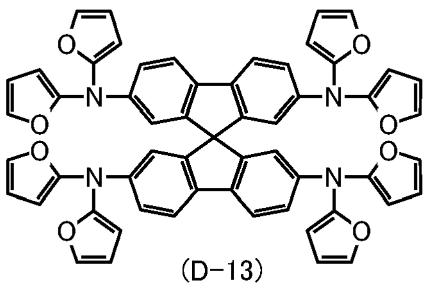

(D-13)

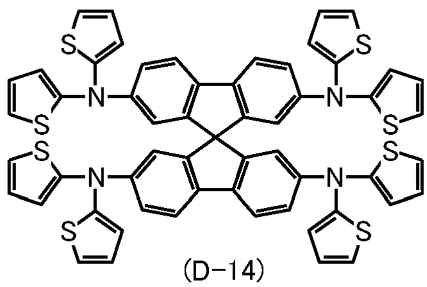

(D-14)

[Chemical Formula 33]

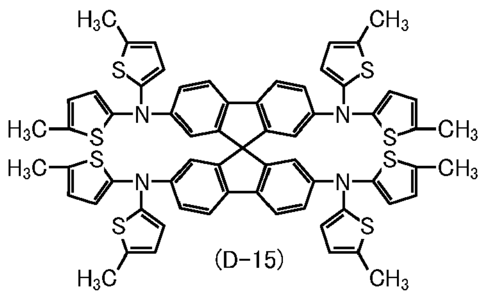
(D-15)

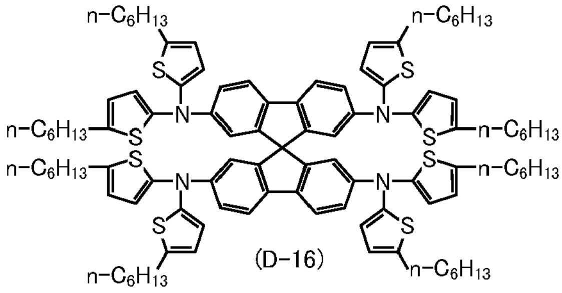
(D-16)

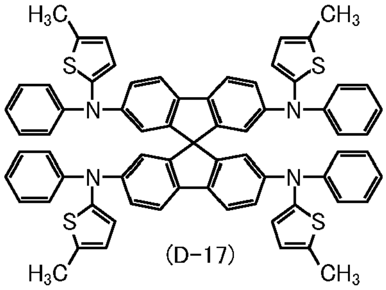
(D-17)

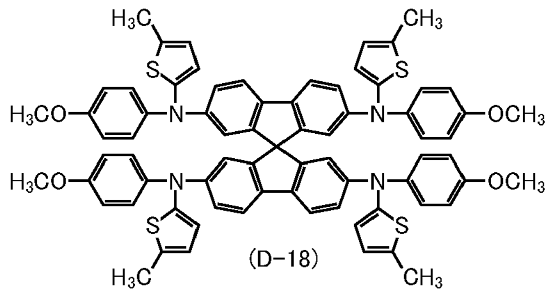
(D-18)

[Chemical Formula 34]

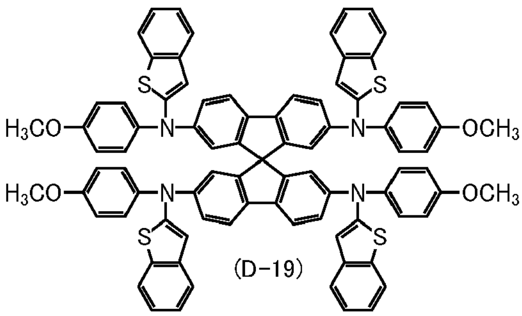
(D-19)

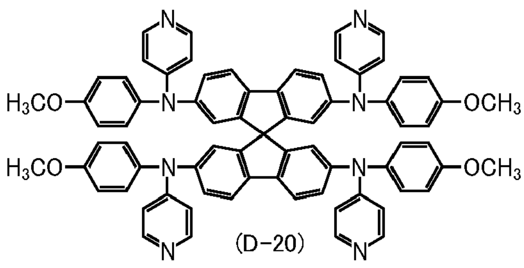
(D-20)

Further, as the spiro-type compound as the hole transporting material, a compound represented by the following general formula (10) can be more suitably used.

[Chemical Formula 35]

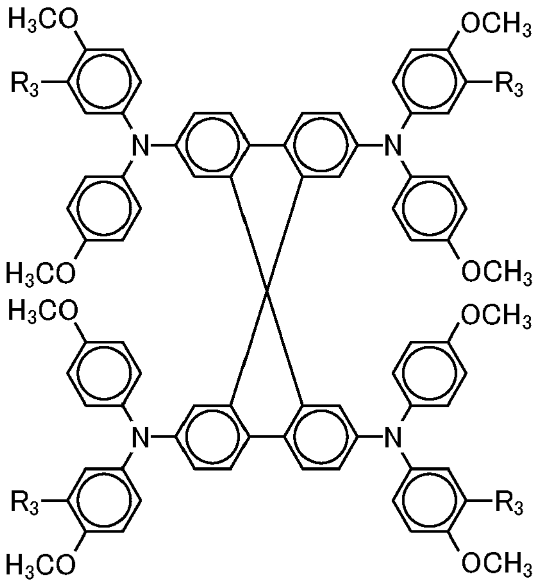

...General Formula (10)

In the general formula (10), $R_3$ represents a hydrogen atom or an alkyl group.

For example, among the above (D-1) to (D-20), those represented by the general formula (10) are (D-7) and (D-10).

These spiro-type compounds have high hole mobility and two benzidine skeleton molecules are spirally bound. Therefore, a nearly spherical electron cloud is formed and hopping conductivity between molecules is excellent. Therefore, the spiro-type compounds exhibit excellent photoelectric conversion properties.

Moreover, these spiro-type compounds are dissolved in various organic solvents because of high solubility. Since the spiro-type compounds are amorphous (amorphous substances that do not have a crystal structure), the spiro-type compounds tend to be densely filled in a porous electron transporting layer 4. Furthermore, the spiro-type compounds do not absorb light of 450 nm or longer, light absorption of the photosensitizing compound 5 can be effectively performed, which is particularly preferable for a solid dye-sensitized solar cell.

In addition to the hole transporting material and lithium salt, it is preferable to add an oxidizing agent to the hole transporting layer 6. The oxidizing agent improves the hole transporting properties and enhances the output characteristics and its durability or stability.

Examples of the oxidizing agent include tris(4-bromophenyl)aminium hexachloroantimonate, silver hexafluoroantimonate, nitrosonium tetrafluoroborate, silver nitrate, metal complexes, hypervalent iodine compounds, and the like. Among these, metal complexes and hypervalent iodine compounds are suitably used.

When the oxidizing agent is a metal complex or a hypervalent iodine compound, a large amount of the oxidizing agent can be added because of high solubility in an organic solvent, and as a result, hole transporting property is improved, and excellent sustained effect can be obtained.

Examples of the metal complex include a complex including, for example, a metal cation, a ligand, and an anion.

Examples of the metal cation include cations of, for example, chromium, manganese, iron, cobalt, nickel, copper, molybdenum, ruthenium, rhodium, palladium, silver, tungsten, rhenium, osmium, iridium, gold, platinum, and the like. Among them, cations of cobalt, iron, nickel, and copper are preferable, and a cation of cobalt complex is more preferable.

The ligand preferably includes a 5-membered heterocycle and/or a 6-membered heterocycle including at least one nitrogen, and may include a substituent. Specific examples the ligand include the following (E-1) to (E-33), but are not limited to these examples.

[Chemical Formula 36]

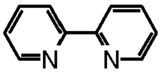
(E-1)

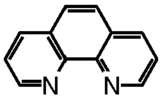
(E-2)

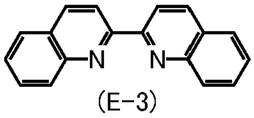
(E-3)

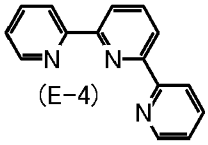
(E-4)

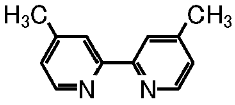
(E-5)

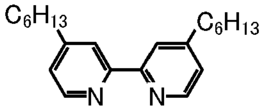
(E-6)

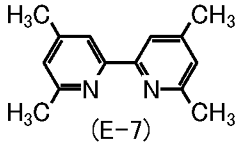
(E-7)

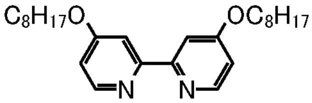
(E-8)

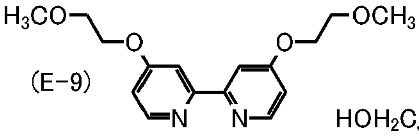
(E-9)

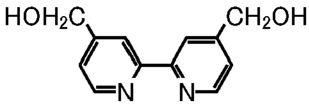
(E-10)

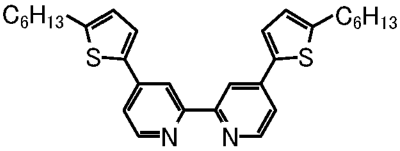
(E-11)

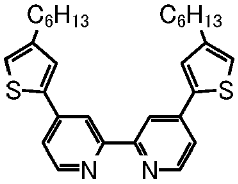
(E-12)

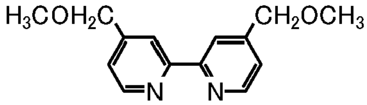
(E-13)

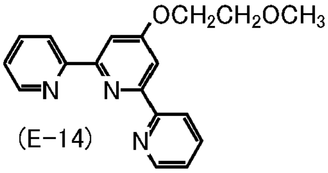
(E-14)

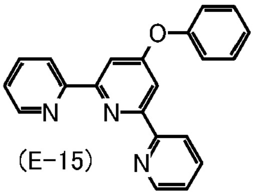
(E-15)

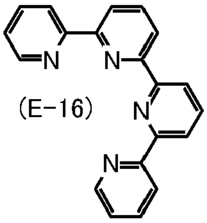
(E-16)

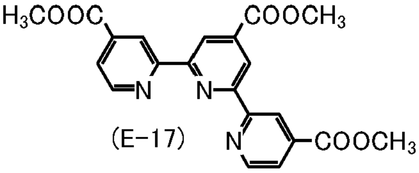
(E-17)

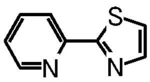
(E-18)

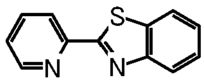
(E-19)

[Chemical Formula 37]

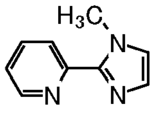
(E-20)

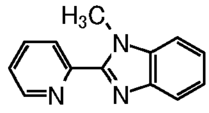
(E-21)

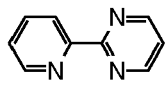
(E-22)

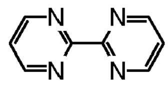
(E-23)

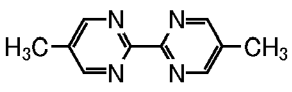
(E-24)

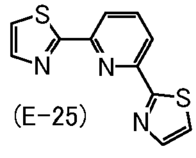
(E-25)

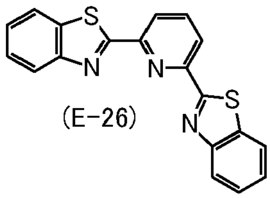
(E-26)

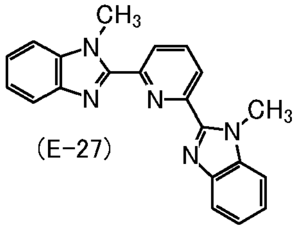
(E-27)

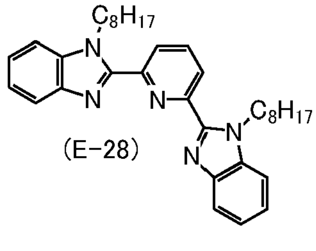
(E-28)

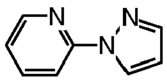
(E-29)

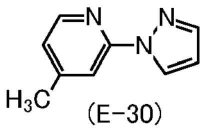
(E-30)

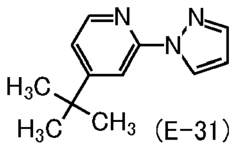
(E-31)

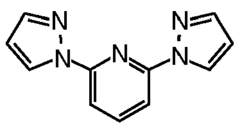
(E-32)

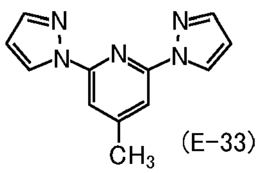
(E-33)

Examples of the anion include a hydride ion (H-), a fluoride ion (F-), a chloride ion ($Cl^-$), a bromide ion ($Br^-$), an iodide ion (I-), a hydroxide ion ($OH^-$), a cyanide ion ($CN^-$), a nitric acid ion ($NO_3^-$), a nitrous acid ion ($NO_2^-$), a hypochlorous acid ion ($ClO^-$), a chlorous acid ion ($ClO_2^-$), a chloric acid ion ($ClO_3^-$), a perchloric acid ion ($ClO_4^-$), a permanganic acid ion ($MnO_4^-$), an acetic acid ion ($CH_3COO^-$), a hydrogen carbonate ion ($HCO_3^-$), a dihydrogen phosphate ion ($H_2PO_4^-$), a hydrogen sulfate ion ($HSO_4^-$), a hydrogen sulfide ion ($HS^-$), a thiocyanic acid ion ($SCN^-$), a tetrafluoroboric acid ion ($BF_4^-$), a hexafluorophosphate ion ($PF_6^-$), a tetracyanoborate ion ($B(CN)_4^-$), a dicyanoamine ion ($N(CN)_2^-$), a p-toluenesulfonic acid ion ($TsO^-$), a trifluoromethyl sulfonate ion ($CF_3SO_2^-$), a bis(trifluoromethylsulfonyl)amine ion ($N(SO_2CF_3)_2^-$), a tetrahydroxoaluminate ion ($[Al(OH)_4]^-$ or $[Al(OH)_4(H_2O)_2]^-$), a dicyanoargentate(I) ion ($[Ag(CN)_2]^-$), a tetrahydroxochromate(III) ion ($[Cr(OH)_4]^-$), a tetrachloroaurate(III) ion ($[AuCl_4]^-$), an oxide ion ($O^{2-}$), a sulfide ion ($S^{2-}$), a peroxide ion ($O_2^{2-}$), a sulfuric acid ion ($SO_4^{2-}$), a sulfurous acid ion ($SO_3^{2-}$), a thiosulfuric acid ($S_2O_3^{2-}$), a carbonic acid ion ($CO_3^{2-}$), a chromic acid ion ($CrO_4^{2-}$), a dichromic acid ion ($Cr_2O_7^{2-}$), a monohydrogen phosphate ion ($HPO_4^{2-}$), a tetrahydroxozincate(II) ion ($[Zn(OH)_4]^{2-}$), a tetracyanozincate(II) ion ($[Zn(CN)_4]^{2-}$), a tetrachlorocuprate(II) ion ($[CuCl_4]^{2-}$), a phosphoric acid ion ($PO_4^{3-}$), a hexacyanoferrate(III) ion ($[Fe(CN)_6]^{3-}$), a bis(thiosulfate)argentate(I) ion ($[Ag(S_2O_3)_2]^{3-}$), a hexacyanoferrate(II) ion ($[Fe(CN)_6]^{4-}$), and the like.

These may be used alone or in combination of two or more of them. Among them, a tetrafluoroboric acid ion, a hexafluorophosphate ion, a tetracyanoborate ion, a bis(trifluoromethylsulfonyl)amine ion, and a perchloric acid ion are preferable.

Among these metal complexes, trivalent cobalt complexes are more preferably added to the hole transporting layer. When the trivalent cobalt complex as the oxidizing agent is added to the hole transporting layer, it is possible to oxidize the hole transporting material, resulting in stabilizing the hole transporting material to enhance the hole transporting property.

In the present embodiment, for example, it is preferable to use trivalent cobalt complexes added to the coating solution for forming the hole transporting layer. The hole transporting layer 6 of the photoelectric conversion element 101 obtained using the coating solution for forming the hole transporting layer should contain a divalent cobalt complex.

This is because the trivalent cobalt complex is mixed with the hole transporting material to oxidize the hole

transporting material and make the cobalt complex divalent. In other words, in the present embodiment, the photoelectric conversion layer preferably further includes a divalent cobalt complex.

Further, it is more desirable that almost no trivalent cobalt complexes remain in the hole transporting layer 6 of the photoelectric conversion element 101, and almost all cobalt complexes are divalent. This not only improves and stabilizes the hole transporting property and increases the output power and its durability, but also enables the effect to be further demonstrated in low-temperature environments.

The valence of the cobalt complex contained in the hole transporting layer 6 can be clarified, for example, by performing XAFS analysis. XAFS analysis stands for X-ray Absorption Fine Structure and is referred to as X-ray absorption fine structure analysis. For example, an XAFS spectrum can be obtained by irradiating a sample with X-rays and measuring the amount of absorption.

In the XAFS spectrum, the near-edge structure is referred to as X-ray Absorption Near Edge Structure (XANES), and the broad-range X-ray absorption fine structure appearing at about 100 eV or more higher energy side from the edge is referred to as Extended X-ray Absorption Fine Structure (EXAFS). Information on the valence number and structure of the target atom can be obtained mainly from the former XANES.

In this case, for example, the valence number of the cobalt complex contained in the hole transporting layer 6 can be clarified by separately measuring the XAFS spectra of the divalent and trivalent cobalt complex powders and comparing them with the XAFS spectra of the cobalt complex contained in the hole transporting layer 6.

The trivalent cobalt complex to be added to the coating solution for forming the hole transporting layer is preferably a cobalt complex represented by structural formulas (4) and (5).

[Chemical Formula 38]

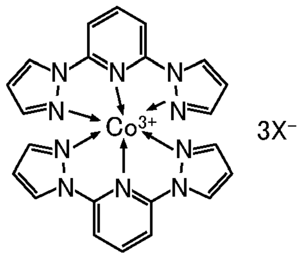

...Structural Formula (4)

[Chemical Formula 39]

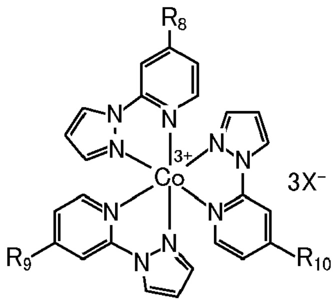

...Structural Formula (5)

In the structural formulas (4) and (5), $R_8$ to $R_{10}$ represent a hydrogen atom, a methyl group, an ethyl group, a tertiary butyl group, or a trifluoromethyl group. X represents one of the following structural formulas (6) to (9).

[Chemical Formula 40]

$BF_4$ ...Structural Formula (6)

$PF_6$ ...Structural Formula (7)

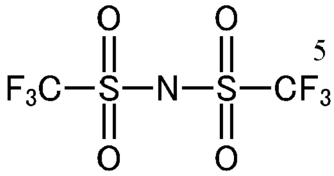

...Structural Formula (8)

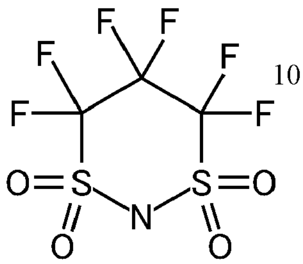

...Structural Formula (9)

As for X, among structural formulas (6) to (9), the structural formula (8) is more preferable. By using the structural formula (8), the hole transporting material can be stably maintained in an oxidized state.

Specific examples of these cobalt complexes include the following (F-1) to (F-24). However, this is not limited to these examples.

[Chemical Formula 41]

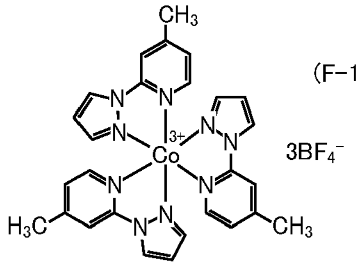
(F-1)

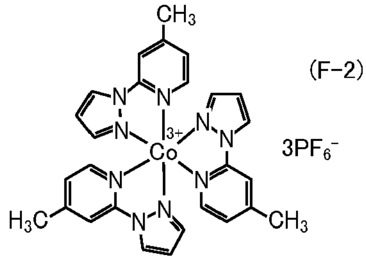
(F-2)

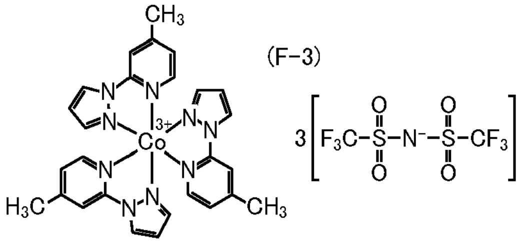
(F-3)

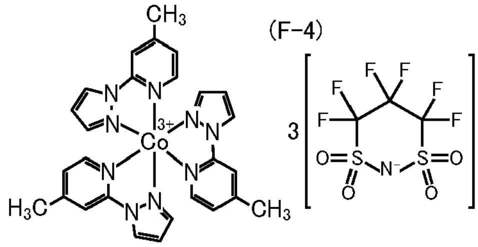
(F-4)

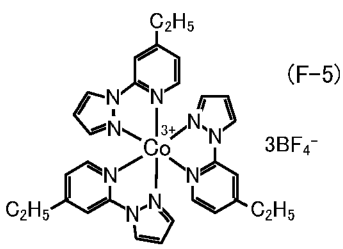
(F-5)

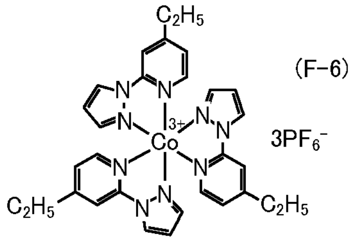
(F-6)

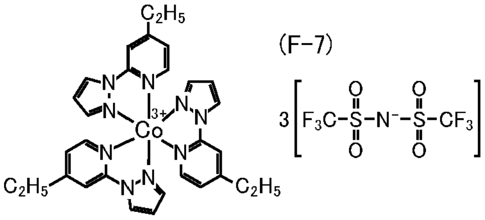
(F-7)

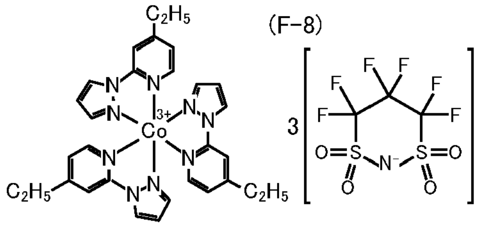
(F-8)

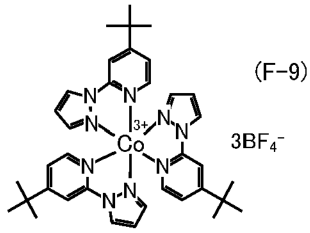
(F-9)

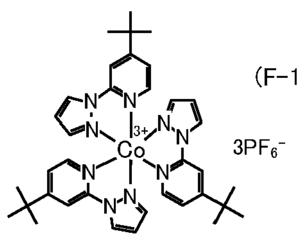
(F-10)

[Chemical Formula 42]

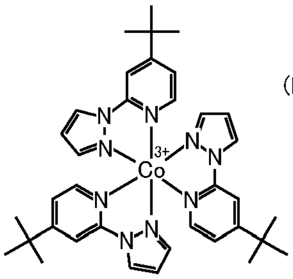

(F-11)

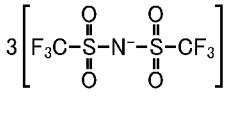

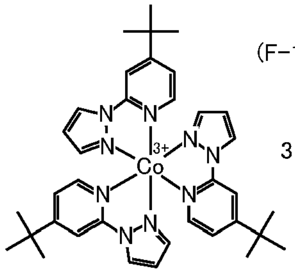

(F-12)

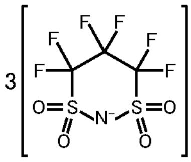

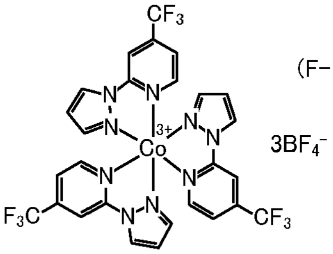

(F-13)

$3BF_4^-$

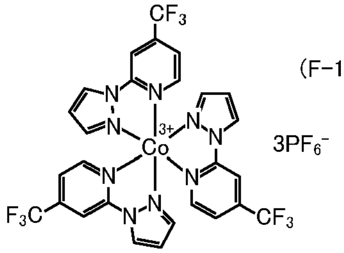

(F-14)

$3PF_6^-$

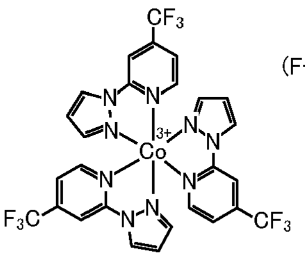

(F-15)

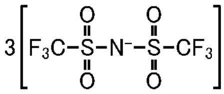

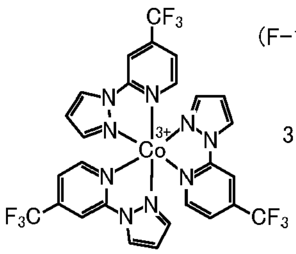

(F-16)

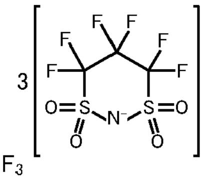

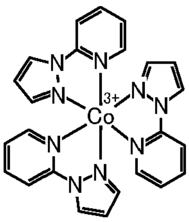

(F-17)

$3BF_4^-$

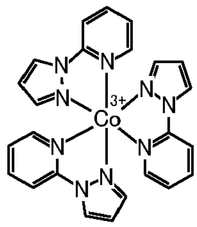

(F-18)

$3PF_6^-$

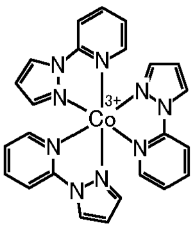

(F-19)

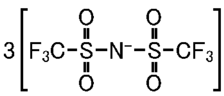

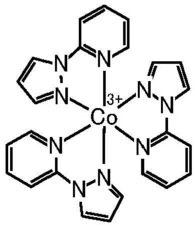

(F-20)

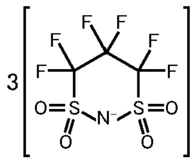

[Chemical Formula 43]

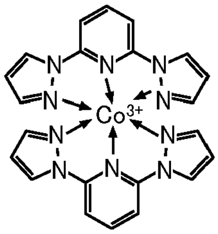 $3BX_4^-$

(F-21)

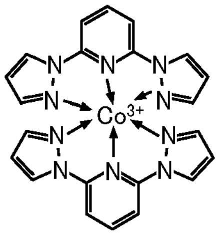 $3PX_6^-$

(F-22)

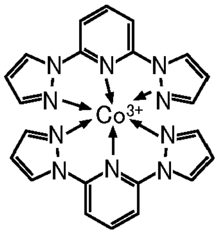 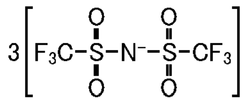

(F-23)

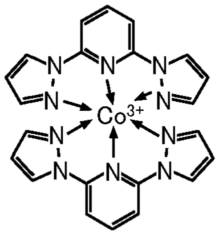 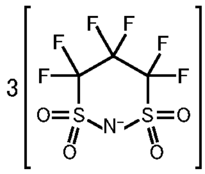

(F-24)

The content of the oxidizing agent is preferably in a range from 1 mol% to 30 mol%, more preferably in a range from 5 mol% to 20 mol%, with respect to the hole transporting material. One or more oxidizing agents may be used alone or in combination of two or more of them. When two or more kinds are used together, the hole transporting layer 6 becomes difficult to crystallize, and high heat resistance may be obtained.

The hole transporting layer 6 may be a single layer structure composed of a single material or a laminated structure containing a plurality of compounds. When the hole transporting layer 6 has a laminated structure, a polymer material is preferably used for the hole transporting layer 6 close to the second electrode 7. The use of a polymeric material having excellent film-forming properties is advantageous in that the surface of the porous electron transporting layer 4 can be smoothed and the photoelectric conversion characteristics can be improved.

Further, since it is difficult for the polymeric material to penetrate into the porous electron transporting layer 4, the surface of the porous electron transporting layer 4 is excellent in coverage, and the effect of preventing short circuit when the electrode is provided may be obtained.

As the polymeric material used for the hole transporting layer 6, a known hole transporting polymeric material can be used.

Examples of the hole transporting polymer material include a polythiophene compound, a polyphenylene vinylene compound, a polyfluorene compound, a polyphenylene compound, a polyarylamine compound, a polythiadiazole compound, and the like.

Examples of polythiophene compounds include poly(3-n-hexylthiophene), poly (3-n-octyloxythiophene), poly(9,9'-dioctyl-fluorene-co-bithiophene), poly (3,3'''-didodecyl-quarterthiophene), poly(3,6-dioctylthieno [3,2-b] thiophene), poly(2,5-bis (3-decylthiophene-2-yl)thieno [3,2-b] thiophene), poly (3,4-didecylthiophene-co-thieno [3,2-b] thiophene), poly(3,6-dioctylthieno [3,2-b] thiophene-co-thieno [3,2-b] thiophene), poly(3,6-dioctylthieno [3,2-b] thiophene-co-thiophene), poly (3,6-dioctylthieno [3,2-b] thiophene-co-bithiophene), and the like.

Examples of the polyphenylenevinylene compound include poly[2-methoxy-5-(2-ethylhexyloxy)-1, 4-phenylenevinylene], poly[2-methoxy-5-(3,7-dimethyloctyloxy)-1,4-phenylenevinylene], poly[(2-methoxy-5-(2-ethylfexyloxy)-1,4-phenylenevinylene)-co-(4,4'-biphenylene-vinylene)], and the like.

Examples of polyfluorene compounds include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], poly[(9,9-dioctyl-2,7-diyl)-co-(1,4-(2,5-dihexyloxy) benzene)], and the like.

Examples of the polyphenylene compound include poly[2,5-dioctyloxy-1,4-phenylene], poly[2,5-di (2-ethylhexyloxy-1,4-phenylene], and the like.

Examples of the polyarylamine compound include poly[(9,9-dioctylfluorenyl-2,7-diyl)-alt-co-(N,N'-diphenyl)-N,N'-di(p-hexylphenyl)-1,4-diaminobenzene], poly[(9,9-dioctylfluorenyl-2,7-diyl)-alt-co-(N,N'-bis(4-octyloxyphenyl) benzidine-N,N'-(1,4-diphenylene)], poly[(N,N'-bis(4-octyloxyphenyl) benzidine-N,N'-(1,4-diphenylene)], poly[(N,N'-bis(4-(2-ethylhexyloxy)phenyl) benzidine-N,N'-(1,4-diphenylene)], poly[phenylimino-1,4-phenylenevinylene-2,5-dioctyloxy-1,4-phenylenevinylene-1,4-phenylene], poly[p-tolylimino-1,4-phenylenevinylene-2,5-di(2-ethylhexyloxy)-1,4-phenylenevinylene-1,4-phenylene], poly[4-(2-ethylhexyloxy) phenylimino-1,4-biphenylene], and the like.

Examples of the polythiadiazole compound include poly[(9,9-dioctylfluorenyl-2,7-diyl)-alt-co-(1, 4-benzo(2,1',3) thiadiazole], poly(3,4-didecylthiophene-co-(1,4-benzo (2,1',3)thiadiazole), and the like.

Among these, polythiophene compounds and polyarylamine compounds are preferable from the viewpoint of

carrier mobility and ionization potential.

The average thickness of the hole transporting layer 6 is not particularly limited and can be appropriately selected according to the purpose, but the hole transporting layer 6 preferably has a structure penetrating into the pores of the porous electron transporting layer 4. As the average thickness of the hole transporting layer 6, the average thickness of the hole transporting layer 6 on the electron transporting layer 4 is preferably in a range from 0.01 μm to 20 μm, more preferably in a range from 0.1 μm to 10 μm, and particularly preferably in a range from 0.2 μm to 2 μm.

The hole transporting layer 6 can be formed directly on the electron transporting layer 4 on which the photosensitizing compound 5 is adsorbed. The method of fabricating the hole transporting layer 6 is not particularly limited and can be appropriately selected according to the purpose, but may include a method of forming a thin film in a vacuum such as vacuum evaporation, a wet film forming method, and the like. Among these, the wet film forming method is preferable in terms of manufacturing cost, and a method of coating on the electron transporting layer 4 is preferable.

When the wet film forming method is used, the coating method is not particularly limited and can be performed according to a known method. As the coating method, for example, a dip method, a spray method, a wire bar method, a spin coating method, a slit die coating method, a roller coating method, a blade coating method, and a gravure coating method can be used. As the wet printing method, various methods such a relief printing method, an offset method, a gravure method, an intaglio printing method, a rubber plate method, a screen-printing method, and the like can be used.

The film may also be formed in a supercritical fluid or in a subcritical fluid at a temperature and pressure below the critical point. Supercritical fluid is a fluid that exists as a non-cohesive dense fluid in the temperature and pressure region above the limit where gas and liquid can coexist (critical point), does not coalesce when compressed, and is above the critical temperature and above the critical pressure, with no particular limitations as long as the fluid is selected according to purpose.

Examples of the supercritical fluid include carbon monoxide, carbon dioxide, ammonia, nitrogen, water, alcohol solvents, hydrocarbon solvents, halogen solvents, ether solvents, and the like.

Examples of the alcohol solvent include methanol, ethanol, n-butanol, and the like.

Examples of the hydrocarbon solvent include ethane, propane, 2,3-dimethylbutane, benzene, toluene, and the like. Examples of the halogen solvent include methylene chloride, chlorotrifluoromethane, and the like.

Examples of the ether solvent include dimethyl ether and the like.

These may be used alone or two or more of these may be used in combination.

Among them, carbon dioxide having a critical pressure of 7.3 MPa and a critical temperature of 31°C is particularly preferable because this makes creation of a supercritical state easy, has incombustibility, and is easily handled.

The subcritical fluid is not particularly limited and may be appropriately selected according to the intended purpose so long as it exists as high-pressure liquid in a temperature and pressure region near the critical point. The aforementioned compounds exemplified as the supercritical fluid can be suitably used as the subcritical fluid.

The critical temperature and the critical pressure of the supercritical fluid are not particularly limited and can be appropriately selected according to the purpose, but the critical temperature is preferably in a range from -273°C to 300°C, and more preferably in a range from 0°C to 200°C.

In addition to the supercritical fluid and the subcritical fluid, an organic solvent or an entrainer can also be used in combination. The addition of an organic solvent and an entrainer makes it easier to adjust the solubility in the supercritical fluid.

The organic solvent is not particularly limited and can be appropriately selected according to the purpose, for example, a ketone solvent, an ester solvent, an ether solvent, an amide solvent, a halogenated hydrocarbon solvent, a hydrocarbon solvent, and the like.

Examples of the ketone solvent include acetone, methyl ethyl ketone, methyl isobutyl ketone, and the like.

Examples of the ester solvent include ethyl formate, ethyl acetate, n-butyl acetate, and the like.

Examples of the ether solvent include diisopropyl ether, dimethoxyethane, tetrahydrofuran, dioxolane, dioxane, and the like.

Examples of the amide solvent include N,N-dimethylformamide, N,N-dimethylacetamide, N-methyl-2 pyrrolidone, and the like.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, 1-chloronaphthalene, and the like.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, cumene, and the like.

These may be used alone or two or more of these may be used in combination.

Further, a press treatment may be performed after the hole transporting material is laminated on the electron transporting layer 4 in which the photosensitizing compound 5 is adsorbed. It is believed that the press treatment allows the hole transporting material to further adhere to the electron transporting layer 4 that is a porous electrode, resulting

in improvement of efficiency.

The press treatment is not particularly limited and may be appropriately selected according to the intended purpose. Examples of the press treatment include: a press molding method using a plate such as an IR tablet molding device; a roll press method using a roller; and the like.

The pressure is preferably 10 $kgf/cm^2$ or more, and more preferably 30 $kgf/cm^2$ or more.

The time of the press treatment is not particularly limited and may be appropriately selected according to the intended purpose. The time thereof is preferably 1 hour or shorter. Moreover, heat may be applied at the time of the press treatment. At the time of the press treatment, a release agent may be disposed between a pressing machine and electrodes.

Examples the release agent include fluororesins such as polyethylene tetrafluoride, polychloroethylene trifluoride, ethylene tetrafluoride-propylene hexafluoride copolymers, perfluoroalkoxy fluoride resins, polyvinylidene fluoride, ethylene-ethylene tetrafluoride copolymers, ethylene-chloroethylene trifluoride copolymers, polyvinyl fluoride, and the like. These may be used alone or in combination of two or more of them.

A metal oxide (not illustrated) may be provided between the hole transporting layer 6 and the second electrode 7 after the press treatment step and before the second electrode 7 is provided.

Examples of the metal oxide include molybdenum oxide, tungsten oxide, vanadium oxide, nickel oxide, and the like. These may be used alone or two or more of these may be used in combination. Among these, molybdenum oxide is preferable.

The method of providing the metal oxide on the hole transporting layer 6 is not particularly limited, and can be appropriately selected according to the purpose. The method includes a method of forming a thin film in a vacuum such as sputtering or vacuum deposition, a wet film forming method, and the like. The preferred wet film forming method is to prepare a paste of metal oxide powder or sol dispersion and coat the paste on the hole transporting layer 6.

The coating method using the wet film forming method is not particularly limited and can be performed according to a known method. Examples of the coating method include a dip method, a spray method, a wire bar method, a spin coating method, a roller coating method, a blade coating method, and a gravure coating method. Further, examples of the wet printing method include various methods such a relief printing method, an offset method, a gravure method, an intaglio printing method, a rubber plate method, a screen-printing method, and the like.

The average thickness of the coated metal oxide is preferably in a range from 0.1 nm to 50 nm, and more preferably in a range from 1 nm to 10 nm.

«Second Electrode»

The second electrode 7 is formed on the hole transporting layer 6. When a metal oxide is formed between the hole transporting layer 6 and the second electrode 7, the second electrode 7 can be formed on the metal oxide in the hole transporting layer 6. Further, the second electrode 7 can be the same as the first electrode 2, and the second substrate 9 is not necessarily required when sufficient strength is maintained.

The second electrode is preferably translucent. Translucent means that the light transmittance of the second electrode is 50% or more. The light transmittance can be measured by a common UV-visible spectrophotometer.

Examples of the material of the second electrode 7 include a metal, a carbon compound, a conductive metal oxide, a conductive polymer, and the like.

Examples of the metal include platinum, gold, silver, copper, aluminum, and the like.

The morphology of the metal used for the second electrode is not particularly limited and may be, for example, nanowires or the like. Silver nanowires are preferably used as nanowires in terms of conductivity.

When silver nanowires are used for the second electrode, it is even more preferable that the second electrode is further mixed with at least one of polythiophene, polyaniline, polypyrrole, or a conductive polymer of these derivatives. As a result, the flexibility of the photoelectric conversion element can be imparted and the adhesion with the hole transport layer can be enhanced.

- Silver Nanowires -

Silver nanowires are wire-like metal structures with a cross-sectional diameter of less than 1 $\mu$m and an aspect ratio (axis length in the longitudinal direction/diameter) of at least 10.

The diameter of the silver nanowires is preferably 5 nm to 250 nm, and more preferably 10 nm to 150 nm. When the diameter of the silver nanowires is within this range, the second electrode has excellent transparency as a coating film.

The axis length in the longitudinal direction of the silver nanowire is preferably 0.5 to 500 $\mu$m, and more preferably 2.5 to 100 $\mu$m. Within this range, the silver nanowires are excellent in dispersibility, and also in conductivity and transparency when used as transparent conductive films.

Silver nanowires can be used without any particular limitations and obtained by known manufacturing methods. In the present invention, silver nanowires obtained from a manufacturing method involving a process of reacting a silver compound in a polyol at 25 to 180°C using an N-substituted acrylamide-containing polymer as a wire growth regulator are preferred.

- Conductive Polymer -

The conducting polymer is not particularly limited and can be selected as appropriate according to the purpose. Examples of the conductive polymers include polythiophene or its derivatives, polyaniline or its derivatives, polypyrrole or its derivatives, polyacetylene or its derivatives, polycarbazole or its derivatives, polyvinylpyridine or its derivatives, poly (n-vinylcarbazole) or its derivatives, polyfluorene or its derivatives, polyphenylene or its derivatives, poly (p-phenylenevinylene) or its derivatives, poly (pyridinvinylene) or its derivatives, polyquinoxaline or its derivatives, polyquinoline or its derivatives, polyoxadiazole derivatives, polyvasophenanthroline derivatives, polytriazole derivatives, or those polymers substituted with substituents such as amine groups, hydroxy groups, nitrile groups, or carbonyl groups as appropriate. These may be used alone or in combination of two or more. Among these, polythiophene or its derivatives, polyaniline or its derivatives, polypyrrole or its derivatives are preferred because of their high conductivity.

A second electrode (hereinafter referred to as silver nanowire layer) using silver nanowires is formed by applying a silver nanowire dispersion on the hole transport layer.

The silver nanowire dispersion contains silver nanowires, a dispersion medium, and other components.

Examples of the dispersion medium include water and alcohols. Examples of alcohols include methanol, ethanol, 1-propanol, 2-propanol, 1-butanol, 2-butanol, 2-methylpropanol, 1,1-dimethylethanol, and cyclohexanol. These may be used alone or in combination of two or more.

Examples of other components may include a variety of additives as needed, such as surfactants, polymerizable compounds, antioxidants, antisulfides, corrosion inhibitors, viscosity modifiers, preservatives, and the like.

The silver nanowire layer can be formed by a known coating method using the above silver nanowire dispersion. Examples of coating methods include spin coating, slit coating, dip coating, blade coating, bar coating, spraying, letterpress printing, intaglio printing, screen printing, plate printing, dispensing, inkjet printing, and the like.

For the silver nanowire layer, the average transmittance at 400 to 800 nm is preferably 90% or less in terms of electrical resistance. In addition, in order to obtain high power generation when light is irradiated from the second electrode side, the average transmittance at 400 to 800 nm is preferably 50% or more. Furthermore, from the point of view of light durability, the average transmittance at 400 to 800 nm is more preferably in a range from 60% to 80%.

Examples of the carbon compound include graphite, fullerene, carbon nanotubes, graphene, and the like.

Examples of the conductive metal oxide include ITO, FTO, ATO, and the like.

Examples of the conductive polymer include polythiophene, polyaniline, and the like.

These may be used alone or two or more of these may be used in combination.

The second electrode 7 can be appropriately formed on the hole transporting layer 6 by methods such as the coating method, the lamination method, the deposition method, the CVD method, and the pasting method, depending on kinds of materials to be used and kinds of the hole transporting layer 6.

The form of the second electrode 7 is not particularly limited, but is preferably film-shaped, and more preferably formed of a metal film.

Note that the second electrode 7 has a path conducting to an electrode extraction terminal 12.

In the photoelectric conversion element 101, it is preferably that at least one of the first electrode 2 and the second electrode 7 is substantially transparent. When a side of the first electrode 2 is transparent and incident light is allowed to pass from the side of the first electrode 2, a material that reflects light is preferably used at the side of the second electrode 7, and glass, plastic, or a metal thin film on which a metal or conductive oxide is deposited is preferably used. In addition, an anti-reflection layer can be provided at a side where the incident light is to be received.

«Second Substrate»

The second substrate 9 is formed above the second electrode 7. Specifically, the second substrate 9 is formed on a sealing member 8 to be described later, which is disposed between the second electrode 7 and the second substrate 9, and the second substrate 9 is fixed to the sealing member 8. The second substrate 9 is not particularly limited, and any known substrate can be used, for example, glass, plastic film, ceramic or the like. The joint between the second substrate 9 and the sealing member 8 may be formed with uneven portions in order to enhance adhesion.

The method of forming the unevenness portions is not particularly limited, and can be appropriately selected according to the purpose. Examples of the methods include a sand blasting method, a water blasting method, a polishing paper, a chemical etching method, a laser beam machining method, and the like.

As a process of enhancing the adhesion between the second substrate 9 and the sealing member 8, for example,

the organic substance on the surface may be removed, and the hydrophilicity of the surface may be improved. The process of removing the organic substance on the surface of the second substrate 9 is not particularly limited, and can be appropriately selected according to the purpose, for example, UV ozone cleaning, oxygen plasma treatment, and the like.

«Sealing Member»

The sealing member 8 is adhered to the first electrode 2 while fixing the second substrate 9, and surrounds at least the photoelectric conversion layer (electron transporting layer 4 and hole transporting layer 6). The sealing member 8 may shield the photoelectric conversion layer from the external environment of the photoelectric conversion element 101. The sealing member 8 is an example of an adhesive layer constituting the photoelectric conversion element.
The sealing member 8 is not particularly limited, and a known member can be used as long as the sealing member 8 can reduce the intrusion of excessive moisture or oxygen into the interior (hereinafter referred to as the sealed interior) of the sealing member 8 from the external environment. Further, the sealing member 8 has an effect of preventing mechanical breakage due to being pressed from the outside, and a known member can be used as long as it can be realized.
The sealing method can be roughly classified into "frame sealing" in which a sealing member is provided on the peripheral portion of the power generation area configured of the photoelectric conversion layer of the photoelectric conversion element 101 and adhered to the second substrate 9, and "surface sealing" in which a sealing member is provided on the entire surface of the power generation area and adhered to the second substrate 9.
In the aforementioned "frame sealing", a hollow part 10 can be formed inside the sealing, the amount of water and the amount of oxygen inside the sealing can be appropriately adjusted. The "frame sealing" has the effect of reducing the influence of electrode peeling because the second electrode 7 is not in contact with the sealing member 8.
On the other hand, "surface sealing" is excellent in preventing excessive water and oxygen from entering from the outside. Further, the "surface sealing" has a large adhesive area with the sealing member, so that the sealing strength is high, and is particularly suitable when a flexible substrate is used for the first substrate 1.
In the present embodiment, the sealing member 8 is adhered to the first electrode 2, but the adhesive layer (sealing member) 8 may be adhered to the first substrate 1 instead of the first electrode 2 in order to enhance the sealing property.
The type of sealing member is not particularly limited and can be appropriately selected according to the purpose. Examples of sealing member include cured resin, a low melting point glass resin, a pressure-sensitive adhesive, and the like. As the pressure-sensitive adhesive, as long as the adhesive adheres by pressure, the pressure-sensitive adhesive is not particularly limited and can be appropriately selected according to the purpose.
The pressure-sensitive adhesive preferably contains at least one kind selected from the group consisting of an olefin-based resin, a rubber-based resin, a silicon-based resin, an acrylic-based resin, and an epoxy-based resin. In other words, one of these resins may be used alone or two or more resins may be used together as the pressure-sensitive adhesive.
When a cured resin is used as the pressure-sensitive adhesive, there is no particular limitation as long as the resin is cured by light or heat, and it can be appropriately selected according to the purpose. Among these, an acrylic resin or an epoxy resin is preferably used as the cured resin.
The cured product of the acrylic resin can be any known material as long as the cured product is a monomer or oligomer having an acrylic group in the molecule.
Any known material can be used as the cured material of epoxy resin, as long as the monomer or oligomer having epoxy groups in the molecule is cured.
Examples of the epoxy resin include a water dispersion type, a solventless type, a solid type, a heat curing type, a curing agent mixing type, an ultraviolet curing type, and the like. Among these, a thermosetting type and an ultraviolet curing type are preferable, and an ultraviolet curing type is more preferable. It should be noted that even in the ultraviolet curing type, heating can be performed, and it is preferable to perform heating even after the ultraviolet curing.
Examples of the epoxy resin include bisphenol A type, bisphenol F type, novolac type, cyclic aliphatic type, long chain aliphatic type, glycidylamine type, glycidyl ether type, glycidyl ester type, and the like. These may be used alone or two or more of these may be used in combination.
The pressure-sensitive adhesive is preferably mixed with a water-absorbing desiccant if necessary. The desiccant, also referred to as a moisture absorbent, is a material having a function of physically or chemically adsorbing and absorbing moisture, and by including the desiccant in the sealing member, the moisture resistance can be further enhanced and the influence of outgas can be reduced.
The desiccant can be suitably selected according to the purpose. Examples of the desiccant include inorganic water-absorbing materials such as calcium oxide, barium oxide, magnesium oxide, magnesium sulfate, sodium sulfate, calcium chloride, activated carbon, silica gel, molecular sieves, zeolites (excluding molecular sieves); and organometallic

compounds; and the like. Among these, zeolite having a large amount of moisture absorption is preferable. These may be used alone or two or more of these may be used in combination.

The pressure-sensitive adhesive may be mixed with other additives as necessary. Examples of the additives include fillers, gap agents, polymerization initiators, curing accelerators, coupling agents, flexibilizers, colorants, flame retardant auxiliaries, antioxidants, organic solvents, and the like. Among them, fillers, gap agents, and curing accelerators are preferable, and fillers and polymerization initiators are more preferable.

The filler is effective in preventing entry of moisture or oxygen under an external environment. In addition, the filler can obtain effects such as a decrease in volumetric shrinkage at the time of curing, a decrease in an amount of gas generated at the time of curing or heating, improvement of mechanical strength, and control of thermal conductivity or fluidity, and is considerably effective in maintaining a stable output under various environments in the present disclosure.

Regarding the output characteristics or the durability of the photoelectric conversion element, not only an influence caused by moisture or oxygen entering the photoelectric conversion element from an external environment but also an influence caused by gas generated at the time of heating and curing the sealing member cannot be ignored. Particularly, an influence caused by the gas generated at the time of heating greatly affects the output characteristics even when the photoelectric conversion element is used under a high temperature environment.

In this case, when the filler and the gap agent are included in the sealing member, they can prevent entry of moisture or oxygen, and can decrease an amount of the sealing member used, which makes it possible to obtain an effect of decreasing generation of gas. This is effective not only at the time of curing but also when the photoelectric conversion element is used under a high temperature environment.

The filler is not particularly limited and known products may be used. Preferable examples thereof include inorganic fillers such as crystalline or amorphous silica, talc, alumina, aluminum nitride, silicon nitride, calcium silicate, and calcium carbonate. These may be used alone or in combination of two or more of them.

An average primary particle diameter of the filler is preferably in a range from 0.1 μm to 10 μm, more preferably in a range from 1 μm to 5 μm. When the average primary particle diameter of the filler is in the preferable range, an effect of preventing entry of moisture or oxygen can be sufficiently achieved, an appropriate viscosity is obtained, and adhesiveness to a substrate or a defoaming property is improved. Alternatively, it is also effective in terms of control of a width of the sealing part or workability.

An amount of the filler is preferably in a range from 10 parts by mass to 90 parts by mass, more preferably in a range from 20 parts by mass to 70 parts by mass, relative to 100 parts by mass of the total amount of the sealing member. When the amount of the filler is in the aforementioned range, an effect of preventing entry of moisture or oxygen can be sufficiently obtained, an appropriate viscosity is obtained, and adhesiveness and workability are good.

The gap agent is called a gap controlling agent or a spacer agent, and can control gap of the sealing part. For example, when a sealing member is provided on the first substrate 1 or the first electrode 2 and, the second substrate 9 is provided thereon for sealing, gap of the sealing part matches with a size of the gap agent because the gap agent is mixed in an epoxy resin. As a result, it is possible to easily control the gap of the sealing part.

As the gap agent, known materials in the art can be used so long as it has a particulate shape and a uniform particle diameter, and has high solvent resistance and heat resistance. The particulate shape is not particularly limited, but is preferably spherical. Specific examples thereof include glass beads, silica particles, and organic resin particles. These may be used alone or in combination of two or more of them.

A particle diameter of the gap agent can be selected depending on gap of the sealing part to be set. The particle diameter thereof is preferably in a range from 1 μm to 100 μm, and more preferably in a range from 5 μm to 50 μm.

The polymerization initiator is, for example, a material added for the purpose of initiating polymerization by using heat or light.

The thermal polymerization initiator is a compound that generates active species such as radical, cations, or the like through heating. Specific examples thereof include azo compounds such as 2,2'-azobisbutyronitrile (AIBN) and peroxides such as benzoyl peroxide (BPO) and the like. Examples of the thermal cationic polymerization initiator include benzenesulfonic acid esters, alkyl sulfonium salts, and the like.

Meanwhile, as the photopolymerization initiator, a photocationic polymerization initiator is preferably used in the case of the epoxy resin. When the photocationic polymerization initiator is mixed with the epoxy resin, followed by irradiation of light, the photocationic polymerization initiator is decomposed to generate strong acid, and the acid induces polymerization of the epoxy resin. Then, curing reaction proceeds. The photocationic polymerization initiator has such effects that volumetric shrinkage during curing is low, oxygen inhibition does not occur, and storage stability is high.

Examples of the photocationic polymerization initiator include aromatic diazonium salts, aromatic iodonium salts, aromatic sulfonium salts, metallocene compounds, silanol-aluminum complexes, and the like.

Moreover, a photoacid generator having a function of generating an acid upon irradiation of light can also be used. The photoacid generator functions as an acid for initiating cationic polymerization. Examples of the photoacid generator include onium salts such as ionic sulfonium salt-based onium salts and ionic iodonium salt-based onium salts

including a cation part and an ionic part. These may be used alone or in combination of two or more of them.

An amount of the polymerization initiator to be added may vary depending on the material to be used, but the amount is preferably in a range from 0.5 parts by mass to 10 parts by mass and more preferably in a range from 1 part by mass to 5 parts by mass with respect to 100 parts by mass of the sealing member as a whole. When the additive amount is within the above range, the curing is properly performed, the remaining uncured material can be reduced, and the outgas can be prevented from being excessive.

The curing accelerator is also called a curing catalyst and is used for the purpose of accelerating a curing speed. The curing accelerator is mainly used for a thermosetting epoxy resin.

Examples of the curing accelerator include: tertiary amine or tertiary amine salts such as DBU (1,8-diazabicyclo(5,4,0)-undecene-7) and DBN (1,5-diazabicyclo(4,3,0)-nonene-5); imidazole-based compounds such as 1-cyanoethyl-2-ethyl-4-methylimidazole, 2-ethyl-4-methylimidazole, and the like; and phosphine or phosphonium salts such as triphenylphosphine, tetraphenylphosphonium-tetraphenyl borate, and the like. These may be used alone or in combination of two or more of them.

The coupling agent has an effect of enhancing a bonding force between molecules, and examples thereof include silane coupling agents. Specific examples thereof include: silane coupling agents such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, 3-methacryloxypropyltrimethoxysilane, and the like. These may be used alone or in combination of two or more of them.

Further, as the sealing member, a rubber-based resin composition commercially available as sealing materials, seal materials, or adhesives (agglutinant) have been known, and can be suitably used in the present embodiment. Among them, there are resin compositions that are developed and are commercially available to be used in solar cells or organic EL elements, and can be particularly effectively used in the present embodiment. Examples of the rubber-based resin composition include Tesa 61539, Tesa 61530 (manufactured by Tesa), S-2191 (manufactured by MORESCO), and the like.

Meanwhile, the glass resin having low melting point is adhered to the glass substrate by a firing process at about 550°C after the resin is applied to the glass substrate. Then, while the resin component is melted through, for example, infrared laser, the resultant is allowed to adhere to the glass substrate to thereby perform the sealing. At this time, the glass component having a low melting temperature is diffused inside the metal oxide layer and is physically joined, to thereby obtain high sealing performance. In addition, since the resin component vanishes, outgas as seen in acrylic resin or epoxy resin is not generated, which does not degrade the photoelectric conversion element.

In the present embodiment, a sheet-like sealing material may be used as the sealing member. The sheet-like sealing material is, for example, a rubber-based resin layer formed in advance on a sheet. The sheet is a glass or a film having a high gas barrier property. Such a sheet corresponds to the second substrate 9 of the present embodiment.

The sheet-like sealing material is adhered onto the second substrate 9 and then cured, whereby the sealing member and the second substrate 9 can be formed at once. The structure in which the hollow part 10 is provided can also be formed by the formation pattern of the rubber-based resin layer formed on the sheet.

Such a sheet-like sealing material is an example of an adhesive layer (sealing member) in which a part of the adhesive layer is formed of a second substrate in the present embodiment. The sheet constituting the sheet-like sealing material is an example of a second substrate constituting a part of the adhesive layer in the present embodiment.

If the rubber-based resin layer to be formed on the sheet is formed on the entire surface, it becomes "surface sealing", but if the resin layer is patterned in such a manner that the hollow part 10, which will be described later, is provided inside the photoelectric conversion element 101 (inside the sealing) by the pattern of forming the resin layer, it becomes "frame sealing".

The method of forming the sealing member is not particularly limited and can be performed according to a known method. As the method of forming the sealing member, various methods such as a dispensing method, a wire bar method, a spin coating method, a roller coating method, a blade coating method, a gravure coating method, a relief printing method, an offset method, a gravure method, an intaglio printing method, a rubber plate method, a screen-printing method, and the like can be used.

In the present embodiment, a passivation layer 11 may be provided between the sealing member 8 and the second electrode 7. The passivation layer 11 is disposed between the second electrode 7 and the second substrate 9, and constitutes an electrode protective layer so that the sealing member 8 does not come into contact with the second electrode 7.

The passivation layer 11 is not particularly limited as long as the sealing member is disposed so as not to contact the second electrode 7, and can be appropriately selected according to the purpose, but aluminum oxide, silicon nitride, silicon oxide, fluorine resin, or the like is preferably used.

In particular, the fluororesin has a good compatibility with the metal part and can be formed on the second

electrode 7. Further, since the adhesive layer in the surface sealing does not adhere to the passivation layer portion, for example, the passivation layer is formed on the entire surface of the passivation layer once, and then the passivation layer is appropriately processed so that the passivation layer portion can be freely designed for sealing.

Further, a fluorine-based compound is known as the sealing member, and the sealing member can be suitably used in the present embodiment. Among them, fluorine-based compounds that are developed and are commercially available to be used in solar cells or organic EL elements can be used.

Examples of the fluorine-based compound include DS-5935F130 (manufactured by DURASURF Co., Ltd.), DP-509C (manufactured by Harves Co., Ltd.), alumina (manufactured by Aldrich Co., Ltd.), and the like. Among these, DS-5935F130 which is a fluorine compound having a silane structure is preferable.

Inclusion of oxygen in the hollow part 10 inside the sealed part makes it possible to stably maintain a function of transporting holes of the hole transporting layer 6 for a long period of time, which is considerably effective in improving the durability of the photoelectric conversion element. In the present embodiment, the hollow part 10 inside the sealed part provided by sealing preferably contains oxygen, and the oxygen concentration is more preferably in a range from 10.0 vol% to 21.0 vol%.

The oxygen concentration of the hollow part 10 can be controlled by performing the sealing in a glove box in which the oxygen concentration has been adjusted. The oxygen concentration can be adjusted by a method using a gas cylinder having a specific oxygen concentration or by a method using a nitrogen gas generator. The oxygen concentration in a glove box is measured using a commercially available oxygen concentration meter or oxygen monitor.

The oxygen concentration in the hollow part 10 formed by the sealing member 8 can be measured by, for example, Internal Vapor Analysis (IVA).

Specifically, the photoelectric conversion element is loaded in a high vacuum, and a hole is bored to perform mass spectrometry on gas and moisture generated. By this method, it is possible to clarify the oxygen concentration contained inside the sealing of the photoelectric conversion element. There are two types of mass spectrometers, quadrupole type and time-of-flight type, and the latter is more sensitive.

As the gas other than oxygen contained inside the sealing part, an inert gas is preferable, and nitrogen or argon is preferable.

When the sealing is performed, the oxygen concentration and the dew point in a glove box are preferably controlled, and such a control is effective in improving the output and the durability. The dew point is defined as a temperature at which condensation starts when water vapor-containing gas is cooled.

The dew point is not particularly limited but is preferably 0°C or lower, more preferably -20°C or lower. The lower limit thereof is preferably -50°C or higher.

The photoelectric conversion element 101 has a hollow part 10 between the second electrode 7 and the second substrate 9. In the present embodiment, the hollow part 10 is provided between the sealing member 8 and the second electrode 7, wherein the sealing member is provided between the second electrode 7 and the second substrate 9. The photoelectric conversion element 101 having the hollow part 10 makes it possible to control the amount of water and the concentration of oxygen in the hollow part 10, thereby enhancing power generation performance and durability.

Further, since the second electrode 7 and the second substrate 9 (and the sealing member 8) are not in contact with each other, the second electrode 7 can be prevented from peeling off or breaking. The oxygen concentration in the hollow part 10 is not particularly limited and can be freely controlled, but is preferably in a range from 10% to 21%.

The entire surface of the photoelectric conversion element 101 of the present embodiment is sealed by the sealing member 8 surrounding the hollow part 10. Specifically, the photoelectric conversion element 101 can be formed by applying sealing material 8 to the entire surface of the second electrode 7 and installing a second substrate 9 on top of the sealing member 8, or by using the aforementioned sheet-type sealing material.

In this case, a passivation layer can be provided between the second electrode 7 and the sealing member, which may be effective in preventing the second electrode 7 from peeling off. Thus, the mechanical strength of the photoelectric conversion element can be enhanced by surrounding almost the entire surface with the sealing member.

FIG. 2 is a plan view of the photoelectric conversion element of FIG. 1, and FIG. 3 is a cross-sectional view taken along line A-A of FIG. 2. In FIGS. 2 and 3, members other than the first substrate 1, the first electrode 2, the sealing member (adhesive layer) 8, and the second substrate 9 are not illustrated. In the present embodiment, as illustrated in FIGS. 1 to 3, a clearance CL surrounding an outer edge 8A of the sealing member (adhesive layer) 8 is formed between the outer edge 8A of the sealing member (adhesive layer) 8 and an outer edge 1A of the first substrate 1 in a plan view.

In the present embodiment, as illustrated in FIGS. 1 to 3, the outer edge 1A of the first substrate 1 and an outer edge of the first electrode 2 formed on the first substrate 1 are flush with each other in the thickness direction, and the outer edge 8A of the sealing member (adhesive layer) 8 and an outer edge of the second substrate 9 formed on the sealing member (adhesive layer) 8 are flush with each other. That is, in the present embodiment, a clearance CL surrounding the outer edge 8A of the sealing member (adhesive layer) 8 is formed between the outer edge of the first electrode 2 and the outer edge of the second substrate 9 in a plan view.

As illustrated in FIGS. 4 and 5, the inventors have found that, in a conventional photoelectric conversion element

102 as illustrated in FIGS. 4 and 5, sealing member (adhesive layer) protrudes from the end of the photoelectric conversion element 102 because the sealing member 8 and the first substrate 1 are the same size in a plan view, and have found that productivity, initial output performance, and durability are not sufficient.

The photoelectric conversion element 101 of the present embodiment is based on the above knowledge of the inventors, and is a photoelectric conversion element that forms the clearance CL surrounding the outer edge 8A of the sealing member (adhesive layer) 8 between the outer edge 8A of the sealing member (adhesive layer) 8 and the outer edge 1A of the first substrate 1 in a plan view. In such a photoelectric conversion element 101, the sealing member (adhesive layer) 8 is prevented from protruding from the end portion of the photoelectric conversion element 101.

Thus, the photoelectric conversion element 101 of the present embodiment is unlikely to touch the sealing member (adhesive layer) 8 even when the user touches the device, thereby improving productivity and initial output. In addition, by making it more unlikely to touch the sealing member (adhesive layer) 8, the durability of the device can be improved because the sealing member (adhesive layer) 8 is less likely to be torn.

In the present embodiment, the interval (hereinafter referred to as clearance interval or inward width) between the outer edge 8A of the adhesive layer 8 of the clearance CL and the outer edge 1A of the first substrate 1 is preferably 0.01 mm or more, more preferably 0.05 mm or more, and further more preferably 0.08 mm or more.

The interval between the outer edge 8A of the adhesive layer 8 of the clearance CL and the outer edge 1A of the first substrate 1 is 1.0 mm or less, more preferably 0.8 mm or less, and further more preferably 0.5 mm or less.

In the present embodiment, the sealing member (adhesive layer) 8, which partially constitutes the second substrate 9, is smaller in a plan view than the first substrate 1.

In the sealing member 8, by using a sheet-like sealing material as described above, the sealing member can freely be cut at a processing precision of 0.1 mm by laser cut. Since laser cutting can be performed even after sealing with the second substrate 9, the sealed second substrate 9 and sealing member (adhesive layer) 8 can be laser cut at least 0.1 mm smaller than the first substrate 1.

In the present embodiment, by setting the interval between the outer edge 8A of the adhesive layer 8 of the clearance CL and the outer edge 1A of the first substrate 1 to 0.01 mm or more, the sealing member (adhesive layer) 8 is surely suppressed from protruding from the end portion of the photoelectric conversion element 101. Therefore, according to the present embodiment, productivity, initial output performance, and durability can be further improved.

It should be noted that the larger the clearance CL interval, the more unlikely it is for the user to touch the sealing member (adhesive layer) 8 and the more durability can be improved, so that the upper limit of the clearance CL interval is not limited. On the other hand, if the clearance CL interval becomes too large, the effective power generating area becomes small and the output of the device may be lowered. Therefore, the upper limit of the clearance CL interval is preferably 5 mm or less.

In the photoelectric conversion element 101 of the present embodiment, the thickness (hereinafter, it may be referred to as the thickness of the sealing member or the sealing line width) of the sealing member (adhesive layer) 8 in the circumferential direction is preferably 0.2 mm or more, more preferably 0.5 mm or more, and more preferably 0.9 mm or more. Here, the circumferential thickness of the sealing member (adhesive layer) 8 indicates the thickness of the sealing member (adhesive layer) 8 in a direction in which the sealing member (adhesive layer) 8 surrounds the lateral surfaces of the photoelectric conversion layers (electron transporting layer 4 and hole transporting layer 6).

In the present embodiment, when the thickness of the sealing member (adhesive layer) 8 in the circumferential direction is set to 0.2 mm or more, the sealing width of the sealing member (adhesive layer) can be widened, and deterioration of the photoelectric conversion element in a high-temperature, high-humidity environment can be suppressed. Therefore, the output of the device can be improved, and the durability of the high photoelectric conversion element can be improved.

In addition, the thicker the sealing member 8 is (the wider the sealing width is), the more deterioration of the photoelectric conversion element can be suppressed in a high-temperature and high-humidity environment, and the upper limit of the thickness of the sealing member 8 is not limited. On the other hand, when the thickness of the sealing member 8 is too thick (when the sealing width is too wide), the effective power generating area becomes small and the output of the device may be disadvantageously lowered, and thus the upper limit of the thickness of the sealing member 8 is preferably 5 mm or less.

Therefore, in this embodiment, as described above, the circumferential thickness of the sealing member (adhesive layer) 8 is in a range from 0.1 mm to 1.5 mm, the sealing width of the sealing member (adhesive layer) can be widened so that the effective power generation area is not reduced. Thus, the output can be improved while suppressing the deterioration of the photoelectric conversion element.

The total of the interval between the outer edge 8A of the adhesive layer 8 of the clearance CL and the outer edge 1A of the first substrate 1 and the thickness of the sealing member (adhesive layer) 8 in the circumferential direction (hereinafter referred to as the sum of the clearance interval and the thickness of the sealing member) is not particularly limited, but is preferably in a range from 0.3 mm to 10 mm, more preferably in a range from 0.4 mm to 5 mm, and further more preferably in a range from 1.0 mm to 3 mm.

By making the sum of the clearance interval and the thickness of the sealing member within the above range, the output of the device can be further improved while further suppressing the deterioration of the photoelectric conversion element.

In the photoelectric conversion element 101 of the present embodiment, as described above, the second substrate 9 is formed of a part of the sealing member (adhesive layer) 8, and the edge portion 9A of the second substrate 9 is curved. Here, the edge portion 9A of the second substrate 9 indicates a corner portion between the top surface and the side surface of the second substrate 9. Curved surface machining indicates round chamfering.

In the present embodiment, the edge portion 9A of the second substrate 9 configured by a part of the sealing member (adhesive layer) 8 is curved to facilitate peeling of the part (second substrate 9) other than the sealing member (adhesive layer) 8, thereby improving the productivity yield.

In the photoelectric conversion element 101 of the present embodiment, since the adhesive layer 8 is formed of the pressure-sensitive adhesive as described above, high sealing performance can be achieved even if the sealing width is narrow in a high temperature and high humidity environment.

Further, by using a pressure-sensitive adhesive for the adhesive layer 8, durability can be secured with a short sealing width. Also, high output can be obtained even after storage under a high-temperature and high-humidity environment. Further, the adhesive layer 8 using the pressure-sensitive adhesive (agglutinant) loosens the resin by heat at the time of bonding, and then applies pressure at the time of bonding, so that the pressure-sensitive adhesive layer 8 can follow the unevenness of the second substrate 9 and secure the sealing performance.

In the photoelectric conversion element 101 of the present embodiment, as described above, since the adhesive layer 8 contains a moisture absorbent, the moisture resistance of the adhesive layer 8 is improved, and the influence of outgas can be reduced. From this viewpoint as well, the present embodiment can exhibit high sealing performance under a high temperature and high humidity environment.

In the photoelectric conversion element 101 of the present embodiment, since the electrode protective layer (passivation layer) 11 is provided between the second electrode 7 and the second substrate 9 as described above, the sealing member 8 functions as a protection layer of the second electrode 7, and peeling of the electrode can be suppressed when the adhesive layer 8 and the second electrode 7 come into contact with each other. Thus, in the present embodiment, output reduction of the device can be further suppressed.

In the photoelectric conversion element 101 of the present embodiment, since the electrode protective layer (passivation layer) 11 contains a fluorine compound having a silane structure as described above, the fluorine compound having a silane structure is compatible with the metal portion, and therefore, the electrode protective layer 11 can be easily formed on the second electrode 7. By applying a fluorine compound having a silane structure as the passivation layer 11, the film can be more easily peeled off.

In the photoelectric conversion element 101 of the present embodiment, as described above, the photoelectric conversion layer includes an electron transporting layer 4 having a photosensitizing compound 5 and a hole transporting layer 6. Thereby, the light irradiated is absorbed by the photosensitizing compound 5, and the generated electrons and hole are respectively transported to the first electrode 2 or the second electrode 7 by the electron transporting layer 4 and the hole transporting layer 6, so that the photoelectric conversion can be efficiently performed.

In the photoelectric conversion element 101 of the present embodiment, since the second substrate 9 is formed of a metal film as described above, a laminated structure of the second substrate 9 (sealing material) and the adhesive layer 8 can be configured. This makes it easy to cut the adhesive layer 8 partially made of the second substrate 9 (sealing material). Therefore, a clearance CL surrounding the outer edge 8A of the adhesive layer 8 is easily formed between the outer edge 8A of the adhesive layer 8 and the outer edge 1A of the first substrate 1 in a plan view.

(Photoelectric Conversion Module)

The photoelectric conversion module of the present embodiment includes the photoelectric conversion element of the present embodiment described above. Specifically, the photoelectric conversion module has a plurality of photoelectric conversion elements 101 of the present embodiment, and the adjacent photoelectric conversion elements 101 are electrically connected to each other in series or parallel.

The photoelectric conversion module of the present embodiment, which is not illustrated in the figure, has, for example, a photoconversion area in which a plurality of photoelectric conversion elements 101 are arranged adjacent to each other and connected in series or parallel. In the photoelectric conversion module of the present embodiment, furthermore, a plurality of photoelectric conversion elements 101 has a photoelectronic conversion layer including the electron transporting layer 4 and the hole transporting layer 6 between the first electrode 2 and the second electrode 7.

The photoelectric conversion module of the present embodiment may include a plurality of photoelectric conversion elements 101. The plurality of photoelectric conversion elements 101 may be coupled in series, in parallel, or both. Alternatively, the photoelectric conversion module may include independent photoelectric conversion elements 101 that are not coupled to each other.

The configuration of each layer of the photoelectric conversion module may have the same configuration as that of the photoelectric conversion element 101.

The structure of the photoelectric conversion module is not particularly limited and can be appropriately selected according to the purpose. As the structure of the photoelectric conversion module, for example, it is preferable that the first electrode 2, the electron transporting layer 4, and the second electrode 7 are divided in at least two photoelectric conversion elements 101 adjacent to each other, to thereby reduce the risk of short circuit.

Meanwhile, in the at least two photoelectric conversion elements 101 adjacent to each other, the hole transporting layers 6 may be separated, or the hole transporting layers 6 may have configuration of a continuous layer where the hole transporting layers are extended to each other.

In the photoelectric conversion module having at least two photoelectric conversion elements 101 adjacent to each other, it is preferable that the first electrode 2 in one photoelectric conversion element 101 and the second electrode 7 in the other photoelectric conversion element 101 are electrically connected by a conductive part passing through the photoelectric conversion layer.

The photoelectric conversion module may include a pair of substrates, and photoelectric conversion element-disposed regions coupled in series or in parallel between the pair of substrates. In addition, the photoelectric conversion module may include a configuration where the sealing member are sandwiched between the pair of substrates.

An example of the photoelectric conversion element module of the present embodiment includes, for example, a plurality of photoelectric conversion elements 101, which are connected in series.

In the photoelectric conversion element module, after the hole transporting layer 6 is formed, a through portion (not illustrated) is formed, and then the second electrode 7 is formed, so that the material of the second electrode 7 is introduced into the through portion and can be made conductive to the first electrode 2 of an adjacent cell. Note that the first electrode 2 and the second electrode 7 have a path of conduction to the electrode of the photoelectric conversion element 101 or the output take-out terminal which is further adjacent to each other.

The penetrating portion may penetrate the first electrode 2 and reach the first substrate, or may stop processing inside the first electrode 2 and not reach the first substrate.

In the case where a shape of the penetration portion is such a micropore that penetrates the first electrode 2 and reaches the first substrate 1, when a total opening area of the micropore relative to an area of the penetration portion is too large, a cross-sectional area of the film of the first electrode 2 is decreased to thereby increase the resistance value, which may cause a decrease of photoelectric conversion efficiency. Therefore, a ratio of the total opening area of the micropore to the area of the penetration portion is preferably in a range from 5/100 to 60/100.

A method for forming the penetration part 11 is not particularly limited and may be appropriately selected according to the intended purpose. Examples thereof include the sand blasting method, the water blasting method, abrasive paper, the chemical etching method, and the laser processing method. Among them, the laser processing method is preferable. This makes it possible to form a minute hole without using, for example, sand, etching, or a resist, and to perform processing with good cleanness and reproducibility.

In addition, when the penetration part is formed, at least one of the hole blocking layer, the electron transporting layer 4, the hole transporting layer 6, and the second electrode 7 can be removed through impact exfoliation using the laser processing method. As a result, it is not necessary to provide a mask at the time of stacking layers, and removal and formation of the minute penetration part 11 can be easily performed at one time.

In another example of the photoelectric conversion element module of the present embodiment, the hole transporting layer 6 is divided into adjacent photoelectric conversion elements 101, and each of them has an independent layer structure, unlike the example of the photoelectric conversion element module described above. Thereby, electron diffusion is suppressed, leakage current is lowered, and durability can be further improved.

Since the photoelectric conversion element (photoelectric conversion element 101) of the present embodiment is used in the photoelectric conversion element module of the present embodiment as described above, the same effect as the photoelectric conversion element of the present embodiment can be obtained.

(Electronic Device)

An electronic device of the present embodiment includes the photoelectric conversion element 101, the photoelectric conversion module, or both of the present embodiment, and a device configured to be driven by electric power generated through photoelectric conversion of the photoelectric conversion element 101, the photoelectric conversion module, or both and further includes other devices if necessary.

The electronic device of the present embodiment includes one of the photoelectric conversion element 101 of the present embodiment and the photoelectric conversion module of the present embodiment, an electric storage battery capable of storing electric power generated by photoelectric conversion of the photoelectric conversion element 101 or the photoelectric conversion module, a device operating by the electric power stored in the electric storage battery, and other devices as necessary.

(Power Supply Module)

The power supply module of the present embodiment includes a photoelectric conversion module of the present embodiment and a power supply circuit (IC; Integrated Circuit) and other devices as needed.
Next, a specific embodiment of an electronic device having a photoelectric conversion module of the present embodiment and a device operated by electric power obtained by generating the photoelectric conversion module will be described.
A mouse for a personal computer (hereinafter sometimes referred to as mouse) will be described as an example of the electronic device of the present embodiment.
In a mouse (not illustrated) for a personal computer, the photoelectric conversion module of the above, a power supply IC, and an electricity storage device are combined, and the supplied electric power is allowed to pass to a power supply of a control circuit of the mouse. As a result, the electricity storage device is charged when the mouse is not used, and the mouse can be driven by the electric power, and therefore such a mouse that does not require wiring or replacement of a battery can be obtained. Because a cell is not required, a weight thereof can be decreased, which is effective.
In the above-described mouse for a personal computer, the photoelectric conversion module, the power source IC, and the power storage device are mounted inside the mouse, but the upper portion of the photoelectric conversion element 101 is covered with a transparent casing so that the photoelectric conversion element 101 of the photoelectric conversion module is exposed to light.
It is also possible to mold the entire housing of the mouse with a transparent resin. The arrangement of the photoelectric conversion element is not limited to this, and for example, it is possible to arrange the photoelectric conversion element 101 at a position to be irradiated with light even when the mouse is covered with a hand.
Next, another embodiment of an electronic device having a photoelectric conversion module of the present embodiment and a device operated by electric power obtained by generating the photoelectric conversion module will be described.
A keyboard (hereinafter referred to as keyboard) for a personal computer as another example of the electronic device of the present embodiment will be described.
In a personal computer keyboard (not illustrated), a photoelectric conversion element 101 of the above described photoelectric conversion module, a power supply IC, and an electricity storage device are combined, and the supplied electric power is allowed to pass to a power supply of a control circuit of a keyboard. As a result, the electricity storage device is charged when the keyboard is not used, and the keyboard can be driven by the electric power. Therefore, such a keyboard that does not require wiring or replacement of a battery can be obtained. Since a battery is not required, a weight thereof can be decreased, which is effective.
In one example of the keyboard described above, the photoelectric conversion element 101 of the photoelectric conversion module, the power supply IC, and the electricity storage device are mounted inside the keyboard, but an upper portion of the photoelectric conversion element is covered with a transparent housing so that the photoelectric conversion element receives light. The whole housing of the keyboard can be formed of a transparent resin. The arrangement of the photoelectric conversion element 101 is not limited to the above.
In the case of a small keyboard in which a space for incorporating the photoelectric conversion element 101 is small, a small photoelectric conversion element 101 may be embedded in some keys, and such arrangement is effective.
Next, a further embodiment of an electronic apparatus having a photoelectric conversion module of the present embodiment and a device operated by electric power obtained by generating the photoelectric conversion module will be described.
A sensor as an example of the electronic apparatus of the present embodiment will be described.
In a sensor (not illustrated) of the present embodiment, a photoelectric conversion element 101 of a photoelectric conversion module, a power supply IC, and an electricity storage device are combined, and the supplied electric power is allowed to pass to the power supply of a sensor circuit. As a result, a sensor module can be configured without requiring connection to an external power supply and without requiring replacement of a battery.
A sensing target is, for example, temperature and humidity, illuminance, human detection, $CO_2$, acceleration, ultraviolet rays (UV), noise, terrestrial magnetism, and atmospheric pressure, and such an electronic device can be applied to various sensors, which is effective. In a sensor module (not illustrated), the sensor module is configured to sense a target to be measured on a regular basis and to transmit the read data to a PC or a smartphone through wireless communication.
It is expected that use of sensors will significantly increase due to the arrival of the Internet of Things (IoT) society. Replacing batteries of numerous sensors one by one is time consuming and is not realistic. Moreover, the fact that a sensor is installed at a position such as a ceiling and a wall where a battery is not easily replaced also makes workability worse.
With respect to these problems, the sensor of the present embodiment has a merit of solving these problems

by supplying power by the photoelectric conversion element 101. Further, the photoelectric conversion module of the present embodiment can obtain a high output even under low illuminance, and has an advantage of having a high degree of freedom of installation because the output has a small dependence on the light incidence angle.

Next, a further embodiment of an electronic device having a photoelectric conversion module of the present embodiment and a device operated by electric power obtained by generating the photoelectric conversion module will be described.

A turntable as an example of the electronic device of the present embodiment will be described.

In a turntable of the present embodiment (not illustrated), the photoelectric conversion element 101, a power supply IC, and an electricity storage device are combined, and the supplied electric power is allowed to pass to a power supply of a turntable circuit.
As a result, the turntable can be configured without requiring connection to an external power supply and without requiring replacement of a battery.

The turntable is used, for example, in a display case in which products are displayed. Wiring of a power supply detracts from the appearance of the display, and moreover displayed products need to be removed at the time of replacing a cell, which is time-consuming. Use of the photoelectric conversion element of the present embodiment is effective because the aforementioned problems can be solved.

As described above, the electronic device including the photoelectric conversion module of the present embodiment and the device configured to be driven by electric power obtained through power generation of the photoelectric conversion module, and the power supply module have been described above. However, the embodiments described are only part of applicable embodiments, and use of the photoelectric conversion module of the present embodiment is not limited to the above-described uses.

<Application>

The photoelectric conversion module of the present embodiment can function as a self-sustaining power supply, and electric power generated through photoelectric conversion can be used to drive a device.

Since the photoelectric conversion module of the present embodiment can generate electricity by irradiation of light, it is not necessary to couple the electronic device to a power supply or to replace a battery. Therefore, the electronic device can be driven in a place where there is no power supply facility, the electronic device can be worn or carried, and the electronic device can be driven without replacement of a battery even in a place where a battery is not easily replaced.

Moreover, when a dry battery is used, the electronic device becomes heavy by a weight of the dry battery, or the electronic device becomes large by a size of the dry battery. Therefore, there may be a problem in installing the electronic device on a wall or ceiling, or transporting the electronic device. Since the photoelectric conversion module of the present embodiment is light and thin, it can be freely installed, and can be worn and carried, which is advantageous.

As described above, the photoelectric conversion module of the present embodiment can be used as a self-sustaining power supply, and can be combined with various electronic devices. For example, the photoelectric conversion module of the present embodiment can be used in combination with a display device such as an electronic desk calculator, a watch, a mobile phone, an electronic organizer, and electronic paper; an accessory device of a personal computer such as a mouse and a keyboard; various sensor devices such as a temperature and humidity sensor and a human detection sensor; transmitters such as a beacon and a global positioning system (GPS); numerous electronic devices such as an auxiliary lamp and a remote controller; and the like.

The photoelectric conversion module of the present embodiment is widely applied because it can generate electricity particularly with light of a low illuminance and can generate electricity indoors and in further darker shade. Moreover, the photoelectric conversion module is highly safe because liquid leakage found in the case of a dry battery does not occur, and accidental ingestion found in the case of a button battery does not occur. Furthermore, the photoelectric conversion module can be used as an auxiliary power supply for the purpose of prolonging a continuous operation time of a charge-type or dry battery-type electronic equipment.

As described above, when the photoelectric conversion module of the present embodiment is combined with a device configured to be driven by electric power generated through photoelectric conversion of the photoelectric conversion module, it is possible to obtain an electronic device that is light and easy to use, has a high degree of freedom in installation, does not require replacement of a battery, is excellent in safety, and is effective in decreasing environmental loads.

An electronic device (not illustrated) in which a photoelectric conversion module of the present embodiment is combined with a device that operates by power generated by the photoelectric conversion of the module will be described.
When the photoelectric conversion element 101 is irradiated with light, power is generated, and electric power can be extracted. The circuit of the device can be operated by the power.

Since the output of the photoelectric conversion element 101 of the photoelectric conversion module varies

depending on ambient illuminance, the electronic device of the present embodiment may not be stably driven in some cases. In this case, a power supply IC for the photoelectric conversion element 101 can be incorporated between the photoelectric conversion element 101 and the circuit of the device in order to supply stable voltage to a side of the circuit, and such arrangement is effective.

The photoelectric conversion element 101 of the photoelectric conversion module can generate electricity so long as light of a sufficient illuminance is applied thereto. However, when an illuminance for generating electricity is not enough, desired electric power cannot be obtained, which is a disadvantage of the photoelectric conversion element 101.

In this case, when an electricity storage device such as a capacitor is mounted between a power supply IC and a device circuit, excess electric power from the photoelectric conversion element 101 can be stored in the electricity storage device. In addition, the electric power stored in the electricity storage device can be supplied to a device circuit to thereby enable stable operation when the illuminance is too low or even when light is not applied to the photoelectric conversion element 101.

As described above, the electronic device obtained by combining the photoelectric conversion module of the present embodiment with the device circuit can be driven even in an environment without a power supply, does not require replacement of a battery, and can be stably driven in combination with a power supply IC or an electricity storage device. Therefore, it is possible to make the most of the advantages of the photoelectric conversion element 101.

Meanwhile, the photoelectric conversion module of the present embodiment can also be used as a power supply module, and such use is effective. For example, when the photoelectric conversion module of the present embodiment is coupled to a power supply IC for a photoelectric conversion element 101, a DC power supply module capable of supplying electric power generated through photoelectric conversion of the photoelectric conversion element 101 to the power supply IC at a predetermined voltage level can be configured.

Moreover, when an electricity storage device is added to a power supply IC, electric power generated by the photoelectric conversion element 101 can be stored in the electricity storage device. Therefore, a power supply module to which electric power can be supplied can be configured when the illuminance is too low or even when light is not applied to the photoelectric conversion element 101.

The power supply module of the present embodiment can be used as a power supply module without replacing the battery as in the case of a conventional primary battery.

EXAMPLES

Embodiments of the present invention will be described below, but the present invention is not limited to these embodiments.

(Example 1)

<Preparation of Photoelectric Conversion Module>

Indium doped tin oxide (ITO: average thickness 25 mm) and niobium doped tin oxide (NTO: average thickness 150 nm) as first electrodes were sequentially sputter formed on a glass substrate as a first substrate. Next, a dense layer (average thickness 20 nm) made of titanium oxide as the hole blocking layer was formed by reactive sputtering with oxygen gas. The formed first substrate was cut into 300 mm squares by a scriber.

Next, a titanium oxide (Manufactured by JGC C&C, PST-18NR) paste was applied to the cut 300 mm square substrate by screen-printing so that the average thickness was about 0.8 μm on the hole blocking layer. After drying at 120°C, it was fired in air at 550°C for 30 minutes to form a porous electron transporting layer. Thereafter, the ITO/NTO layer, the hole blocking layer, and the electron transporting layer were divided into eight cells by laser machining.

The glass substrate on which the electron transporting layer was formed was immersed in a solution prepared by adding a mixture of acetonitrile/t-butanol (volume ratio of 1:1) to a photosensitizing compound represented by B-5 (0.2 mM) and stirring, and was left in a dark place for 1 hour to adsorb the photosensitizing compound on the surface of the electron transporting layer.

Next, 65.1 mM of lithium (fluorosulfonyl) (trifluoromethanesulfonyl) imide (Li-FTFSI) (manufactured by Xida Chemical Co., Ltd.) as the lithium salt b, 146.5 mM of the pyridine compound a represented by H-1, 162.8 mM of the organic hole transporting material (HTM) (SHT-263, manufactured by Merck) represented by D-7, and 12.7 mM of the cobalt complex represented by F-11 (manufactured by Greatcell solar materials Co., Ltd.) were dissolved in the chlorobenzene solution to prepare a hole transporting layer coating solution. The molar ratio a/b of the pyridine compound a to the lithium salt b was 2.25.

Next, a hole transporting layer of about 600 nm was formed on the electron transporting layer adsorbed with the photosensitizing compound by die coating using a hole transporting layer coating liquid. Furthermore, through hole for connecting cells in series were formed by laser machining.

After a mask was attached to the end of the glass substrate and between the cells, silver was vacuum evaporated to form a second electrode having a thickness of about 70 nm.

Next, a fluorine compound (DURASURF, DS-5935F130) having a silane structure as an electrode protective layer was formed on the second electrode to be a thickness of 10 nm by die coating.

Thereafter, the space between the cells and 1.0 mm from the end portion of the glass substrate on which the sealing member is provided were etched by laser processing, a through hole for connecting to the ITO/NTO layer serving as a terminal extraction portion was formed at 3.0 mm from the end portion the glass substrate by laser processing, and a through hole for connecting the cells in series was formed by laser processing.

An aluminum PET sheet (Manufactured by Tesa: 61539) in which an adhesive layer, a sealing substrate material, and a second substrate were integrated was bonded to the whole surface of a glass substrate using a vacuum bonding device (Air bag vacuum laminator, manufactured by Joyo Engineering Co., Ltd.). The bonded substrates were pressure-bonded while being heated at 70°C by a heated laminator. As described above, the power generation area was sealed.

The sealed film was cut by laser processing so as to be 0.1 mm inward from the outer shape of the product, and the portions other than the sealed portion were peeled off (the interval between the outer edge of the adhesive layer of the clearance and the outer edge of the first substrate was set to 0.1 mm). Then, a UV cut film (PET 50HD UV400 PET 25, manufactured by Lintec Corporation) was attached to the light-receiving surface. Finally, the photoelectric conversion module 1 was prepared by cutting out a sample using a glass scribe.

(Example 2)

In Example 1, the photoelectric conversion module 2 was prepared in the same manner as in Example 1, except that the sealed film was cut by laser processing so as to be 0.5 mm inward from the outer shape of the product (the clearance interval was set to 0.5 mm).

(Example 3)

In Example 1, the photoelectric conversion module 3 was prepared in the same manner as in Example 1, except that the width of the laser edging treatment after the formation of the electrode protective layer was changed to 0.5 mm from the end portion (the clearance interval was set to 0.5 mm).

(Example 4)

In Example 1, the photoelectric conversion module 4 was prepared in the same manner as in Example 1, except that the width of the laser edging treatment after the formation of the electrode protective layer was changed to 0.9 mm from the end portion (the clearance interval was set to 0.9 mm).

(Example 5)

In Example 4, a photoelectric conversion module 5 was prepared in the same manner as in Example 1, except that the laser processing pattern of the edge of the sealing film was changed to R.

(Example 6)

In Example 6, a photoelectric conversion module 6 was prepared in the same manner as in Example 1, except that the second electrode, which is the silver layer formed from vacuum deposition in Example 3, was formed by die-coating a silver nanowire dispersion (manufactured by Aldrich) in which silver nanowires having a diameter of 60 nm and a length of 10 $\mu$m are dispersed in a pure water to the hole transport layer so as to form a 70 nm of a film, followed by heat-drying the second electrode at 120°C for 5 minutes to obtain the second electrode.

(Comparative Example 1)

In Example 1, a photoelectric conversion module 7 was prepared in the same manner as in Example 1, except that the sealed film was cut by laser processing so as to be an outer shape of the product (The width of the laser edge treatment after the electrode protective layer is formed is 0.2 mm from the edge).

(Comparative Example 2)

A photoelectric conversion module 8 was prepared in the same manner as in Example 1, except that the sealed

film was cut to form an outer shape of the product by laser processing in Example 6.

Next, the amount of protrusion of the adhesive layer was evaluated for each of the prepared photoelectric conversion modules as follows. The results are indicated in Table 1.

<Evaluation of Amount of Protrusion of Adhesive Layer (Resin)>

Using an optical microscope (VS 1550, manufactured by Hitachi High-Tech Corporation), the protrusion width of the adhesive layer from the outer shape of the prepared photoelectric conversion module was confirmed. The results are indicated in Table 1.

<Evaluation of Productivity Yield>

The number of sealing film peeled from a 300 mm square substrate was calculated to check the productivity yield. The evaluation criteria are as follows. A rating of A to C was considered good, and a rating of D was considered poor.

[Evaluation Criteria]

A: 99% or higher of yield
B: 95% or higher and less than 99% of yield
C: 90% or higher and less than 95% of yield
D: Less than 90% of yield

<Evaluation of Sealing Performance>

The IV characteristics of the obtained photoelectric conversion modules at 25°C were measured using a solar cell evaluation system (As-510-PV03, manufactured by NF Corporation), and the initial maximum output power Pmax1 ($\mu W/cm^2$) was determined. After that, upon being left in a constant temperature bath under an environment of a temperature of 60°C and humidity of 90% for about 500 hours, the IV characteristics were measured again. The maximum output power Pmax2 ($\mu W/cm^2$) was then measured, and the Pmax maintenance rate [(Pmax2/Pmax1)×100](%) was determined.

The evaluation criteria for sealing performance are as follows. A to C were rated as good, and D was rated as poor. The better the sealing performance, the better the durability.

[Evaluation Criteria of Sealing Performance]

A: Pmax maintenance rate: 95% or more
B: Pmax maintenance rate: 90% or more and less than 95%
C: Pmax maintenance rate: 80% or more and less than 90%
D: Pmax maintenance rate: Less than 80%

[Evaluation of Effective Power Generation Area Ratio]

From a 300 mm square substrate, a solar cell that was cut out in a rectangular shape of 28 mm in width and 32 mm in length was prepared, and the effective power generation area ratio was evaluated. The evaluation criteria are as follows. A to C were rated as good, and D was rated as poor. The better the effective generation area ratio evaluation, the better the initial output characteristics.

[Evaluation Criteria of Effective Power Generation Area Ratio]

A: Effective power generation area ratio: 70% or higher
B: Effective power generation area ratio: 60% or higher and less than 70%
C: Effective power generating area ratio: 50% or higher and less than 60%

D: Effective power generation area ratio: Less than 50%

[Table 1]

| | Conditions | | | | | | | Evaluation results | | | |
|---|---|---|---|---|---|---|---|---|---|---|---|
| | Photoelectric conversion module No. | Sealing member | Adhesive agent layer | Inward width | Ssealing line width | Sum of inward width and sealing line width | Edge portion of sealing substrate material | Protrusion of resin | Productivity yield | Sealing performance (at 60°C and 90% humidity) | Effective power generationarea ratio |
| Example 1 | photoelectric conversion module 1 | aluminum film | pressure-sensitive adhesive | 0.1 mm | 1.0 mm | 1.1 mm | square | Not present | B | A | B |
| Example 2 | photoelectric conversion module 2 | aluminum film | pressure-sensitive adhesive | 0.5 mm | 1.0 mm | 1.5 mm | square | Not present | B | A | B |
| Example 3 | photoelectric conversion module 3 | aluminum film | pressure-sensitive adhesive | 0.1 mm | 0.5 mm | 0.6 mm | square | Not present | B | B | A |
| Example 4 | photoelectric conversion module 4 | aluminum film | pressure-sensitive adhesive | 0.1 mm | 0.9 mm | 1.0 mm | square | Not present | B | A | A |
| Example 5 | photoelectric conversion module 5 | aluminum film | pressure-sensitive adhesive | 0.1 mm | 0.9 mm | 1.0 mm | round chamfering | Not present | A | A | A |
| Example 6 | photoelectric conversion module 6 | aluminum film | pressure-sensitive adhesive (agglutinant) | 0.1 mm | 0.5 mm | 0.6 mm | square | Not present | B | B | A |
| Comparative Example 1 | photoelectric conversion module 7 | aluminum film | pressure-sensitive adhesive | 0 mm | 0.2 mm | 0.2 mm | square | Present | D | A | A |
| Comparative Example 2 | photoelectric conversion module 8 | aluminum film | pressure-sensitive adhesive (agglutinant) | 0.1 mm | 0.5 mm | 0.6 mm | square | Present | D | D | A |

From the results of Table 1, it has been found that the protrusion of the adhesive layer can be suppressed by sealing the substrate glass at a position located 0.1 mm or more inward from the substrate glass (the clearance interval is 0.1 mm or more) in the photoelectric conversion modules of Examples 1 to 6.

On the other hand, in the photoelectric conversion module in which the sealing film was laser-cut to a size similar to that of the substrate glass (the clearance interval was set to 0 mm), the protrusion of the adhesive layer was observed because the adhesive layer expanded during vacuum bonding (Comparative Example 1).

The protruded adhesive layer and the sealing film tend to peel off in the production process, which causes sealing breakdown. In general, the effective power generation area ratio of the photoelectric conversion layer is reduced by increasing the sealing line width or by bringing the sealing film inside. Therefore, the photoelectric conversion module of Examples 3 to 6 took measures to reduce the sealing line width by the amount of the sealing film enclosed.

More specifically, in the photoelectric conversion module of Examples 3 to 6, the effective power generation area ratio was good when the sealing line width (thickness of the sealing member in the circumferential direction) was 0.6 mm to 1.5 mm. On the other hand, the photoelectric conversion module having a sealing line width (circumferential thickness of the sealing member) of 0.2 mm had a poor productivity yield (Comparative Example 1).

Further, by performing round chamfering the edge portion of the sealing film, peeling of the sealing film other than the sealing portion becomes easy, and the productivity yield is greatly improved (Example 5).

The silver nanowire, which is the second electrode in Comparative Example 2, had high water permeability and was easily affected by water penetration due to resin overflow, resulting in a significant degradation of sealing performance.

The embodiments of the present invention are, for example, as follows.

<1> A photoelectric conversion element in which a first substrate, a first electrode, a photoelectric conversion layer, a second electrode, and a second substrate are sequentially laminated, the photoelectric conversion element comprising:

an adhesive layer surrounding at least the photoelectric conversion layer,
wherein a clearance surrounding an outer edge of the adhesive layer is formed between the outer edge of the adhesive layer and an outer edge of the first substrate in a plan view.

<2> The photoelectric conversion element according to <1>,
wherein an interval between the outer edge of the adhesive layer of the clearance and the outer edge of the first substrate is 0.01 mm or more in a plan view.
<3> The photoelectric conversion element according to <1> or <2>,
wherein a thickness of the adhesive layer in a circumferential direction is 0.2 mm or more.
<4> The photoelectric conversion element according to any one of <1> to <3>,

wherein the second substrate is composed of part of the adhesive layer, and
wherein an edge portion of the second substrate is curved.

<5> The photoelectric conversion element according to any one of <1> to <4>, wherein the adhesive layer is formed of a pressure-sensitive adhesive.
<6> The photoelectric conversion element according to any one of <1> to <5>, wherein the adhesive layer contains a moisture absorbent.
<7> The photoelectric conversion element according to any one of <1> to <6>,
wherein an electrode protective layer is provided between the second electrode and the second substrate.
<8> The photoelectric conversion element according to <7>,
wherein the electrode protective layer contains a fluorine compound having a silane structure.
<9> The photoelectric conversion element according to any one of <1> to <8>,
wherein the photoelectric conversion layer includes an electron transporting layer and a hole transporting layer, the electron transporting layer having a photosensitizing compound.
<10> The photoelectric conversion element according to any one of <1> to <9>,
wherein the second substrate is formed of a metal film.
<11> A photoelectric conversion element module comprising the photoelectric conversion element of any one of <1> to <10>.

Although the embodiments of the present invention have been described above, the present invention is not limited to specific embodiments, and various modifications and modifications are possible within the scope of the invention described in the claims.

The present application is based on and claims priority to Japanese patent application No. 2021-177553, filed October 29, 2021, and No. 2022-167661, filed October 19, 2022 with the Japanese Patent Office, the entire contents of which are hereby incorporated by reference.

## Claims

1. A photoelectric conversion element in which a first substrate, a first electrode, a photoelectric conversion layer, a second electrode, and a second substrate are sequentially laminated, the photoelectric conversion element comprising:

   an adhesive layer surrounding at least the photoelectric conversion layer,
   wherein a clearance surrounding an outer edge of the adhesive layer is formed between the outer edge of the adhesive layer and an outer edge of the first substrate in a plan view.

2. The photoelectric conversion element according to claim 1, wherein an interval between the outer edge of the adhesive layer of the clearance and the outer edge of the first substrate is 0.01 mm or more in a plan view.

3. The photoelectric conversion element according to claim 1, wherein a thickness of the adhesive layer in a circumferential direction is 0.2 mm or more.

4. The photoelectric conversion element according to claim 1, wherein the second substrate is composed of part of the adhesive layer, and wherein an edge portion of the second substrate is curved.

5. The photoelectric conversion element according to claim 1, wherein the adhesive layer is formed of a pressure-sensitive adhesive.

6. The photoelectric conversion element according to claim 1, wherein the adhesive layer contains a moisture absorbent.

7. The photoelectric conversion element according to claim 1, wherein an electrode protective layer is provided between the second electrode and the second substrate.

8. The photoelectric conversion element according to claim 7, wherein the electrode protective layer contains a fluorine compound having a silane structure.

9. The photoelectric conversion element according to claim 1, wherein the photoelectric conversion layer includes an electron transporting layer and a hole transporting layer, the electron transporting layer having a photosensitizing compound.

10. The photoelectric conversion element according to claim 1, wherein the second substrate is formed of a metal film.

11. A photoelectric conversion element module comprising the photoelectric conversion element of any one of claims 1 to 10.

FIG.1

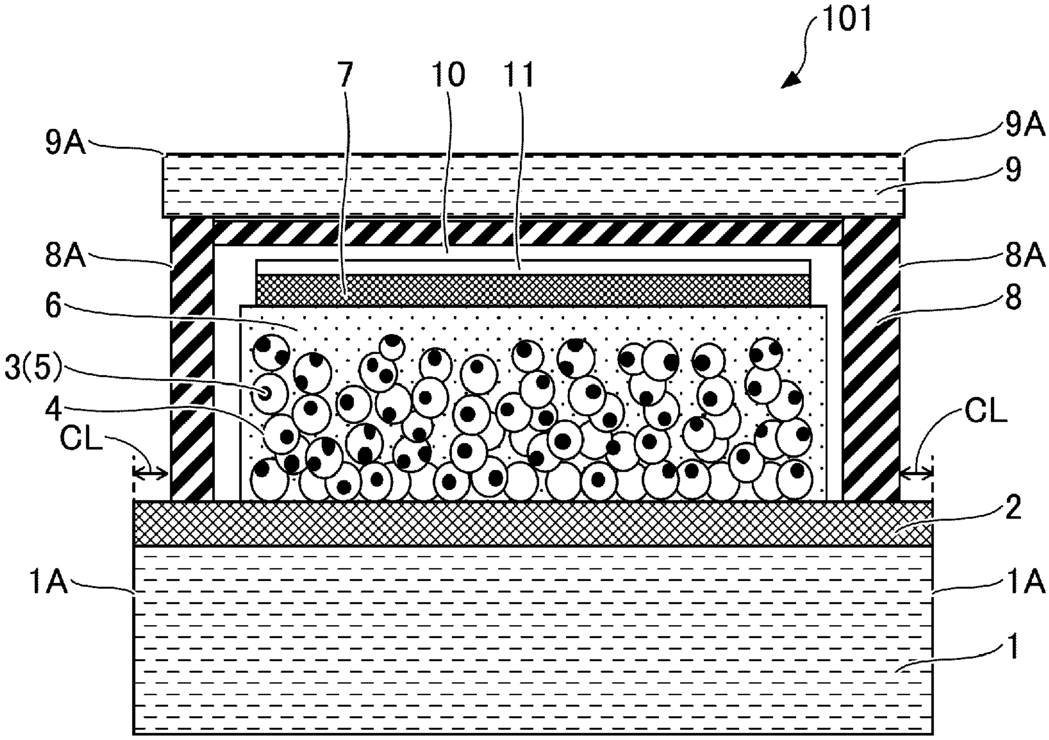

FIG.2

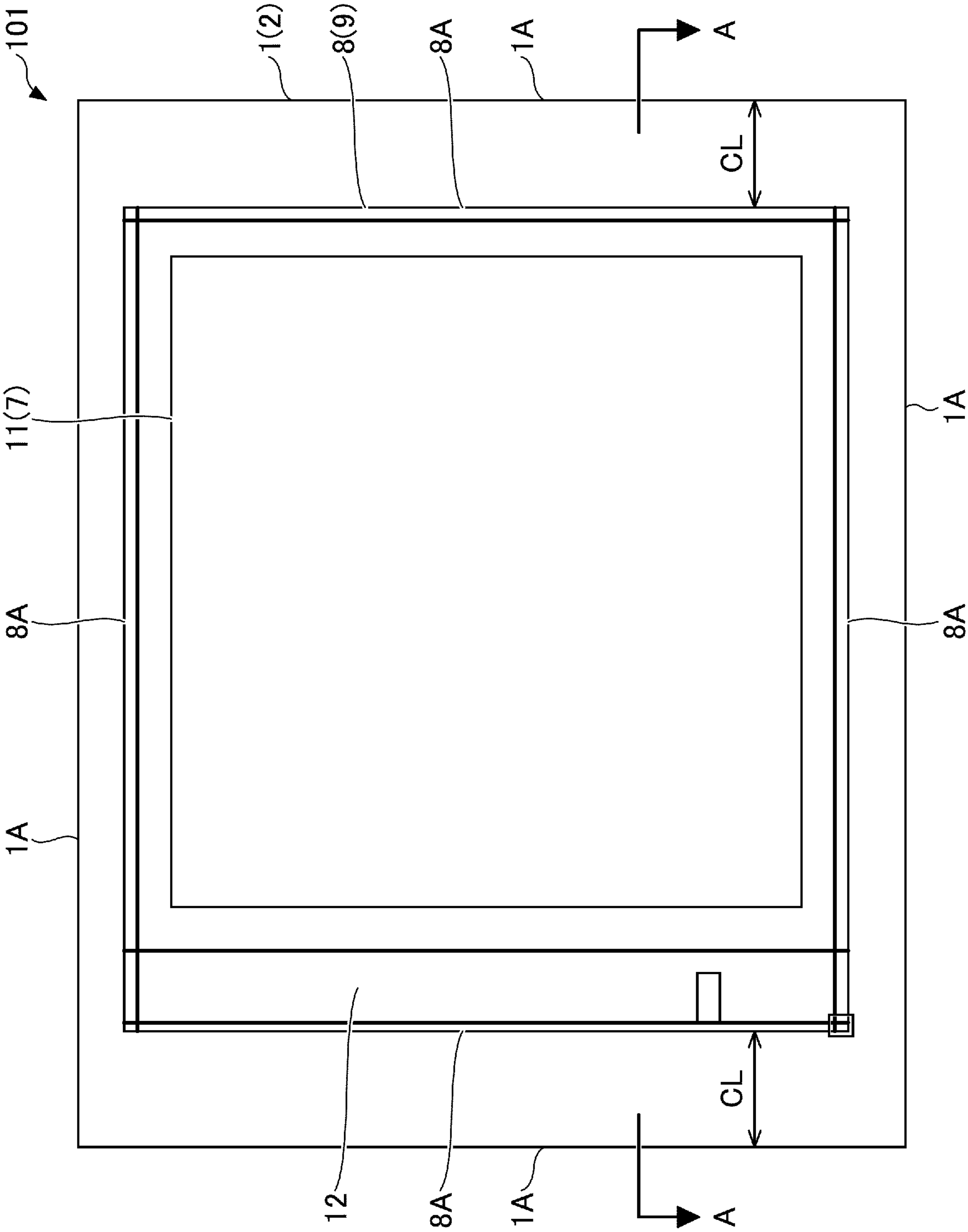

FIG.3

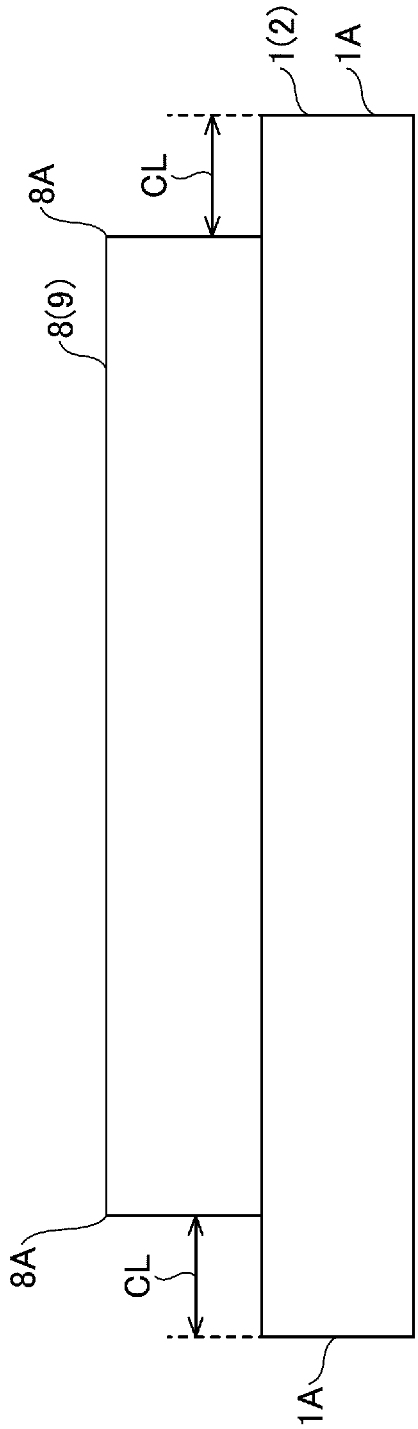

FIG.4

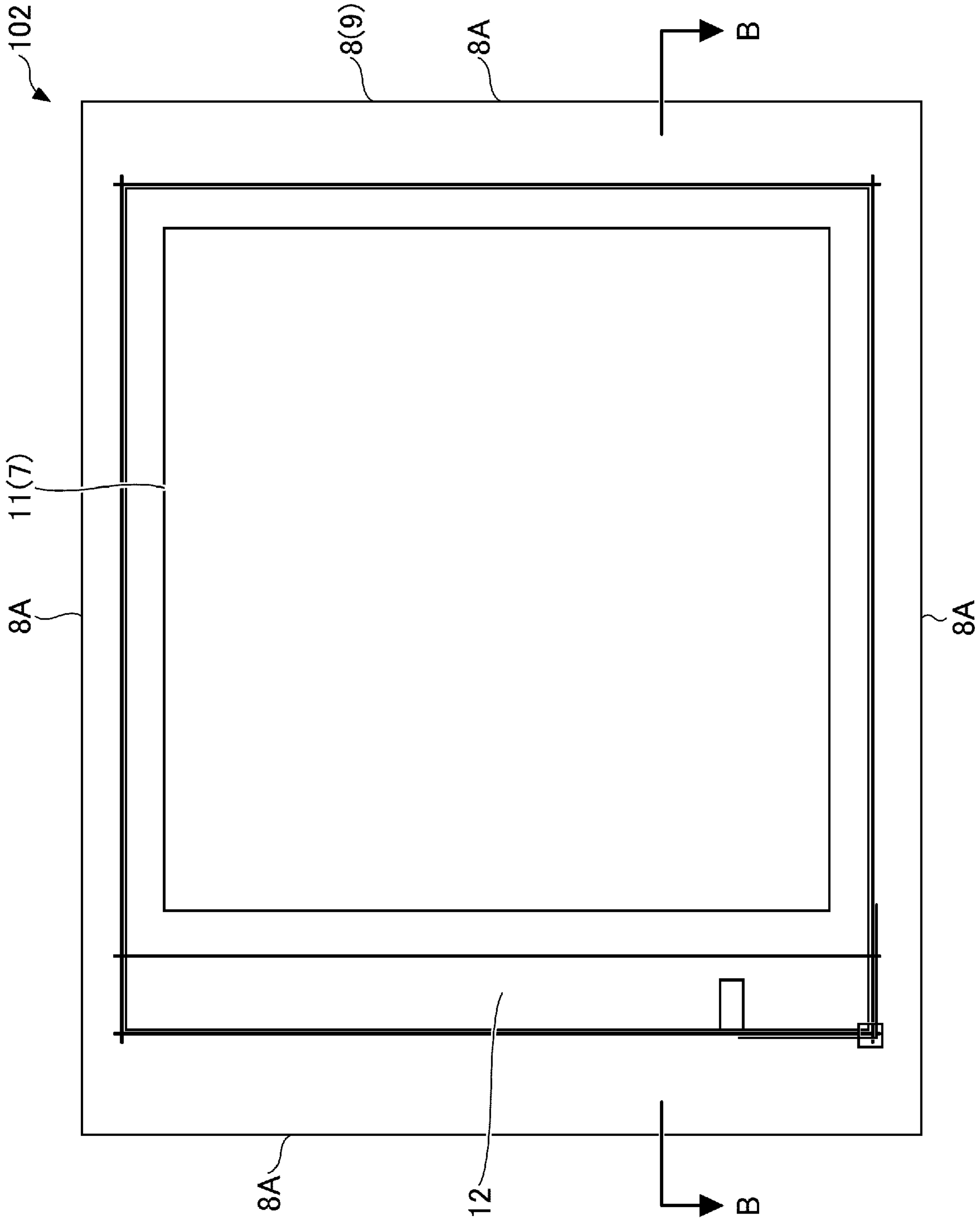

FIG.5

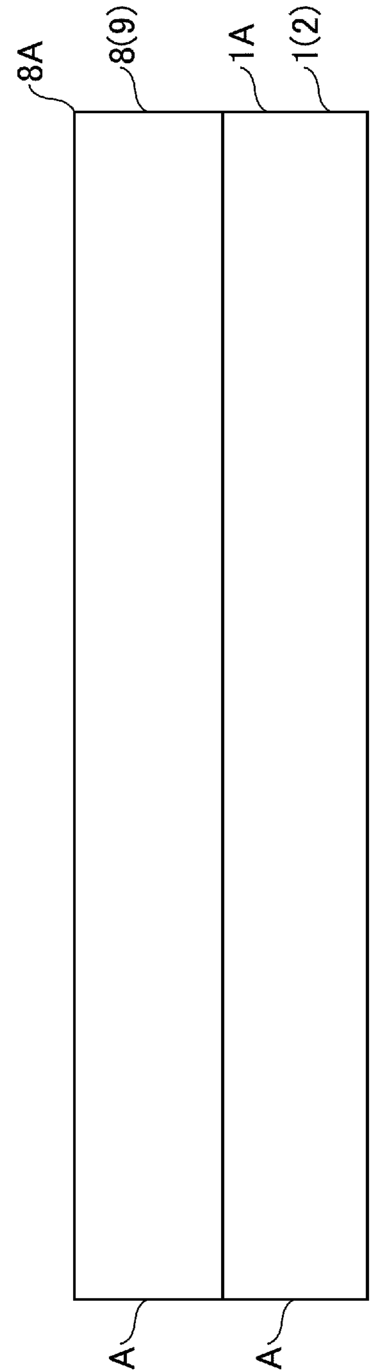

Europäisches Patentamt
European Patent Office
Office européen des brevets

# EUROPEAN SEARCH REPORT

Application Number
EP 22 20 3512

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/107158 A1 (RICOH CO LTD [JP]; KANEI NAOMICHI [JP] ET AL.) 3 June 2021 (2021-06-03) * paragraph [0120] - paragraph [0210]; figures 1-27; tables 1-1, 1-2 * ----- | 1-11 | INV. H01G9/20 |
| X | US 2017/243698 A1 (KANEI NAOMICHI [JP] ET AL) 24 August 2017 (2017-08-24) * paragraph [0052] - paragraph [0298]; figures 1-20; tables 1,2 * ----- | 1-11 | |
| | | | TECHNICAL FIELDS SEARCHED (IPC) |
| | | | H01G |

The present search report has been drawn up for all claims

1

| Place of search | Date of completion of the search | Examiner |
|---|---|---|
| The Hague | 10 March 2023 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 20 3512

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2023

| Patent document cited in search report | Publication date | Patent family member(s) | Publication date |
|---|---|---|---|
| WO 2021107158 A1 | 03-06-2021 | CN 114730846 A | 08-07-2022 |
| | | EP 4066293 A1 | 05-10-2022 |
| | | KR 20220079923 A | 14-06-2022 |
| | | US 2022392714 A1 | 08-12-2022 |
| | | WO 2021107158 A1 | 03-06-2021 |
| US 2017243698 A1 | 24-08-2017 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013232320 A
- JP H7500630 W
- JP H10233238 A
- JP 2000026487 A
- JP 2000323191 A
- JP 2001059062 A
- JP H1093118 A
- JP 2002164089 A
- JP 2004095450 A
- JP 2003264010 A
- JP 2004063274 A
- JP 2004115636 A
- JP 2004200068 A
- JP 2004235052 A
- JP H1186916 A
- JP H11214730 A
- JP 2000106224 A
- JP 2001076773 A
- JP 2003007359 A
- JP H11214731 A
- JP H11238905 A
- JP 2001052766 A
- JP 2001076775 A
- JP 2003007360 A
- JP H1092477 A
- JP H11273754 A
- JP H11273755 A
- JP 2003031273 A
- JP H9199744 A
- JP H11204821 A
- JP H11265738 A
- JP 2006032260 A
- JP 2021177553 A
- JP 2022167661 A


### Non-patent literature cited in the description


- *J. Phys. Chem. C,* 2007, vol. 111
- *Chem. Commun.,* 2007, vol. 4887
- *J. Am. Chem. Soc.,* 2004, vol. 126
- *Chem. Commun.,* 2003, vol. 3036
- *Angew. Chem. Int. Ed.,* 2008, vol. 47
- *J. Am. Chem. Soc.,* 2006, vol. 128
- *J. Phys. Chem.,* 1987, vol. 91
- *J. Phys. Chem. B,* 1993, vol. 97
- *Electroanal. Chem.,* 2002, vol. 537
- *J. Porphyrins Phthalocyanines,* 1999, vol. 3
- *Angew. Chem. Int. Ed.,* 2007, vol. 46
- *Langmuir,* 2008, vol. 24